(19) Europäisches Patentamt / European Patent Office / Office européen des brevets

(11) **EP 4 614 910 A1**

(12) **EUROPEAN PATENT APPLICATION**
published in accordance with Art. 153(4) EPC

(43) Date of publication:
**10.09.2025 Bulletin 2025/37**

(21) Application number: **22965567.5**

(22) Date of filing: **18.11.2022**

(51) International Patent Classification (IPC):
*H04L 27/00* *(2006.01)*

(52) Cooperative Patent Classification (CPC):
**H04L 27/00**

(86) International application number:
**PCT/CN2022/132833**

(87) International publication number:
**WO 2024/103386 (23.05.2024 Gazette 2024/21)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **Huawei Technologies Co., Ltd.
Shenzhen, Guangdong 518129 (CN)**

(72) Inventors:
• **LIU, Ke
Shenzhen, Guangdong 518129 (CN)**
• **ZHANG, Huazi
Shenzhen, Guangdong 518129 (CN)**

• **TONG, Jiajie
Shenzhen, Guangdong 518129 (CN)**
• **WANG, Xianbin
Shenzhen, Guangdong 518129 (CN)**
• **LI, Rong
Shenzhen, Guangdong 518129 (CN)**
• **WANG, Jun
Shenzhen, Guangdong 518129 (CN)**
• **TONG, Wen
Shenzhen, Guangdong 518129 (CN)**

(74) Representative: **Goddar, Heinz J.
Boehmert & Boehmert
Anwaltspartnerschaft mbB
Pettenkoferstrasse 22
80336 München (DE)**

(54) **COMMUNICATION METHOD BASED ON LDPC CODE, AND COMMUNICATION APPARATUS**

(57) This application provides an LDPC base graph construction manner. An LDPC base graph may be obtained based on a storage matrix and indication information that indicates a correspondence between rows of the storage matrix or a correspondence between rows of the expected LDPC base graph. In addition, in a process of obtaining the LDPC base graph, a total quantity of edges that correspond to non-extended columns and that are in a Tanner graph may not be changed. Therefore, the manner provided in this application helps maintain calculation complexity of an LDPC code, and in particular, helps reduce calculation complexity of an LDPC code in a scenario in which a high code rate is extended to a low code rate, to improve decoding efficiency.

FIG. 6

**EP 4 614 910 A1**

**Description**

**TECHNICAL FIELD**

This application relates to the field of channel encoding, and more specifically, to an LDPC code-based communication method and a communication apparatus.

**BACKGROUND**

In the field of channel encoding, a low-density parity check (low-density parity check, LDPC) code is a most mature and widely used channel encoding scheme. A high-code-rate part (namely, a kernel matrix) of a new radio (new radio, NR) LDPC code supports only parallel decoding of quasi-cyclic (quasi-cyclic, QC) blocks, and cannot support parallel decoding of an entire row. This limits decoding efficiency. For each code rate of an 802.11ay LDPC code, one check matrix is stored, and a flexible code rate is not supported. Therefore, the 802.11ay LDPC code does not support an incremental redundancy-hybrid automatic repeat request (incremental redundancy-hybrid automatic repeat request, IR-HARQ) mechanism.

**SUMMARY**

Embodiments of this application provide an LDPC code-based communication method and a communication apparatus, to help improve LDPC code decoding efficiency.

According to a first aspect, an LDPC code-based communication method is provided. The method may be performed by a transmitting end, or may be performed by a module or a unit in the transmitting end, which is collectively referred to as the transmitting end below for ease of description. Optionally, the transmitting end may be a terminal or a network device.

The method includes: obtaining an information bit sequence; performing LDPC encoding on the information bit sequence based on an LDPC base graph, to obtain an LDPC coding bit sequence, where the LDPC base graph is obtained based on a storage matrix and indication information, the indication information indicates a correspondence between rows of the storage matrix or a correspondence between rows of the LDPC base graph, and a sum of column weights of non-extended columns of the LDPC base graph is equal to a sum of column weights of non-extended columns of the storage matrix; and sending the LDPC coding bit sequence.

According to the foregoing method, the LDPC base graph may be obtained based on the storage matrix and the indication information that indicates the correspondence between the rows of the storage matrix or the correspondence between the rows of the expected LDPC base graph. In addition, in a process of obtaining the LDPC base graph, a total quantity of edges that correspond to the non-extended columns and that are in a Tanner (Tanner) graph may not be changed. A quantity of edges in the Tanner graph is one of key factors that affect calculation complexity of an LDPC code. Therefore, the method provided in this application helps maintain calculation complexity of an LDPC code, and in particular, helps reduce calculation complexity of an LDPC code in a scenario in which a high code rate is extended to a low code rate, to improve decoding efficiency.

In addition, the foregoing method supports a flexible code rate, and further supports an IR-HARQ mechanism.

With reference to the first aspect, in some implementations of the first aspect, a code rate corresponding to the LDPC base graph is different from a code rate corresponding to the storage matrix.

According to the foregoing method, the LDPC base graph with the code rate different from that corresponding to the storage matrix may be obtained based on the storage matrix and the indication information that indicates the correspondence between the rows of the storage matrix or the correspondence between the rows of the expected LDPC base graph. In addition, in a process of obtaining the LDPC base graph, a total quantity of edges that correspond to the non-extended columns and that are in a Tanner graph may not be changed. The method helps reduce calculation complexity of a low-code-rate LDPC code in a scenario in which a high code rate is extended to a low code rate.

With reference to any one of the first aspect or the implementations of the first aspect, in some other implementations of the first aspect, the LDPC base graph includes a first submatrix and a second submatrix, the first submatrix includes the non-extended columns of the LDPC base graph, the second submatrix includes extended columns of the LDPC base graph; a column weight of each of Q columns of the second submatrix is 2; and one of two non-zero elements included in a $q^{th}$ column in the Q columns corresponds to an $i_1^{th}$ row of the first submatrix, the other one of the two non-zero elements included in the $q^{th}$ column in the Q columns corresponds to an $i_2^{th}$ row of the first submatrix, the $i_1^{th}$ row and the $i_2^{th}$ row are orthogonal to each other, and the $q^{th}$ column is any one of the Q columns, where Q, q, $i_1$, and $i_2$ are all positive integers.

In other words, degrees of some or all extended nodes in the LDPC base graph are 2, and parts, other than extended parts, of two rows corresponding to each of the extended nodes are orthogonal to each other. The LDCP base graph having the foregoing features may support row parallel decoding. This helps improve the decoding efficiency.

With reference to any one of the first aspect or the implementations of the first aspect, in some other implementations of the first aspect, the LDPC base graph is an $X \times Y$ matrix, and a $(y_2+1)^{th}$ column to a $Y^{th}$ column of the LDPC base graph are extended columns; and the LDPC base graph includes a submatrix A1, a submatrix B1, a submatrix C1, a submatrix D1, and a submatrix E1, where the submatrix A1 is a $1^{st}$ row to an $x_1^{th}$ row and a $1^{st}$ column to a $y_1^{th}$ column of the LDPC base graph, the submatrix B1 is the $1^{st}$ row to the $x_1^{th}$ row and a $(y_1+1)^{th}$ column to a $y_2^{th}$ column of the LDPC base graph, the submatrix C1 is the $1^{st}$ row to the $x_1^{th}$ row and the $(y_2+1)^{th}$ column to the $Y^{th}$ column of the LDPC base graph, the submatrix D1 is an $(x_1+1)^{th}$ row to an $X^{th}$ row and the $1^{st}$ column to the $y_2^{th}$ column of the LDPC base graph, and the submatrix E1 is the $(x_1+1)^{th}$ row to the $X^{th}$ row and the $(y_2+1)^{th}$ column to the $Y^{th}$ column of the LDPC base graph, where $1 \leq x_1 \leq X$; $1 \leq y_1 \leq y_2 \leq Y$; and $x_1$, X, $y_1$, $y_2$, and Y are integers. Elements on a diagonal of the submatrix E1 are non-zero elements, a non-zero element is included above the diagonal of the submatrix E1, and/or a non-zero element is included below the diagonal of the submatrix E1, and the submatrix C1 includes a non-zero element.

It should be noted that, if a row location is adjusted and/or a column location is adjusted in a process of obtaining the LDPC base graph according to the foregoing method, extended rows and/or extended columns satisfy: $X-x_1$ extended rows and/or $Y-y_2$ extended columns are sorted in a splitting order, and sorted extended rows and extended columns have the feature described herein.

According to the foregoing method, the submatrix C1 includes the non-zero element. This helps avoid an error floor caused by a small degree of the extended node (that is, a column weight of the expansion column). Further, when the non-zero element is also included above the diagonal of the submatrix E1, the error floor caused by the small degree of the extended node may be further avoided.

With reference to any one of the first aspect or the implementations of the first aspect, in some other implementations of the first aspect, a form used for the indication information includes at least one of an indication sequence, a mapping table, or a mapping pair.

With reference to any one of the first aspect or the implementations of the first aspect, in some other implementations of the first aspect, the indication information indicates the correspondence between the rows of the LDPC base graph, the storage matrix is used to store a connection relationship between a variable node and a check node, a shifting value of a non-zero element of the storage matrix is obtained based on a shifting value table, and the shifting value table is used to store shifting values of locations of non-extended rows of the storage matrix.

According to the foregoing method, only the shifting values of the locations of the non-extended rows of the storage matrix may be stored, in other words, only shifting values of locations of a core part are stored. This helps reduce occupation of storage space.

With reference to any one of the first aspect or the implementations of the first aspect, in some other implementations of the first aspect, the indication information is in the form of the indication sequence, the LDPC base graph is obtained by reading the storage matrix and the shifting value table based on the indication sequence, the indication sequence includes at least one row number, and an $i_3^{th}$ row number in the at least one row number indicates that a shifting value of an $i_3^{th}$ row of the LDPC base graph is determined based on a shifting value of a row identified by the $i_3^{th}$ row number in the at least one row number, where $i_3$ is a positive integer.

In other words, the LDPC base graph used for encoding is obtained by reading the storage matrix and the shifting value table based on the indication sequence.

For example, the expected LDPC base graph is a matrix with seven rows and 29 columns, the storage matrix stores connection relationships between variable nodes and check nodes, the shifting value table stores a shifting value of each location of six rows and 28 columns of a core part, and a $7^{th}$ row number of the indication information is 2. For a $7^{th}$ row of the LDPC base graph, the transmitting end may determine a shifting value of the $7^{th}$ row based on a connection relationship of a $7^{th}$ row of the storage matrix and a shifting value corresponding to a $2^{nd}$ row of the storage matrix in the shifting value table.

With reference to any one of the first aspect or the implementations of the first aspect, in some other implementations of the first aspect, the indication information is in the form of the indication sequence, the LDPC base graph is obtained by splitting the storage matrix based on the indication sequence, the indication sequence includes at least one row number, an $(m_1+r)^{th}$ row number in the at least one row number indicates that an $(m_1+r)^{th}$ row of the LDPC base graph is used to perform elimination processing on a row identified by the $(m_1+r)^{th}$ row number in the at least one row number, and a sorting order of the at least one row number is a splitting order, where $m_1$ is a quantity of non-extended rows of the storage matrix, and r is a positive integer.

With reference to any one of the first aspect or the implementations of the first aspect, in some other implementations of the first aspect, the at least one row number includes at least one segment, each of the at least one segment corresponds to one round of splitting, and row numbers in a segment corresponding to a $t^{th}$ round of splitting in at least one round of splitting corresponding to the at least one segment are in a form of permutation of $\{1, ..., 2^{t-1}m_1\}$ or a form of permutation of a subset of $\{1, ..., 2^{t-1}m_1\}$, where t is a positive integer.

According to the foregoing method, because the row numbers included in the segment corresponding to the $t^{th}$

round of splitting are in the form of permutation of $\{1, ..., 2^{t-1}m_1\}$ or the form of permutation of the subset of $\{1, ..., 2^{t-1}m_1\}$, each row number appears only once in one round of splitting, and a plurality of times of splitting included in each round may be performed in parallel. This helps improve splitting efficiency.

With reference to any one of the first aspect or the implementations of the first aspect, in some other implementations of the first aspect, the storage matrix is an $M \times N$ matrix, and an $(m_1+1)^{th}$ row to an $M^{th}$ row of the storage matrix are extended rows; and the storage matrix includes a submatrix A2, a submatrix B2, a submatrix C2, a submatrix D2, and a submatrix E2, where the submatrix A2 is a $1^{st}$ row to an $m_1^{th}$ row and a $1^{st}$ column to an $n_1^{th}$ column of the storage matrix, the submatrix B2 is the $1^{st}$ row to the $m_1^{th}$ row and an $(n_1+1)^{th}$ column to an $n_2^{th}$ column of the storage matrix, the submatrix C2 is the $1^{st}$ row to the $m_1^{th}$ row and an $(n_2+1)^{th}$ column to an $N^{th}$ column of the storage matrix, the submatrix D2 is the $(m_1+1)^{th}$ row to the $M^{th}$ row and the $1^{st}$ column to the $n_2^{th}$ column of the storage matrix, and the submatrix E2 is the $(m_1+1)^{th}$ row to the $M^{th}$ row and the $(n_2+1)^{th}$ column to the $N^{th}$ column of the storage matrix, where $1 \le m_1 \le M$; $1 \le n_1 \le n_2 \le N$; and $m_1$, M, $n_1$, $n_2$, and N are integers. An $a_1^{th}$ row of the submatrix D2 is properly included in a $b_1^{th}$ row of a third submatrix and/or an $a_2^{th}$ row of the submatrix D2, the third submatrix includes the submatrix A2 and the submatrix B2, and the $a_1^{th}$ row is any row of the submatrix D2.

In other words, a variable node (other than an extended node) included in a row other than the core part of the storage matrix is properly included in a variable node included in a parent node of the row other than the core part of the storage matrix.

With reference to any one of the first aspect or the implementations of the first aspect, in some other implementations of the first aspect, a difference between a shifting value of each non-zero element in the $a_1^{th}$ row and a shifting value of a non-zero element at a corresponding location in the $b_1^{th}$ row remains the same, and/or a difference between a shifting value of each non-zero element in the $a_1^{th}$ row and a shifting value of a non-zero element at a corresponding location in the $b_1^{th}$ row remains the same.

In other words, a difference between a shifting value of the row other than the core part of the storage matrix and a shifting value of a location corresponding to the parent node of the row other than the core part of the storage matrix is a fixed constant. Optionally, the constant may be 0.

With reference to any one of the first aspect or the implementations of the first aspect, in some other implementations of the first aspect, a plurality of rows that are of the submatrix D2 and that correspond to a $b_2^{th}$ row of the third submatrix are different from each other, and the $b_2^{th}$ row is any row of the third submatrix.

According to the foregoing method, a row weight of the core part of the storage matrix is ensured.

With reference to any one of the first aspect or the implementations of the first aspect, in some other implementations of the first aspect, a correspondence between the $a_1^{th}$ row and the $b_1^{th}$ row and a correspondence between the $a_1^{th}$ row and the $a_2^{th}$ row are determined based on the indication information.

With reference to any one of the first aspect or the implementations of the first aspect, in some other implementations of the first aspect, the method further includes: determining a quantity R of splitting times based on a code length corresponding to the LDPC base graph, a quantity of information bits corresponding to the LDPC base graph, and a quantity of information columns of the LDPC base graph; and splitting the storage matrix for R times to obtain the LDPC base graph, where an $r^{th}$ time of splitting in the R times of splitting includes the following operations: obtaining the $(m_1+r)^{th}$ row number of the indication sequence; and performing, by using an $(m_1+r)^{th}$ row of the storage matrix, elimination processing on a row that is in the storage matrix and that corresponds to the $(m_1+r)^{th}$ row number, where $m_1$ is a quantity of the non-extended rows of the storage matrix, the $r^{th}$ time of splitting is any one of the R times of splitting, and r is a positive integer.

With reference to any one of the first aspect or the implementations of the first aspect, in some other implementations of the first aspect, the storage matrix does not include an extended column.

In other words, the transmitting end stores a kernel matrix or a high-code-rate matrix.

With reference to any one of the first aspect or the implementations of the first aspect, in some other implementations of the first aspect, the $(m_1+r)^{th}$ row of the LDPC base graph is obtained based on an $r^{th}$ row of a division table, and one row of the division table is used to construct one extended row of the LDPC base graph.

With reference to any one of the first aspect or the implementations of the first aspect, in some other implementations of the first aspect, the method further includes: determining a quantity R of splitting times based on a code length corresponding to the LDPC base graph, a quantity of information bits corresponding to the LDPC base graph, and a quantity of information columns of the LDPC base graph; and splitting the storage matrix for R times to obtain the LDPC base graph, where an $r^{th}$ time of splitting in the R times of splitting includes the following operations: obtaining the $r^{th}$ row of the division table, and constructing an $r^{th}$ extended row of the storage matrix based on the $r^{th}$ row; obtaining an $(M+r)^{th}$ row number of the indication sequence; and performing elimination processing on a $k^{th}$ row by using the $r^{th}$ extended row, where the $k^{th}$ row is a row that is in the storage matrix or first r-1 extended rows of the storage matrix and that corresponds to the $(M+r)^{th}$ row number, M is a quantity of rows of the storage matrix, the $r^{th}$ time of splitting is any one of the R times of splitting, and r is a positive integer.

With reference to any one of the first aspect or the implementations of the first aspect, in some other implementations of the first aspect, R is a smallest integer that satisfies $RZ_c \geq N_0 - K_0$, where $Z_c$ is a lifting value, $Z_c$ is a smallest $Z_c$ that satisfies $KZ_c \geq K_0$ in a $Z_c$ list, $N_0$ is the code length corresponding to the LDPC base graph, $K_0$ is the quantity of information bits corresponding to the LDPC base graph, and K is the quantity of information columns of the LDPC base graph.

With reference to any one of the first aspect or the implementations of the first aspect, in some other implementations of the first aspect, if a part of parity bits corresponding to a last column of the LDPC base graph are punctured, a row after $Z_c$ lifting is used as a granularity for a last time of splitting in the R times of splitting, where $Z_c$ is a lifting value, $Z_c$ is a smallest $Z_c$ that satisfies $KZ_c \geq K_0$ in a $Z_c$ list, $K_0$ is a quantity of information bits corresponding to the LDPC base graph, and K is the quantity of information columns of the LDPC base graph.

According to the foregoing method, when the part of parity bits corresponding to the last column of the LDPC base graph need to be punctured, a basic splitting granularity may be changed from a row before $Z_c$ lifting to a row after $Z_c$ lifting, in other words, from $Z_c$ to 1, to implement fine-grained rate matching.

With reference to any one of the first aspect or the implementations of the first aspect, in some other implementations of the first aspect, the indication information is in the form of the indication sequence, the LDPC base graph is obtained by merging the storage matrix based on the indication sequence, the indication sequence includes a plurality of pieces of sub-information, each of the plurality of pieces of sub-information indicates two rows to be merged in the storage matrix, and an arrangement order of the plurality of pieces of sub-information is a merging order.

Optionally, the foregoing sub-information may be a label of an extended node, and rows to be merged are rows corresponding to the extended node. The label of the extended node may be a label numbered when only extended nodes are numbered. For example, the storage matrix includes 10 extended nodes, and numbers of the extended nodes may be sequentially 1 to 10. The label of the extended node may alternatively be a label numbered when all variable nodes are numbered. For example, if the storage matrix includes 28 variable nodes, including four extended nodes are included, labels of the extended nodes may be sequentially 25 to 28.

Optionally, the sub-information may be labels of rows to be merged. For example, when a 5th row and a 6th row of the storage matrix need to be merged, the sub-information may include a label of the 5th row and a label of the 6th row.

With reference to any one of the first aspect or the implementations of the first aspect, in some other implementations of the first aspect, the plurality of pieces of sub-information include at least one segment, each of the at least one segment corresponds to one round of merging, and labels of extended columns, of the storage matrix, corresponding to sub-information included in a $t$th segment in the at least one segment are in a form of permutation of $\{(2^{T-t}-1)s_1+1, ..., (2^{T-t+1}-1)s_1\}$ or a form of permutation of a subset of $\{(2^{T-t}-1)s_1+1, ..., (2^{T-t+1}-1)s_1\}$, where T is an upper bound of a quantity of merging rounds, $s_1$ is a quantity of non-extended rows of the storage matrix, and T and t are positive integers.

According to the foregoing method, because the labels of the extended columns, of the storage matrix, corresponding to the sub-information included in the $t$th segment are in the form of permutation of $\{(2^{T-t}-1)s_1+1, ..., (2^{T-t+1}-1)s_1\}$ or the form of permutation of a subset of $\{(2^{T-t}-1)s_1+1, ..., (2^{T-t+1}-1)s_1\}$, each label appears only once in one round of merging, and a plurality of rounds of merging included in each round may be performed in parallel. This helps improve merging efficiency.

With reference to any one of the first aspect or the implementations of the first aspect, in some other implementations of the first aspect, the storage matrix includes a fourth submatrix and a fifth submatrix, the fourth submatrix includes the non-extended columns of the storage matrix, the fifth submatrix includes extended columns of the storage matrix; a column weight of each of P columns of the fifth submatrix is 2; and one of two non-zero elements included in a $p$th column in the P columns corresponds to a $j_1$th row of the first submatrix, the other one of the two non-zero elements included in the $p$th column in the P columns corresponds to a $j_2$th row of the first submatrix, the $j_1$th row and the $j_2$th row are orthogonal to each other, and the $p$th column is any one of the P columns, where P, p, $j_1$, and $j_2$ are all positive integers.

According to the foregoing method, degrees of some or all extended nodes in the storage matrix are 2, and parts, other than extended parts, of two rows corresponding to each of the extended nodes are orthogonal to each other. Therefore, merging the two rows does not change a variable quantity of parts other than extended parts of the storage matrix.

With reference to any one of the first aspect or the implementations of the first aspect, in some other implementations of the first aspect, the storage matrix is an $S \times G$ matrix, and an $(s_1+1)$th row to an $S$th row of the storage matrix are extended rows, and a $(g_2+1)$th column to a $G$th column of the storage matrix are extended columns; and the storage matrix includes a submatrix A3, a submatrix B3, a submatrix C3, a submatrix D3, and a submatrix E3, where the submatrix A3 is a 1st row to an $s_1$th row and a 1st column to a $g_1$th column of the storage matrix, the submatrix B3 is the 1st row to the $s_1$th row and a $(g_1+1)$th column to a $g_2$th column of the storage matrix, the submatrix C3 is the 1st row to the $s_1$th row and the $(g_2+1)$th column to the $G$th column of the storage matrix, the submatrix D3 is the $(s_1+1)$th row to the $S$th row and the 1st column to the $g_2$th column of the storage matrix, and the submatrix E3 is the $(s_1+1)$th row to the $S$th row and the $(g_2+1)$th column to the $G$th column of the storage matrix, where $1 \leq s_1 \leq S$; $1 \leq g_1 \leq g_2 \leq G$; and $s_1$, S, $g_1$, $g_2$, and G are integers. Elements on a diagonal of the submatrix E3 are non-zero elements, a non-zero element is included above the diagonal of the submatrix E3, and/or a non-zero element is included below the diagonal of the submatrix E3, and the submatrix C3 includes a non-zero element.

With reference to any one of the first aspect or the implementations of the first aspect, in some other implementations of the first aspect, the method further includes: determining a quantity W of merging times based on the code rate corresponding to the LDPC base graph, a quantity of information columns of the LDPC base graph, a quantity of non-extended rows of the storage matrix, a quantity of non-extended columns of the storage matrix, and the upper bound T of the quantity of merging rounds; and merging the storage matrix for W times to obtain the LDPC base graph, where a $w^{th}$ time of merging in the W times of splitting includes the following operations: obtaining a $w^{th}$ piece of sub-information of the indication sequence; and merging two rows indicated by the $w^{th}$ piece of sub-information, where the $w^{th}$ time of merging is any one of the W times of merging, and w is a positive integer.

With reference to any one of the first aspect or the implementations of the first aspect, in some other implementations of the first aspect, W is a smallest integer that satisfies $R_0 \leq \dfrac{K}{g_1 + (2^{T1} - 1)s_1 - W}$, where $R_0$ is the code rate corresponding to the LDPC base graph; K is the quantity of information columns of the LDPC base graph; $s_1$ is the quantity of non-extended rows of the storage matrix; $g_1$ is the quantity of non-extended columns of the storage matrix; and T1 is the upper bound of the quantity of merging rounds.

With reference to any one of the first aspect or the implementations of the first aspect, in some other implementations of the first aspect, if a part of parity bits corresponding to a last column of the LDPC base graph are punctured, a row after $Z_c$ lifting is used as a granularity for a last time of merging in the W times of merging, where $Z_c$ is a lifting value, $Z_c$ is a smallest $Z_c$ that satisfies $KZ_c \geq K_0$ in a $Z_c$ list, $K_0$ is a quantity of information bits corresponding to the LDPC base graph, and K is the quantity of information columns of the LDPC base graph.

According to the foregoing method, when the part of parity bits corresponding to the last column of the LDPC base graph need to be punctured, a basic merging granularity may be changed from a row before $Z_c$ lifting to a row after $Z_c$ lifting, in other words, from $Z_c$ to 1, to implement fine-grained rate matching.

According to a second aspect, an LDPC code-based communication method is provided. The method may be performed by a receiving end, or may be performed by a module or a unit in the receiving end. Optionally, the receiving end may be a terminal or a network device.

For technical effects of the method shown in the second aspect and the possible implementations of the second aspect, refer to the first aspect and the possible implementations of the first aspect. Details are not described again.

The method includes: receiving an LDPC coding bit sequence from a transmitting end; and decoding the LDPC coding bit sequence based on an LDPC base graph, where the LDPC base graph is obtained based on a storage matrix and indication information, the indication information indicates a correspondence between rows of the storage matrix or a correspondence between rows of the LDPC base graph, and a sum of column weights of non-extended columns of the LDPC base graph is equal to a sum of column weights of non-extended columns of the storage matrix.

With reference to the second aspect, in some implementations of the second aspect, a code rate corresponding to the LDPC base graph is different from a code rate corresponding to the storage matrix.

With reference to any one of the second aspect or the implementations of the second aspect, in some other implementations of the second aspect, the LDPC base graph includes a first submatrix and a second submatrix, the first submatrix includes the non-extended columns of the LDPC base graph, the second submatrix includes extended columns of the LDPC base graph; a column weight of each of Q columns of the second submatrix is 2; and one of two non-zero elements included in a $q^{th}$ column in the Q columns corresponds to an $i_1^{th}$ row of the first submatrix, the other one of the two non-zero elements included in the $q^{th}$ column in the Q columns corresponds to an $i_2^{th}$ row of the first submatrix, the $i_1^{th}$ row and the $i_2^{th}$ row are orthogonal to each other, and the $q^{th}$ column is any one of the Q columns, where Q, q, $i_1$, and $i_2$ are all positive integers.

With reference to any one of the second aspect or the implementations of the second aspect, in some other implementations of the second aspect, the LDPC base graph is an $X \times Y$ matrix, and a $(y_2 + 1)^{th}$ column to a $Y^{th}$ column of the LDPC base graph are extended columns; and the LDPC base graph includes a submatrix A1, a submatrix B1, a submatrix C1, a submatrix D1, and a submatrix E1, where the submatrix A1 is a $1^{st}$ row to an $x_1^{th}$ row and a $1^{st}$ column to a $y_1^{th}$ column of the LDPC base graph, the submatrix B1 is the $1^{st}$ row to the $x_1^{th}$ row and a $(y_1 + 1)^{th}$ column to a $y_2^{th}$ column of the LDPC base graph, the submatrix C1 is the $1^{st}$ row to the $x_1^{th}$ row and the $(y_2 + 1)^{th}$ column to the $Y^{th}$ column of the LDPC base graph, the submatrix D1 is an $(x_1 + 1)^{th}$ row to an $X^{th}$ row and the $1^{st}$ column to the $y_2^{th}$ column of the LDPC base graph, and the submatrix E1 is the $(x_1 + 1)^{th}$ row to the $X^{th}$ row and the $(y_2 + 1)^{th}$ column to the $Y^{th}$ column of the LDPC base graph, where $1 \leq x_1 \leq X$; $1 \leq y_1 \leq y_2 \leq Y$; and $x_1$, X, $y_1$, $y_2$, and Y are integers. Elements on a diagonal of the submatrix E1 are non-zero elements, a non-zero element is included above the diagonal of the submatrix E1, and/or a non-zero element is included below the diagonal of the submatrix E1, and the submatrix C1 includes a non-zero element.

With reference to any one of the second aspect or the implementations of the second aspect, in some other implementations of the second aspect, a form used for the indication information includes at least one of an indication sequence, a mapping table, or a mapping pair.

With reference to any one of the second aspect or the implementations of the second aspect, in some other implementations of the second aspect, the indication information indicates the correspondence between the rows of the LDPC base graph, the storage matrix is used to store a connection relationship between a variable node and a check node, a shifting value of a non-zero element of the storage matrix is obtained based on a shifting value table, and the shifting value table is used to store shifting values of locations of non-extended rows of the storage matrix.

With reference to any one of the second aspect or the implementations of the second aspect, in some other implementations of the second aspect, the indication information is in the form of the indication sequence, the LDPC base graph is obtained by reading the storage matrix and the shifting value table based on the indication sequence, the indication sequence includes at least one row number, and an $i_3$th row number in the at least one row number indicates that a shifting value of an $i_3$th row of the LDPC base graph is determined based on a shifting value of a row identified by the $i_3$th row number in the at least one row number, where $i_3$ is a positive integer.

With reference to any one of the second aspect or the implementations of the second aspect, in some other implementations of the second aspect, the indication information is in the form of the indication sequence, the LDPC base graph is obtained by splitting the storage matrix based on the indication sequence, the indication sequence includes at least one row number, an $(m_1+r)$th row number in the at least one row number indicates that an $(m_1+r)$th row of the LDPC base graph is used to perform elimination processing on a row identified by the $(m_1+r)$th row number in the at least one row number, and a sorting order of the at least one row number is a splitting order, where $m_1$ is a quantity of non-extended rows of the storage matrix, and r is a positive integer.

With reference to any one of the second aspect or the implementations of the second aspect, in some other implementations of the second aspect, the at least one row number includes at least one segment, each of the at least one segment corresponds to one round of splitting, and row numbers in a segment corresponding to a $t$th round of splitting in at least one round of splitting corresponding to the at least one segment are in a form of permutation of $\{1, ..., 2^{t-1}m_1\}$ or a form of permutation of a subset of $\{1, ..., 2^{t-1}m_1\}$, where t is a positive integer.

With reference to any one of the second aspect or the implementations of the second aspect, in some other implementations of the second aspect, the storage matrix is an $M \times N$ matrix, and an $(m_1+1)$th row to an $M$th row of the storage matrix are extended rows; and the storage matrix includes a submatrix A2, a submatrix B2, a submatrix C2, a submatrix D2, and a submatrix E2, where the submatrix A2 is a 1st row to an $m_1$th row and a 1st column to an $n_1$th column of the storage matrix, the submatrix B2 is the 1st row to the $m_1$th row and an $(n_1+1)$th column to an $n_2$th column of the storage matrix, the submatrix C2 is the 1st row to the $m_1$th row and an $(n_2+1)$th column to an $N$th column of the storage matrix, the submatrix D2 is the $(m_1+1)$th row to the $M$th row and the 1st column to the $n_2$th column of the storage matrix, and the submatrix E2 is the $(m_1+1)$th row to the $M$th row and the $(n_2+1)$th column to the $N$th column of the storage matrix, where $1 \le m_1 \le M$; $1 \le n_1 \le n_2 \le N$; and $m_1$, M, $n_1$, $n_2$, and N are integers. An $a_1$th row of the submatrix D2 is properly included in a $b_1$th row of a third submatrix and/or an $a_2$th row of the submatrix D2, the third submatrix includes the submatrix A2 and the submatrix B2, and the $a_1$th row is any row of the submatrix D2.

With reference to any one of the second aspect or the implementations of the second aspect, in some other implementations of the second aspect, a difference between a shifting value of each non-zero element in the $a_1$th row and a shifting value of a non-zero element at a corresponding location in the $b_1$th row remains the same, and/or a difference between a shifting value of each non-zero element in the $a_1$th row and a shifting value of a non-zero element at a corresponding location in the $b_1$th row remains the same.

With reference to any one of the second aspect or the implementations of the second aspect, in some other implementations of the second aspect, a plurality of rows that are of the submatrix D2 and that correspond to a $b_2$th row of the third submatrix are different from each other, and the $b_2$th row is any row of the third submatrix.

With reference to any one of the second aspect or the implementations of the second aspect, in some other implementations of the second aspect, a correspondence between the $a_1$th row and the $b_1$th row and a correspondence between the $a_1$th row and the $a_2$th row are determined based on the indication information.

With reference to any one of the second aspect or the implementations of the second aspect, in some other implementations of the second aspect, the method further includes: determining a quantity R of splitting times based on a code length corresponding to the LDPC base graph, a quantity of information bits corresponding to the LDPC base graph, and a quantity of information columns of the LDPC base graph; and splitting the storage matrix for R times to obtain the LDPC base graph, where an $r$th time of splitting in the R times of splitting includes the following operations: obtaining the $(m_1+r)$th row number of the indication sequence; and performing, by using an $(m_1+r)$th row of the storage matrix, elimination processing on a row that is in the storage matrix and that corresponds to the $(m_1+r)$th row number, where $m_1$ is a quantity of the non-extended rows of the storage matrix, the $r$th time of splitting is any one of the R times of splitting, and r is a positive integer.

With reference to any one of the second aspect or the implementations of the second aspect, in some other implementations of the second aspect, the storage matrix does not include an extended column.

With reference to any one of the second aspect or the implementations of the second aspect, in some other implementations of the second aspect, the $(m_1+r)$th row of the LDPC base graph is obtained based on an $r$th row of a division table, and one row of the division table is used to construct one extended row of the LDPC base graph.

With reference to any one of the second aspect or the implementations of the second aspect, in some other implementations of the second aspect, the method further includes: determining a quantity R of splitting times based on a code length corresponding to the LDPC base graph, a quantity of information bits corresponding to the LDPC base graph, and a quantity of information columns of the LDPC base graph; and splitting the storage matrix for R times to obtain the LDPC base graph, where an $r^{th}$ time of splitting in the R times of splitting includes the following operations: obtaining the $r^{th}$ row of the division table, and constructing an $r^{th}$ extended row of the storage matrix based on the $r^{th}$ row; obtaining an $(M+r)^{th}$ row number of the indication sequence; and performing elimination processing on a $k^{th}$ row by using the $r^{th}$ extended row, where the $k^{th}$ row is a row that is in the storage matrix or first r-1 extended rows of the storage matrix and that corresponds to the $(M+r)^{th}$ row number, M is a quantity of rows of the storage matrix, the $r^{th}$ time of splitting is any one of the R times of splitting, and r is a positive integer.

With reference to any one of the second aspect or the implementations of the second aspect, in some other implementations of the second aspect, R is a smallest integer that satisfies $RZ_c \geq N_0 - K_0$, where $Z_c$ is a lifting value, $Z_c$ is a smallest $Z_c$ that satisfies $KZ_c \geq K_0$ in a $Z_c$ list, $N_0$ is the code length corresponding to the LDPC base graph, $K_0$ is the quantity of information bits corresponding to the LDPC base graph, and K is the quantity of information columns of the LDPC base graph.

With reference to any one of the second aspect or the implementations of the second aspect, in some other implementations of the second aspect, if a part of parity bits corresponding to a last column of the LDPC base graph are punctured, a row after $Z_c$ lifting is used as a granularity for a last time of splitting in the R times of splitting, where $Z_c$ is a lifting value, $Z_c$ is a smallest $Z_c$ that satisfies $KZ_c \geq K_0$ in a $Z_c$ list, $K_0$ is a quantity of information bits corresponding to the LDPC base graph, and K is the quantity of information columns of the LDPC base graph.

With reference to any one of the second aspect or the implementations of the second aspect, in some other implementations of the second aspect, the indication information is in the form of the indication sequence, the LDPC base graph is obtained by merging the storage matrix based on the indication sequence, the indication sequence includes a plurality of pieces of sub-information, each of the plurality of pieces of sub-information indicates two rows to be merged in the storage matrix, and an arrangement order of the plurality of pieces of sub-information is a merging order.

With reference to any one of the second aspect or the implementations of the second aspect, in some other implementations of the second aspect, the plurality of pieces of sub-information include at least one segment, each of the at least one segment corresponds to one round of merging, and labels of extended columns, of the storage matrix, corresponding to sub-information included in a $t^{th}$ segment in the at least one segment are in a form of permutation of $\{(2^{T-t}-1)s_1+1, ..., (2^{T-t+1}-1)s_1\}$ or a form of permutation of a subset of $\{(2^{T-t}-1)s_1+1, ..., (2^{T-t+1}-1)s_1\}$, where T is an upper bound of a quantity of merging rounds, $s_1$ is a quantity of non-extended rows of the storage matrix, and T and t are positive integers.

With reference to any one of the second aspect or the implementations of the second aspect, in some other implementations of the second aspect, the storage matrix includes a fourth submatrix and a fifth submatrix, the fourth submatrix includes the non-extended columns of the storage matrix, the fifth submatrix includes extended columns of the storage matrix; a column weight of each of P columns of the fifth submatrix is 2; and one of two non-zero elements included in a $p^{th}$ column in the P columns corresponds to a $j_1^{th}$ row of the first submatrix, the other one of the two non-zero elements included in the $p^{th}$ column in the P columns corresponds to a $j_2^{th}$ row of the first submatrix, the $j_1^{th}$ row and the $j_2^{th}$ row are orthogonal to each other, and the $p^{th}$ column is any one of the P columns, where P, p, $j_1$, and $j_2$ are all positive integers.

With reference to any one of the second aspect or the implementations of the second aspect, in some other implementations of the second aspect, the storage matrix is an $S \times G$ matrix, and an $(s_1+1)^{th}$ row to an $S^{th}$ row of the storage matrix are extended rows, and a $(g_2+1)^{th}$ column to a $G^{th}$ column of the storage matrix are extended columns; and the storage matrix includes a submatrix A3, a submatrix B3, a submatrix C3, a submatrix D3, and a submatrix E3, where the submatrix A3 is a $1^{st}$ row to an $s_1^{th}$ row and a $1^{st}$ column to a $g_1^{th}$ column of the storage matrix, the submatrix B3 is the $1^{st}$ row to the $s_1^{th}$ row and a $(g_1+1)^{th}$ column to a $g_2^{th}$ column of the storage matrix, the submatrix C3 is the $1^{st}$ row to the $s_1^{th}$ row and the $(g_2+1)^{th}$ column to the $G^{th}$ column of the storage matrix, the submatrix D3 is the $(s_1+1)^{th}$ row to the $S^{th}$ row and the $1^{st}$ column to the $g_2^{th}$ column of the storage matrix, and the submatrix E3 is the $(s_1+1)^{th}$ row to the $S^{th}$ row and the $(g_2+1)^{th}$ column to the $G^{th}$ column of the storage matrix, where $1 \leq s_1 \leq S$; $1 \leq g_1 \leq g_2 \leq G$; and $s_1$, S, $g_1$, $g_2$, and G are integers. Elements on a diagonal of the submatrix E3 are non-zero elements, a non-zero element is included above the diagonal of the submatrix E3, and/or a non-zero element is included below the diagonal of the submatrix E3, and the submatrix C3 includes a non-zero element.

With reference to any one of the second aspect or the implementations of the second aspect, in some other implementations of the second aspect, the method further includes: determining a quantity W of merging times based on the code rate corresponding to the LDPC base graph, a quantity of information columns of the LDPC base graph, a quantity of non-extended rows of the storage matrix, a quantity of non-extended columns of the storage matrix, and the upper bound T of the quantity of merging rounds; and merging the storage matrix for W times to obtain the LDPC base graph, where a $w^{th}$ time of merging in the W times of splitting includes the following operations: obtaining a $w^{th}$ piece of sub-information of the indication sequence; and merging two rows indicated by the $w^{th}$ piece of sub-information, where the $w^{th}$

time of merging is any one of the W times of merging, and w is a positive integer.

With reference to any one of the second aspect or the implementations of the second aspect, in some other implementations of the second aspect, W is a smallest integer that satisfies $R_0 \leq \dfrac{K}{g_1 + (2^{T1}-1)s_1 - W}$, where $R_0$ is the code rate corresponding to the LDPC base graph; K is the quantity of information columns of the LDPC base graph; $s_1$ is the quantity of non-extended rows of the storage matrix; $g_1$ is the quantity of non-extended columns of the storage matrix; and T1 is the upper bound of the quantity of merging rounds.

With reference to any one of the second aspect or the implementations of the second aspect, in some other implementations of the second aspect, if a part of parity bits corresponding to a last column of the LDPC base graph are punctured, a row after $Z_c$ lifting is used as a granularity for a last time of merging in the W times of merging, where $Z_c$ is a lifting value, $Z_c$ is a smallest $Z_c$ that satisfies $KZ_c \geq K_0$ in a $Z_c$ list, $K_0$ is a quantity of information bits corresponding to the LDPC base graph, and K is the quantity of information columns of the LDPC base graph.

In a possible implementation, that the receiving end performs channel decoding on the LDPC coding bit sequence based on the LDPC base graph includes: decoding, in a first decoding manner, a row that is in the LDPC coding bit sequence and that corresponds to the $i_1$th row and a row that is in the LDPC coding bit sequence and that corresponds to the $i_2$th row; and decoding, in a second decoding manner, a row that is in the LDPC coding bit sequence and that corresponds to an $i_1$th row of the second submatrix and a row that is in the LDPC coding bit sequence and that corresponds to an $i_2$th row of the second submatrix. The first decoding manner is row parallel decoding, and the second decoding manner is different from the first decoding manner.

In other words, for an $i_1$th row and an $i_2$th row of the LDPC base graph, the first decoding manner (namely, row parallel decoding) is used for a location other than an extended node in the two rows, and decoding in the second decoding manner is performed for a location corresponding to the extended node in the two rows.

In a possible implementation, the $i_1$th row and the $i_2$th row of the LDPC base graph are used as an example. It is assumed that the $i_1$th row corresponds to a first check node, and the $i_2$th row corresponds to a second extended node. The following decoding operations may be performed on a first extended node (where a correspondence may be described in the feature 2) corresponding to the $i_1$th row and the $i_2$th row: obtaining first information stored on the first extended node and second information stored on the first check node, where the first information is information sent by the first extended node to the first check node in a previous decoding iteration process, and the second information is information sent by the first check node to the first extended node in the previous decoding iteration process; obtaining third information stored on a second check node, where the third information is information sent by the second check node to the first extended node in the previous decoding iteration process; determining fourth information based on the first information, the second information, and the third information, and storing the fourth information on the second check node, where the fourth information is information sent by the second check node to the first extended node in a current decoding iteration process; determining fifth information based on the fourth information and the first information, and storing the fifth information on the first extended node, where the fifth information is information sent by the first extended node to the first check node in the current decoding iteration process; and determining sixth information based on the fourth information, and storing the sixth information on the first check node, where the sixth information is information sent by the first check node to the first extended node in the current decoding iteration process.

In the foregoing decoding process, in addition to being used to update storage of the second check node, the information sent by the second check node to the first extended node in the current decoding iteration process may be directly used, without being stored, to calculate the information sent by the first extended node to the first check node in the current decoding iteration process and the information sent by the first check node to the first extended node in the current decoding iteration process. In this way, pipeline decoding is performed, and times of reading and updating the first extended node, the first check node, and the second check node can be reduced.

According to a third aspect, an LDPC code-based communication method is provided. The method may be performed by a transmitting end, or may be performed by a module or a unit in the transmitting end, which is collectively referred to as the transmitting end below for ease of description. Optionally, the transmitting end may be a terminal or a network device.

The method includes: obtaining an information bit sequence; performing LDPC encoding on the information bit sequence based on a storage matrix to obtain a first LDPC coding bit sequence, where the storage matrix includes a fourth submatrix and a fifth submatrix, the fourth submatrix includes non-extended columns of the storage matrix, the fifth submatrix includes extended columns of the storage matrix; a column weight of each of P columns of the fifth submatrix is 2; and one of two non-zero elements included in a $p$th column in the P columns corresponds to a $j_1$th row of a first submatrix, the other one of the two non-zero elements included in the $p$th column in the P columns corresponds to a $j_2$th row of the first submatrix, the $j_1$th row and the $j_2$th row are orthogonal to each other, and the $p$th column is any one of the P columns, where P, p, $j_1$, and $j_2$ are all positive integers; and sending a second LDPC coding bit sequence based on indication information, where the indication information indicates a punctured column of the fifth submatrix, and the second LDPC coding bit sequence includes coding bits that are in the first LDPC coding bit sequence and that are different from coding bits corresponding to the punctured column of the fifth submatrix.

The LDPC base graph may be a matrix stored at the transmitting end, namely, the storage matrix. The matrix may be a check matrix with a lowest code rate.

According to the foregoing method, degrees of some or all extended nodes of the LDPC base graph are 2, and parts, other than extended parts, of two rows corresponding to each of the extended nodes are orthogonal to each other. Therefore, the extended nodes may be punctured to implement a merging effect, so as to increase a code rate from low to high. In addition, because the parts, other than the extended parts, of the two rows corresponding to each of the extended nodes are orthogonal to each other, merging the two rows does not change a variable quantity of parts other than extended parts of the LDPC base graph.

In addition, the foregoing method supports a flexible code rate, and further supports an IR-HARQ mechanism.

In addition, because the code rate is changed through puncturing, the used LDPC base graph does not change. Therefore, calculation units used for encoding and decoding at the transmitting end and the receiving end may be fixedly disposed.

With reference to the third aspect, in some implementations of the third aspect, the storage matrix is an $S \times G$ matrix, and an $(s_1+1)^{th}$ row to an $S^{th}$ row of the storage matrix are extended rows, and a $(g_2+1)^{th}$ column to a $G^{th}$ column of the storage matrix are extended columns; and the storage matrix includes a submatrix A3, a submatrix B3, a submatrix C3, a submatrix D3, and a submatrix E3, where the submatrix A3 is a $1^{st}$ row to an $s_1^{th}$ row and a $1^{st}$ column to a $g_1^{th}$ column of the storage matrix, the submatrix B3 is the $1^{st}$ row to the $s_1^{th}$ row and a $(g_1+1)^{th}$ column to a $g_2^{th}$ column of the storage matrix, the submatrix C3 is the $1^{st}$ row to the $s_1^{th}$ row and the $(g_2+1)^{th}$ column to the $G^{th}$ column of the storage matrix, the submatrix D3 is the $(s_1+1)^{th}$ row to the $S^{th}$ row and the $1^{st}$ column to the $g_2^{th}$ column of the storage matrix, and the submatrix E3 is the $(s_1+1)^{th}$ row to the $S^{th}$ row and the $(g_2+1)^{th}$ column to the $G^{th}$ column of the storage matrix, where $1 \le s_1 \le S$; $1 \le g_1 \le g_2 \le G$; and $s_1$, $S$, $g_1$, $g_2$, and $G$ are integers. Elements on a diagonal of the submatrix E3 are non-zero elements, a non-zero element is included above the diagonal of the submatrix E3, and/or a non-zero element is included below the diagonal of the submatrix E3, and the submatrix C3 includes a non-zero element.

With reference to any one of the third aspect or the implementations of the third aspect, in some other implementations of the third aspect, a form used for the indication information includes at least one of an indication sequence, a mapping table, or a mapping pair.

With reference to any one of the third aspect or the implementations of the third aspect, in some other implementations of the third aspect, the indication information is in the form of the indication sequence, the indication sequence includes a plurality of pieces of sub-information, each of the plurality of pieces of sub-information indicates one of the extended columns of the storage matrix, and an arrangement order of the plurality of pieces of sub-information is a puncturing order.

Optionally, the sub-information may be a label of the extended node. The label of the extended node may be a label numbered when only extended nodes are numbered. For example, the storage matrix includes 10 extended nodes, and numbers of the extended nodes may be sequentially 1 to 10. The label of the extended node may alternatively be a label numbered when all variable nodes are numbered. For example, if the storage matrix includes 28 variable nodes, including four extended nodes, labels of the extended nodes may be sequentially 25 to 28.

With reference to any one of the third aspect or the implementations of the third aspect, in some other implementations of the third aspect, the plurality of pieces of sub-information include at least one segment, each of the at least one segment corresponds to one round of puncturing, and labels of extended columns indicated by sub-information included in a $t^{th}$ segment in the at least one segment are in a form of permutation of $\{(2^{T-t}-1)s_1+1, ..., 2^{T-t+1}-1)s_1\}$ or a form of permutation of a subset of $\{(2^{T-t}-1)s_1+1, ..., 2^{T-t+1}-1)s_1\}$, where T is an upper bound of a quantity of merging rounds, $s_1$ is a quantity of non-extended rows of the storage matrix, and T and t are positive integers.

According to the foregoing method, because the labels of the extended columns corresponding to the sub-information included in the $t^{th}$ segment are in the form of permutation of $\{(2^T-1)s_1+1, ..., 2^{T-t+1}-1)s_1\}$ or the form of permutation of the subset of $\{(2^T-1)s_1+1, ..., 2^{T-t+1}-1)s_1\}$, each label appears only once in one round of puncturing, and a plurality of times of puncturing included in each round may be performed in parallel. This helps improve puncturing efficiency.

With reference to any one of the third aspect or the implementations of the third aspect, in some other implementations of the third aspect, a quantity J of pieces of sub-information included in the indication sequence is a smallest integer that satisfies $R_0 \le \dfrac{K}{g_2 + (2^{T2}-1)s_1 - J}$, where $R_0$ is a target code rate, K is a target quantity of information columns, $s_1$ is the quantity of non-extended rows of the storage matrix, $g_2$ is a quantity of non-extended columns of the storage matrix, and T2 is the upper bound of the quantity of merging rounds.

According to a fourth aspect, an LDPC code-based communication method is provided. The method may be performed by a receiving end, or may be performed by a module or a unit in the receiving end. Optionally, the receiving end may be a terminal or a network device.

For technical effects of the method shown in the fourth aspect and the possible implementations of the fourth aspect, refer to the third aspect and the possible implementations of the third aspect. Details are not described again.

The method includes: receiving an LDPC coding bit sequence from a transmitting end; and decoding the LDPC coding bit sequence based on a storage matrix and indication information, where the storage matrix includes a fourth submatrix and a fifth submatrix, the fourth submatrix includes non-extended columns of the storage matrix, the fifth submatrix includes extended columns of the storage matrix; a column weight of each of P columns of the fifth submatrix is 2; one of two non-zero elements included in a $p^{th}$ column in the P columns corresponds to a $j_1^{th}$ row of a first submatrix, the other one of the two non-zero elements included in the $p^{th}$ column in the P columns corresponds to a $j_2^{th}$ row of the first submatrix, the $j_1^{th}$ row and the $j_2^{th}$ row are orthogonal to each other, and the $p^{th}$ column is any one of the P columns, where P, p, $j_1$, and $j_2$ are all positive integers; and the indication information indicates a punctured column of the fifth submatrix, and the second LDPC coding bit sequence includes coding bits that are in a first LDPC coding bit sequence and that are different from coding bits corresponding to the punctured column of the fifth submatrix.

With reference to the fourth aspect, in some implementations of the fourth aspect, the storage matrix is an $S \times G$ matrix, and an $(s_1+1)^{th}$ row to an $S^{th}$ row of the storage matrix are extended rows, and a $(g_2+1)^{th}$ column to a $G^{th}$ column of the storage matrix are extended columns; and the storage matrix includes a submatrix A3, a submatrix B3, a submatrix C3, a submatrix D3, and a submatrix E3, where the submatrix A3 is a $1^{st}$ row to an $s_1^{th}$ row and a $1^{st}$ column to a $g_1^{th}$ column of the storage matrix, the submatrix B3 is the $1^{st}$ row to the $s_1^{th}$ row and a $(g_1+1)^{th}$ column to a $g_2^{th}$ column of the storage matrix, the submatrix C3 is the $1^{st}$ row to the $s_1^{th}$ row and the $(g_2+1)^{th}$ column to the $G^{th}$ column of the storage matrix, the submatrix D3 is the $(s_1+1)^{th}$ row to the $S^{th}$ row and the $1^{st}$ column to the $g_2^{th}$ column of the storage matrix, and the submatrix E3 is the $(s_1+1)^{th}$ row to the $S^{th}$ row and the $(g_2+1)^{th}$ column to the $G^{th}$ column of the storage matrix, where $1 \leq s_1 \leq S$; $1 \leq g_1 \leq g_2 \leq G$; and $s_1$, S, $g_1$, $g_2$, and G are integers. Elements on a diagonal of the submatrix E3 are non-zero elements, a non-zero element is included above the diagonal of the submatrix E3, and/or a non-zero element is included below the diagonal of the submatrix E3, and the submatrix C3 includes a non-zero element.

With reference to any one of the fourth aspect or the implementations of the fourth aspect, in some other implementations of the fourth aspect, a form used for the indication information includes at least one of an indication sequence, a mapping table, or a mapping pair.

With reference to any one of the fourth aspect or the implementations of the fourth aspect, in some other implementations of the fourth aspect, the indication information is in the form of the indication sequence, the indication sequence includes a plurality of pieces of sub-information, each of the plurality of pieces of sub-information indicates one of the extended columns of the storage matrix, and an arrangement order of the plurality of pieces of sub-information is a puncturing order.

With reference to any one of the fourth aspect or the implementations of the fourth aspect, in some other implementations of the fourth aspect, the plurality of pieces of sub-information include at least one segment, each of the at least one segment corresponds to one round of puncturing, and labels of extended columns indicated by sub-information included in a $t^{th}$ segment in the at least one segment are in a form of permutation of $\{(2^{T-t}-1)s_1+1, ..., 2^{T-t+1}-1)s_1\}$ or a form of permutation of a subset of $\{(2^{T-t}-1)s_1+1, ..., 2^{T-t+1}-1)s_1\}$, where T is an upper bound of a quantity of merging rounds, $s_1$ is a quantity of non-extended rows of the storage matrix, and T and t are positive integers.

With reference to any one of the fourth aspect or the implementations of the fourth aspect, in some other implementations of the fourth aspect, a quantity J of pieces of sub-information included in the indication sequence is a smallest integer that satisfies $R_0 \leq \dfrac{K}{g_2+(2^{T2}-1)s_1-J}$, where $R_0$ is a target code rate, K is a target quantity of information columns, $s_1$ is the quantity of non-extended rows of the storage matrix, $g_2$ is a quantity of non-extended columns of the storage matrix, and T2 is the upper bound of the quantity of merging rounds.

According to a fifth aspect, a communication apparatus is provided. The apparatus is configured to perform the method provided in any one of the foregoing aspects or the implementations of the foregoing aspects. Specifically, the apparatus may include a unit and/or a module configured to perform the method provided in any one of the foregoing aspects or the implementations of the foregoing aspects, for example, a processing unit and/or a communication unit.

In an implementation, the apparatus is a transmitting end or a receiving end. When the apparatus is the transmitting end or the receiving end, the communication unit may be a transceiver, an input/output interface, or a communication interface; and the processing unit may be at least one processor. Optionally, the transceiver is a transceiver circuit. Optionally, the input/output interface is an input/output circuit.

In another implementation, the apparatus is a chip, a chip system, or a circuit used at a transmitting end or a receiving end. When the apparatus is the chip, the chip system, or the circuit used at the transmitting end or the receiving end, the communication unit may be an input/output interface, an interface circuit, an output circuit, an input circuit, a pin, a related circuit, or the like on the chip, the chip system, or the circuit; and the processing unit may be at least one processor, processing circuit, logic circuit, or the like.

According to a sixth aspect, a communication apparatus is provided. The apparatus includes: a memory, configured to store a program; and at least one processor, configured to execute a computer program or instructions stored in the memory, to perform the method provided in any one of the foregoing aspects or the implementations of the foregoing aspects.

In an implementation, the apparatus is a transmitting end or a receiving end.

In another implementation, the apparatus is a chip, a chip system, or a circuit used at a transmitting end or a receiving end.

According to a seventh aspect, a communication apparatus is provided. The apparatus includes at least one processor and a communication interface. The at least one processor is configured to obtain, through the communication interface, a computer program or instructions stored in a memory, to perform the method provided in any one of the foregoing aspects or the implementations of the foregoing aspects. The communication interface may be implemented by hardware or software.

In an implementation, the apparatus further includes the memory.

According to an eighth aspect, a processor is provided. The processor is configured to perform the methods provided in the foregoing aspects.

Unless otherwise specified, or if operations such as sending and obtaining/receiving related to the processor do not conflict with actual functions or internal logic in related descriptions, the operations may be understood as operations such as output, receiving, and input of the processor, or may be understood as operations such as sending and receiving performed by a radio frequency circuit and an antenna. This is not limited in this application.

According to a ninth aspect, a computer-readable storage medium is provided. The computer-readable storage medium stores program code to be executed by a device, and the program code is used to perform the method provided in any one of the foregoing aspects or the implementations of the foregoing aspects.

According to a tenth aspect, a computer program product including instructions is provided. When the computer program product runs on a computer, the computer is enabled to perform the method provided in any one of the foregoing aspects or the implementations of the foregoing aspects.

According to an eleventh aspect, a chip is provided. The chip includes a processor and a communication interface. The processor reads, through the communication interface, instructions stored in a memory, to perform the method provided in any one of the foregoing aspects or the implementations of the foregoing aspects. The communication interface may be implemented by hardware or software.

Optionally, in an implementation, the chip further includes the memory. The memory stores a computer program or the instructions. The processor is configured to execute the computer program or the instructions stored in the memory. When the computer program is executed or the instructions are executed, the processor is configured to perform the method provided in any one of the foregoing aspects or the implementations of the foregoing aspects.

When the method provided in this application is performed by the chip, a quantity of chips that specifically implement the method of this application is not limited in this application. For example, the method may be performed by one chip, or may be performed by two or more chips. In addition, when there are two or more chips that implement the method of this application, a chip vendor is not limited. The chips may be from a same vendor or from different vendors.

According to a twelfth aspect, a communication system is provided. The system includes the foregoing transmitting end and/or receiving end.

According to a thirteenth aspect, a computer program is provided. When the computer program is run on a computer, the method provided in any one of the foregoing aspects or the implementations of the foregoing aspects is performed.

**BRIEF DESCRIPTION OF DRAWINGS**

FIG. 1 is a diagram of a communication scenario to which an embodiment of this application is applicable;

FIG. 2 is a diagram of a check matrix H of LDPC;

FIG. 3 is a Tanner graph of a check matrix H of LDPC;

FIG. 4 is a diagram of a structure of a parity check matrix of 5G NR LDPC;

FIG. 5 is a diagram of an information transmission procedure;

FIG. 6 is a schematic flowchart of an LDPC code-based communication method 600 according to this application;

FIG. 7 is an example of an LDPC base graph;

FIG. 8 is a diagram of one time of splitting of a high-code-rate matrix;

FIG. 9 is a diagram of a progressive splitting manner;

FIG. 10 is a diagram of two complete rounds of splitting of a high-code-rate matrix;

FIG. 11 is a diagram of a split sequence;

FIG. 12 is a diagram of a correspondence between a division table and a split sequence;

FIG. 13 is an example of a division table;

FIG. 14 is a diagram of one time of splitting;

FIG. 15 is another diagram of one time of splitting;

FIG. 16 is a diagram of fine-grained rate matching;

FIG. 17 is a diagram of one time of merging;

FIG. 18 is a schematic flowchart of an LDPC code-based communication method 1800 according to this application;

FIG. 19 is a diagram of a structure of an apparatus according to an embodiment of this application; and

FIG. 20 is another diagram of a structure of an apparatus according to an embodiment of this application.

## DESCRIPTION OF EMBODIMENTS

For ease of understanding of embodiments of this application, before embodiments of this application are described, the following descriptions are first provided.

In this application, "indicating" or "indicate" may include a direct indication and an indirect indication, or "indicating" or "indicate" may be an explicit indication and/or an implicit indication. For example, when a piece of indication information is described as indicating information I, the indication information may directly indicate I or indirectly indicate I, but it does not necessarily indicate that the indication information carries I. For another example, the implicit indication may be based on a location and/or a resource used for transmission; and the explicit indication may be based on one or more parameters, and/or one or more indexes, and/or one or more bit patterns represented by the explicit indication.

Definitions listed for many features in this application are merely used to explain functions of the features by using examples. For detailed content of the definitions, refer to the conventional technology.

In the following embodiments, first, second, third, fourth, and various numbers are merely used for differentiation for ease of description, but are not used to limit the scope of embodiments of this application, for example, used for differentiation between different fields and different information.

"Pre-definition" may be implemented by pre-storing corresponding code or a corresponding table in a device, or may be implemented in another manner that may be used for indicating related information. A specific implementation of "pre-definition" is not limited in this application. "Storing" may be storage in one or more memories. A type of the memory may be a storage medium in any form. This is not limited in this application.

A "protocol" in embodiments of this application may be a standard protocol in the communication field, for example, may include a long term evolution (long term evolution, LTE) protocol, a new radio (new radio, NR) protocol, and a related protocol applied to a future communication system. This is not limited in this application.

Each aspect, embodiment, or feature is presented in this application with reference to a system including a plurality of devices, components, modules, and the like. It should be appreciated and understood that, each system may include another device, component, module, and the like, and/or may not include all devices, components, modules, and the like discussed with reference to the accompanying drawings. In addition, a combination of these solutions may be used.

In embodiments of this application, words such as "example", "for example", and "in an (another) example" are used to represent giving an example, an illustration, or a description. Any embodiment or design scheme described as an "example" in this application should not be explained as being more preferred or having more advantages than another embodiment or design scheme. Exactly, the term "example" is for presenting a concept in a specific manner.

The terms "include", "have", and their variants all mean "include but are not limited to", unless otherwise specifically emphasized in another manner.

"At least one" means one or more, and "a plurality of" means two or more. The term "and/or" describes an association relationship between associated objects, and represents that three relationships may exist. For example, A and/or B may represent the following cases: Only A exists, both A and B exist, and only B exists, where A and B may be singular or plural. The character "/" usually indicates an "or" relationship between the associated objects. At least one of the following items (pieces) or a similar expression thereof indicates any combination of these items, including a single item (piece) or any combination of a plurality of items (pieces). For example, at least one of a, b, and c may indicate a, b, c, a and b, a and c, b and c, or a, b, and c. Each of a, b, and c may be in a singular form or a plural form.

In embodiments of this application, related descriptions of sending a message, information, or data by a network element A to a network element B, and receiving, by the network element B, the message, information, or data from the network element A are intended to describe a network element to which the message, information, or data is to be sent. Whether the message, information, or data is directly sent or indirectly sent through another network element is not limited.

In embodiments of this application, the descriptions "when...", "in a case that...", "if", and the like all mean that a device performs corresponding processing in an objective case, but are not intended to limit time. The descriptions do not necessarily mean that the device performs a determining action during implementation, and do not mean any other limitation.

The technical solutions in embodiments of this application are applicable to various communication systems, including but not limited to a 5th generation (5th generation, 5G) system or an NR system, an LTE system, a long term evolution-advanced (long term evolution-advanced, LTE-A) system, an LTE frequency division duplex (frequency division duplex, FDD) system, an LTE time division duplex (time division duplex, TDD) system, and the like. The technical solutions are further applicable to a future communication system, for example, a 6th generation mobile communication system. In addition, the technical solutions are further applicable to device to device (device to device, D2D) communication, vehicle-to-everything (vehicle-to-everything, V2X) communication, machine to machine (machine to machine, M2M) communication, machine type communication (machine type communication, MTC), an internet of things (internet of things, IoT) communication system, or another communication system. In addition, the technical solutions may be further extended to a similar wireless communication system, for example, a communication system related to wireless-fidelity (wireless-fidelity, Wi-Fi), worldwide interoperability for microwave access (worldwide interoperability for microwave access, WiMAX), and the 3rd generation partnership project (3rd generation partnership project, 3GPP). This is not limited.

The communication system applicable to this application may include one or more transmitting ends and one or more receiving ends. Optionally, one of the transmitting end and the receiving end may be a terminal device, and the other may be a network device. Optionally, both the transmitting end and the receiving end may be terminals. Optionally, both the transmitting end and the receiving end may be network devices.

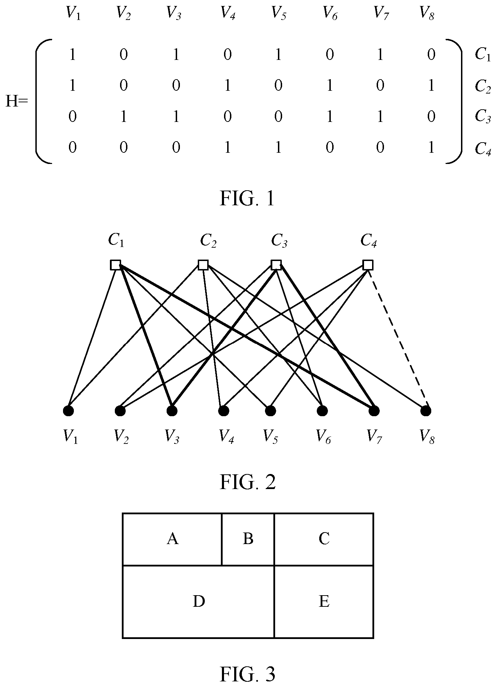

For example, FIG. 1 is a diagram of a communication scenario to which an embodiment of this application is applicable.

As shown in FIG. 1, this embodiment of this application is applicable to uplink data transmission and is also applicable to downlink data transmission. In FIG. 1, only uplink data transmission or downlink data transmission between one network device and two terminals (for example, a terminal 1 and a terminal 2) is used as an example. In uplink data transmission, the transmitting end in this specification is a terminal, and the receiving end is a network device. In downlink data transmission, the transmitting end is a network device, and the receiving end is a terminal. In addition, applicability of embodiments of this application in another communication scenario is not limited. For example, embodiments of this application may also be applied to sidelink communication.

The terminal in this application may also be referred to as a user equipment (user equipment, UE), an access terminal, a subscriber unit, a subscriber station, a mobile station, a mobile terminal (mobile terminal, MT), a remote station, a remote terminal, a mobile device, a user terminal, a terminal device, an uncrewed aerial vehicle, a wireless communication device, a user agent, or a user apparatus. The terminal device in embodiments of this application may be a device that provides voice and/or data connectivity for a user, and may be configured to connect a person, an object, and a machine, for example, a handheld device or a vehicle-mounted device having a wireless connection function. The terminal device in embodiments of this application may be a mobile phone (mobile phone), a tablet computer (pad), a notebook computer, a palmtop computer, a mobile internet device (mobile internet device, MID), a wearable device, a virtual reality (virtual reality, VR) device, an augmented reality (augmented reality, AR) device, a wireless terminal in industrial control (industrial control), a wireless terminal in self driving (self driving), a wireless terminal in remote surgery (remote surgery), a wireless terminal in a smart grid (smart grid), a wireless terminal in transportation safety (transportation safety), a wireless terminal in a smart city (smart city), a wireless terminal in a smart home (smart home), or the like.

The network device in this application may be a device having a wireless transceiver function. The network device may be a device that provides a wireless communication function service, is usually located on a network side, and includes but is not limited to a next generation NodeB (gNodeB, gNB) in a 5G system, a base station in a 6th generation mobile communication system, a base station in a future mobile communication system, an access node in a wireless fidelity (wireless fidelity, Wi-Fi) system, an evolved NodeB (evolved NodeB, eNB) in a long term evolution (long term evolution, LTE) system, a radio network controller (radio network controller, RNC), a NodeB (NodeB, NB), a base station controller (base station controller, BSC), a home base station (for example, a home evolved NodeB, or a home NodeB, HNB), a baseband unit (baseband unit, BBU), a transmission reception point (transmission reception point, TRP), a transmission point (transmission point, TP), a base transceiver station (base transceiver station, BTS), a satellite, an uncrewed aerial vehicle, and the like. In a network structure, the network device may include a central unit (central unit, CU) node or a distributed unit (distributed unit, DU) node; or may be a RAN device including a CU node and a DU node, or a RAN device including a CU-control plane node, a CU-user plane node, and a DU node. Alternatively, the network device may be a radio controller, a relay station, a vehicle-mounted device, a wearable device, and the like in a cloud radio access network (cloud radio access network, CRAN) scenario. In addition, the base station may be a macro base station, a micro base station, a relay node, a donor node, or a combination thereof. The base station may alternatively be a communication module, a modem, or a chip that is disposed in the foregoing device or apparatus. The base station may alternatively be a mobile switching center, a device that bears a base station function in D2D, V2X, and M2M communication, a network side device in a 6G network, a device that bears a base station function in a future communication system, or the like. The base station may support networks of a same access technology or different access technologies. This is not limited.

It should be noted that an apparatus configured to implement a function of the terminal or the network device in this application may be a terminal or a network device, or may be an apparatus, for example, a chip system or a chip, that can support the terminal or the network device in implementing the function. The apparatus may be mounted in the terminal or the network device. In embodiments of this application, the chip system may include a chip, or may include a chip and another discrete device.

It should be further noted that in some embodiments of this specification, a 5G system is used as an example to describe specific solution details. It may be understood that when the solution is applied to another communication system, for example, an LTE system or a future communication system, messages, channels, information, or the like in the solution may be replaced with messages, channels, information, or the like that can implement corresponding functions in the another communication system. This is not limited in this application.

For ease of understanding the solutions in this application, terms in this application are first described.

1. LDPC code

The LDPC code is a linear block code, and a check matrix of the LDPC code is a sparse matrix. In the check matrix of the LDPC code, a quantity of zero elements is far greater than a quantity of non-zero elements. Alternatively, a row weight and a column weight of the check matrix are much less than a code length of the LDPC code. An LDPC code whose information bit sequence length is equal to k and whose code length is equal to n may be uniquely determined based on a check matrix of the LDPC code.

In 1981, Tanner (Tanner) represented LDPC coding bits in a graph. This graph now is referred to as a Tanner graph, and the Tanner graph and a check matrix are in one-to-one correspondence. The Tanner graph includes two types of vertices. One type of vertex indicates coding bits and is referred to as a variable node. The other type of vertex is a check node and indicates a check constraint relationship. Each check node indicates one check constraint relationship. The following provides descriptions with reference to FIG. 2 and FIG. 3.

FIG. 2 is a diagram of a check matrix H of LDPC.

In FIG. 3, $\{V_i\}$ indicates a variable node set, and $\{C_i\}$ indicates a check node set. In the check matrix H, each row indicates one check equation, each check equation corresponds to one check node, each column indicates one coding bit, and each coding bit corresponds to one variable node. In FIG. 1, there are eight variable nodes and four check nodes. If a coding bit is included in a corresponding check equation, a variable node and a check node that are used are connected by using a connection line, to obtain a Tanner graph.

FIG. 3 is a Tanner graph of a check matrix H of LDPC.

As shown in FIG. 3, the Tanner graph indicates the check matrix of the LDPC. For example, for the check matrix H with a size of m rows and n columns, the Tanner graph includes two types of nodes: n variable nodes and m check nodes. The n variable nodes respectively correspond to the n columns of the check matrix H, and the m check nodes respectively correspond to the m rows of the check matrix H. A cycle in the Tanner graph consists of connected vertices. In the cycle, one of the vertices is used as both a start point and an end point, and the cycle passes through each node only once. A length of the cycle is defined as a quantity of connection lines included in the cycle. A girth of a graph may also be referred to as a size of the graph, and is defined as a shortest cycle length in the graph. In FIG. 3, a girth is 6, as shown by a bold connection line in FIG. 3. The variable nodes in the Tanner graph each correspond to one column of the check matrix H, that is, correspond to each LDPC coding bit. The check nodes in the Tanner graph each correspond to one row of the check matrix H, that is, correspond to LDPC parity bits. A connection between the two types of nodes corresponds to a value of an element in the matrix H. If there is a connection between an $i^{th}$ check node and a $j^{th}$ variable node, it indicates that a value of an element (i, j) in the matrix H is 1. If there is no connection between an $i^{th}$ check node and a $j^{th}$ variable node, a corresponding element is 0. A connection line between a variable node and a check node may also be referred to as an edge.

In addition, in the Tanner graph, a cycle (cycle) is a closed loop formed by a variable node, a check node, and an edge that are connected end to end.

As described above, the LDPC code is a linear block code. In the linear block code, a to-be-encoded information sequence is divided into groups each including k bits, and an encoder performs a linear operation on the k information bits to obtain m parity bits. Then, the k information bits are merged with the m parity bits to obtain a code group whose length is n=k+m. A mapping relationship between the information bits of k bits and the code group whose length is n bits is usually represented by a corresponding check matrix H. An encoding sequence may be correspondingly generated based on the check matrix H to complete an encoding process. After the encoding sequence is transmitted through a channel, a receiving end correspondingly decodes a received signal, to determine an original information bit.

2. QC-LDPC

A quasi-cyclic low density parity check (quasi-cyclic low density parity check, QC-LDPC) code is a type of structured LDPC code. Due to a unique structure of a check matrix of the QC-LDPC code, a simple feedback shift register may be used during encoding, to reduce LDPC encoding complexity. When a code length is long, a check matrix H of LDPC is very large. Therefore, the check matrix H is usually represented by blocks: The complete check matrix H is considered to be generated by a plurality of $Z_c \times Z_c$ submatrices. Specifically, the complete check matrix H may be represented by one base graph $H_b$, each element in $H_b$ corresponds to one $Z_c \times Z_c$ submatrix, and each submatrix may be represented by a quantity of cyclic shift bits. Therefore, storage space required by the complete check matrix H is greatly reduced. An element in the base graph $H_b$ may also be referred to as a quasi-cyclic (quasi-cyclic, QC) block.

Based on the base graph $H_b$ and the lifting factor $Z_c$, the base graph $H_b$ may be extended into a complete check matrix for encoding or decoding. $Z_c$ (lifting size) may also be referred to as a lifting factor, a lifting value, an extension value, an extension coefficient, a lifting size, or the like. In this application, the lifting value is used for description.

For example, a base graph $H_b$ of QC-LDPC is shown as follows:

$$
\begin{bmatrix}
13 & 48 & 80 & 66 & 4 & 74 & 7 & 30 & 76 & 52 & 37 & 60 & -1 & 49 & -1 & 73 & 31 & 74 & 73 & 23 & 1 & 0 & -1 & -1 \\
69 & 63 & 74 & 56 & 64 & 77 & 57 & 65 & 6 & 16 & 51 & -1 & 64 & -1 & 64 & 68 & 9 & 48 & 62 & 54 & -1 & 0 & 0 & -1 \\
51 & 15 & 0 & 80 & 24 & 25 & 42 & 54 & 44 & 71 & 71 & 9 & 67 & 35 & 67 & -1 & 58 & -1 & 29 & -1 & 0 & -1 & 0 & 0 \\
16 & 29 & 36 & 41 & 44 & 56 & 59 & 37 & 50 & 24 & -1 & 65 & 4 & 65 & 4 & 52 & -1 & 4 & -1 & 73 & 1 & -1 & -1 & 0
\end{bmatrix}
$$

It can be learned that a size of the base graph $H_b$ is 4 rows and 24 columns, each element in the base graph $H_b$ represents a square matrix whose $Z_c$=code length/24 order, an element $P_{Z_c}^i$ represents a circular permutation matrix, and i represents a cyclic shift value, where $0 \le i \le Z_c - 1$, and i is an integer. In addition, in the base graph $H_b$, "-1" represents an all-zero matrix, and "0" represents an identity matrix.

For example, $P_{Z_c}^1$ is as follows:

$$
P_{Z_c}^1 =
\begin{bmatrix}
0 & 1 & 0 & \ldots & 0 \\
0 & 0 & 1 & \ldots & 0 \\
\vdots & \vdots & \vdots & \ddots & \vdots \\
0 & 0 & 0 & \ldots & 1 \\
1 & 0 & 0 & \ldots & 0
\end{bmatrix}
$$

It should be noted that, in addition to "-1", a zero element in the base graph $H_b$ may alternatively be expressed in another form. For example, "-" or a null value represents the all-zero matrix.

3. Basic structure of a base graph

5th generation (5th generation, 5G) NR LDPC is used as an example. A "Raptor-like (Raptor-like)" structure is used for the 5G NR LDPC, and a parity check matrix of the LDPC may be gradually extended to a low code rate by using a high-code-rate kernel matrix (Kernel Matrix). In this way, encoding at various code rates can be flexibly supported.

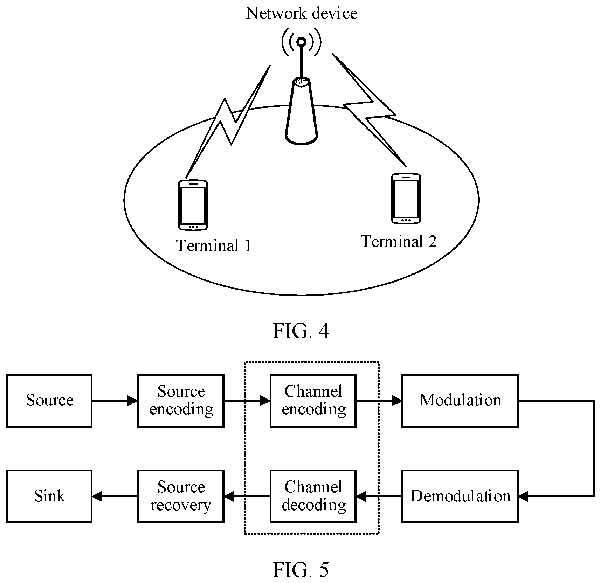

FIG. 4 is a diagram of a structure of a parity check matrix of 5G NR LDPC. As shown in FIG. 4, the parity check matrix of the 5G NR LDPC includes five parts: A, B, C, D, and E. A and B jointly form a high-code-rate kernel matrix, A corresponds to information bits (or referred to as information bits), and B is a square matrix and corresponds to high-code-rate parity bits (or referred to as parity bits). C is an all-zero matrix. E is an identity matrix and corresponds to a parity bit with a low extended code rate. D and E jointly form a single parity check relationship.

4. IR-HARQ

In an incremental redundancy-hybrid automatic repeat request (incremental redundancy-hybrid automatic repeat request, IR-HARQ) mechanism, a transmitting end sends information bits and some redundant bits during initial transmission, and sends additional redundant bits during retransmission. If decoding fails during the initial transmission, the transmitting end retransmits more redundant bits to decrease a code rate of a channel, to increase a decoding success rate. If the receiving end still cannot correctly perform decoding based on redundant bits in a first time of retransmission, the transmitting end performs retransmission again. As a quantity of retransmission times increases, redundant bits are continuously increased, and a channel encoding rate is continuously decreased, to achieve a better decoding effect.

The IR HARQ mechanism requires an LDPC encoding scheme compatible with a plurality of rates, so that a new incremental redundant bit can be introduced during retransmission.

4. 5G NR LDPC code

A check matrix of the 5G NR LDPC code includes the following main features:

(1) Large column weight and puncturing design
The feature means that the check matrix of the 5G NR LDPC code has variable nodes with very large degrees. After encoding is completed, a transmitting end may puncture columns corresponding to the variable nodes. In other words, the transmitting end does not send the encoded columns corresponding to the variable nodes, and a receiving end device sets log likelihood ratios (log likelihood ratios, LLRs) corresponding to the punctured columns to 0 for decoding.
(2) Raptor-like extended node structure design
The feature means that an extended node of a check matrix of the 5G NR LDPC code has a single diagonal structure, to be specific, a degree of the extended node is 1, and the extended node appears only in one check equation.
(3) QC block structure
The feature means that an actually used LDPC code is obtained by extending a non-negative element in the base graph $H_b$ by a lifting value $Z_c$ to a cyclic shift matrix.
(4) Dense core region (core region)

The check matrix of the 5G NR LDPC code has dense connections in a $1^{st}$ row to a $4^{th}$ row and a $1^{st}$ column to a $26^{th}$ column (relative to other locations). This part is referred to as a kernel matrix (Kernel Matrix). The kernel matrix has high edge density, and a degree of a parity bit is not 1. Each parity bit of a non-kernel matrix is a Raptor-like node, and has a degree of 1.

The 5G NR LDPC code supports IR-HARQ. However, a high-code-rate part (namely, the kernel matrix) of the 5G NR LDPC code supports only parallel decoding of QC blocks, and cannot support parallel decoding of an entire row. A low code rate part supports parallel decoding of an entire row. As a result, quantities of calculation units of the high-code-rate part and the low code rate part may not be similar. For example, to support the parallel decoding of the QC blocks in the high-code-rate part, a large quantity of calculation units are set for each row, and only some of these calculation units may be used for decoding of the low code rate part. Consequently, a large area of calculation units is wasted. In addition, a peak throughput of the 5G NR LDPC code cannot reach 100 Gbps, and a decoding latency is long.

5. 802.11ay LDPC code

A check matrix of the 802.11ay LDPC code includes the following main features:

(1) A check matrix is stored for each code rate, and there are only several specific code rates and code lengths. Flexible code rates and code lengths are not supported, a nesting feature is not supported, and IR-HARQ is not supported.
(2) A low-code-rate check matrix is multi-row orthogonal, and row parallel decoding may be performed.
(3) A QC block structure is the same as that of the 5G NR LDPC code.
(4) A high-code-rate check matrix has high edge density, and the low-code-rate check matrix has low edge density. Overall edge density is high from the perspective of all check matrices.

The 802.11ay LDPC code has a large limitation on a code rate, matrix storage is redundant, flexibility is poor, different code rates do not have a nesting property, and IR-HARQ is not supported.

6. Non-zero element and zero element

In this application, a zero element in a check matrix indicates that there is no connection between a variable node and a check node. A non-zero element in a check matrix indicates that a connection exists between a variable node and a check node.

Specific representation forms of the zero element and the non-zero element are not limited in this application. For example, in a base graph $H_b$, "-1" may represent a zero element, and a "non-negative value" may represent a non-zero element. For another example, in a check matrix H, "0" may represent a zero element, and "1" may represent a non-zero element.

7. Column weight and row weight

For a column of a matrix, the column weight may be a quantity of "1"s included in the column. For a row of the matrix, the row weight may be a quantity of "1"s included in the row. The column weight may also be referred to as a column degree. For a check matrix, the column weight may also be referred to as a degree of a variable node.

8. Extended column, non-extended column, extended row, and non-extended row

For an LDPC code, each time one extended node is added, one row and one column are added. In this application, the added row and column are referred to as an extended column and an extended row. The extended column is a column corresponding to the extended node. In other words, the extended column corresponds to an extended parity bit. A column other than the extended column is a non-extended column. A row other than an extended row is a non-extended row. FIG. 4 is used as an example. Columns in C and E are extended columns, and rows in D and E are extended rows.

9. Information transmission procedure

FIG. 5 is a diagram of an information transmission procedure. As shown in FIG. 5, information is sent by a source, and after processing such as source encoding, channel encoding, modulation, air interface transmission, demodulation, channel decoding, and source recovery, the information reaches a sink, so that transmission of the information from the source to the sink is completed. In FIG. 5, processing (including source encoding, channel encoding, modulation, and the like) shown at an upper layer is performed at a transmitting end, and processing (including demodulation, channel decoding, source recovery, and the like) shown at a lower layer is performed at the transmitting end.

Embodiments of this application mainly relate to source encoding, channel encoding, channel decoding, and source recovery shown in FIG. 5.

It can be learned from the foregoing content that a high-code-rate part (namely, a kernel matrix) of a 5G NR LDPC code supports parallel decoding of only quasi-cyclic QC blocks, and cannot support parallel decoding of an entire row. This limits decoding efficiency. For each code rate of an 802.11ay LDPC code, a check matrix is stored, and a flexible code rate is not supported. Therefore, the 802.11ay LDPC code does not support an IR-HARQ mechanism.

For the foregoing problem, this application provides an LDPC code-based communication method. An LDPC base graph may be obtained based on a storage matrix and indication information that indicates a correspondence between rows of the storage matrix or a correspondence between rows of the expected LDPC base graph. In addition, in a process of obtaining the LDPC base graph, a total quantity of edges that correspond to non-extended columns and that are in a Tanner graph may not be changed. A quantity of edges in the Tanner graph is one of key factors that affect calculation complexity of an LDPC code. Therefore, the method provided in this application helps maintain calculation complexity of an LDPC code, and in particular, helps reduce calculation complexity of an LDPC code in a scenario in which a high code rate is extended to a low code rate, to improve decoding efficiency.

An LDPC code-based communication method provided in this application is described below.

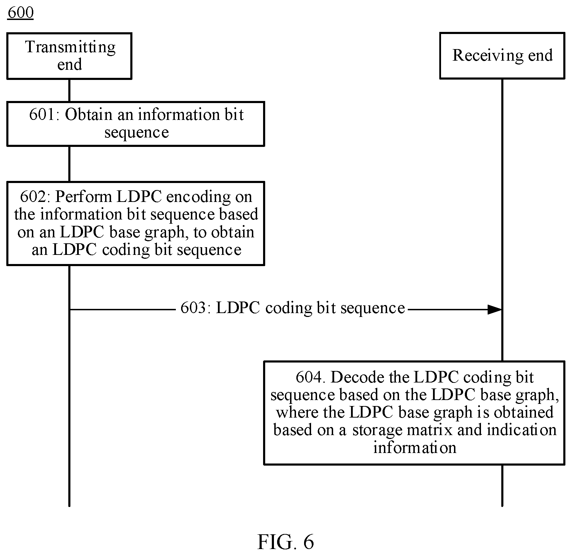

FIG. 6 is a schematic flowchart of an LDPC code-based communication method 600 according to this application.

The method 600 may be performed by a transmitting end and a receiving end, or may be performed by modules or units in the transmitting end and the receiving end, which are collectively referred to as the transmitting end and the receiving end below for ease of description. The method 600 may include at least a part of the following content.

Step 601: The transmitting end obtains an information bit sequence.

To be specific, if the transmitting end needs to communicate with the receiving end, in other words, the transmitting end needs to send a signal to the receiving end, the transmitting end needs to first obtain an information bit sequence corresponding to the signal that needs to be sent to the receiving end.

Optionally, that the transmitting end obtains the to-be-sent information sequence may mean that the transmitting end performs source encoding on a source symbol to generate the information bit sequence. That the transmitting end obtains the to-be-sent information sequence may alternatively mean that the transmitting end receives the information bit sequence from another communication apparatus.

Step 602: The transmitting end performs LDPC encoding on the information bit sequence based on an LDPC base graph, to obtain an LDPC coding bit sequence.

Step 603: The transmitting end sends the LDPC coding bit sequence to the receiving end, in other words, the receiving end receives the LDPC coding bit sequence from the transmitting end.

Step 604: The receiving end decodes the LDPC coding bit sequence based on the LDPC base graph.

The LDPC base graph may be obtained based on a storage matrix and indication information. The indication information indicates a correspondence between rows of the storage matrix or a correspondence between rows of the LDPC base graph. A specific correspondence is described with reference to the following manner 1 to manner 4.

A specific form of the indication information is not limited in this application. In a possible implementation, a form used for the indication information may include at least one of an indication sequence, a mapping table, or a mapping pair.

The following describes the form used for the indication information with reference to examples.

For example, the indication information indicates the correspondence between the rows of the LDPC base graph. It is assumed that the LDPC base graph includes eight rows, rows with row numbers 0 to 7 respectively correspond to a 1st row to an 8th row, where the 3rd row to the 8th row are extended rows, a correspondence exists between the 3rd row and the 1st row, a correspondence exists between the 4th row and the 2nd row, a correspondence exists between the 5th row and the 2nd row, a correspondence exists between the 6th row and the 1st row, a correspondence exists between the 7th row and the 3rd row, and a correspondence exists between the 8th row and the 4th row.

(1) When the indication information is in the form of the sequence, for example, the indication sequence may be {0, 1, 1, 0, 2, 3}.

(2) When the indication information is in the form of the mapping table, for example, the mapping table may be shown in Table 1 or Table 2.

Table 1

| Row number ⟍ Row number | 0 | 1 | 2 | 3 | 4 | 5 | 6 | 7 |
|---|---|---|---|---|---|---|---|---|
| 0 | 0 | 0 | 0 | 0 | 0 | 0 | 0 | 0 |
| 1 | 0 | 0 | 0 | 0 | 0 | 0 | 0 | 0 |
| 2 | 1 | 0 | 0 | 0 | 0 | 0 | 0 | 0 |
| 3 | 0 | 1 | 0 | 0 | 0 | 0 | 0 | 0 |
| 4 | 1 | 1 | 0 | 0 | 0 | 0 | 0 | 0 |
| 5 | 1 | 0 | 0 | 0 | 0 | 0 | 0 | 0 |
| 6 | 0 | 1 | 1 | 0 | 0 | 0 | 0 | 0 |
| 7 | 0 | 0 | 0 | 1 | 0 | 0 | 0 | 0 |

Table 2

| Row number / Row number | 0 | 1 | 2 | 3 | 4 | 5 | 6 | 7 |
|---|---|---|---|---|---|---|---|---|
| 0 | 0 | 0 | 0 | 0 | 0 | 0 | 0 | 0 |
| 1 | 0 | 0 | 0 | 0 | 0 | 0 | 0 | 0 |
| 2 | 1 | 0 | 0 | 0 | 0 | 0 | 0 | 0 |
| 3 | 0 | 1 | 0 | 0 | 0 | 0 | 0 | 0 |
| 4 | 1 | 1 | 0 | 0 | 0 | 0 | 0 | 0 |
| 5 | 1 | 0 | 0 | 0 | 0 | 0 | 0 | 0 |
| 6 | 1 | 0 | 1 | 0 | 0 | 0 | 0 | 0 |
| 7 | 0 | 1 | 0 | 1 | 0 | 0 | 0 | 0 |

(3) When the indication information is in the form of the mapping pair, for example, the mapping pair may include (2, 0), (3, 1), (4, 1), (5, 0), (6, 2), and (7, 3).

In this application, the row number may also be referred to as a row index (row index).

For ease of description, the technical solutions of this application are described below by using an indication sequence as an example. The indication sequence may be replaced with an equivalent form such as a mapping table or a mapping pair.

The LDPC base graph herein may be a matrix actually used by the transmitting end or the receiving end, and the storage matrix may be a matrix stored in the transmitting end or the receiving end or a matrix predefined in a protocol.

Optionally, a code rate corresponding to the LDPC base graph may be the same as or different from a code rate corresponding to the storage matrix, depending on whether a target code rate is the same as the code rate corresponding to the storage matrix. For example, if a current target code rate is the same as the code rate corresponding to the storage matrix, the transmitting end or the receiving end may directly use the storage matrix to perform encoding or decoding. In this case, the transmitting end or the receiving end may not split or merge rows of the storage matrix based on the indication sequence. For another example, if a current target code rate is different from the code rate corresponding to the storage matrix, the transmitting end or the receiving end may split or merge the storage matrix based on the indication sequence to obtain an LDPC base graph corresponding to the target code rate.

It should be noted that LDPC base graphs used by the transmitting end and the receiving end may be the same or may be different. For example, when the storage matrix can be used for encoding, the transmitting end may encode the information bit sequence by using the storage matrix, in other words, the LDPC base graph used by the transmitting end is the storage matrix. After receiving the LDPC coding bit sequence, the receiving end may split or merge the storage matrix based on the indication sequence, to obtain the LDPC base graph used by the transmitting end.

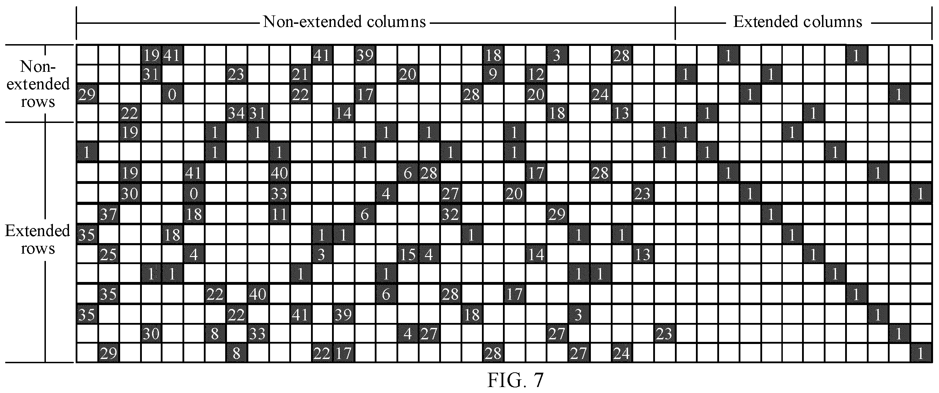

FIG. 7 is an example of an LDPC base graph.

In this application, the LDPC base graph has at least some of the following features:

Feature 1: A sum of column weights of non-extended columns of the LDPC base graph is equal to a sum of column weights of non-extended columns of a storage matrix.

In other words, in a process of obtaining the LDPC base graph based on the storage matrix and an indication sequence, a sum of column weights corresponding to other variable nodes than an extended node remains unchanged.

Feature 2: The LDPC base graph includes a first submatrix and a second submatrix, the first submatrix includes the non-extended columns of the LDPC base graph, the second submatrix includes extended columns of the LDPC base graph; a column weight of each of Q columns of the second submatrix is 2; and one of two non-zero elements included in a $q^{th}$ column in the Q columns corresponds to an $i_1{}^{th}$ row of the first submatrix, the other one of the two non-zero elements included in the $q^{th}$ column in the Q columns corresponds to an $i_2{}^{th}$ row of the first submatrix, the $i_1{}^{th}$ row and the $i_2{}^{th}$ row are orthogonal to each other, and the $q^{th}$ column is any one of the Q columns, where Q, q, $i_1$, and $i_2$ are all positive integers.

In other words, degrees of some or all extended nodes in the LDPC base graph are 2, and parts, other than extended parts, of two rows corresponding to each of the extended nodes are orthogonal to each other.

Feature 3: The LDPC base graph is an $X \times Y$ matrix, and a $(y_2+1)^{th}$ column to a $Y^{th}$ column of the LDPC base graph are extended columns; and the LDPC base graph includes a submatrix A1, a submatrix B1, a submatrix C1, a submatrix D1, and a submatrix E1, where the submatrix A1 and the submatrix B1 constitute a core part of the storage matrix. The submatrix A1 is a $1^{st}$ row to an $x_1^{th}$ row and a $1^{st}$ column to a $y_1^{th}$ column of the LDPC base graph, the submatrix B1 is the $1^{st}$ row to the $x_1^{th}$ row and a $(y_1+1)^{th}$ column to a $y_2^{th}$ column of the LDPC base graph, the submatrix C1 is the $1^{st}$ row to the $x_1^{th}$ row and the $(y_2+1)^{th}$ column to the $Y^{th}$ column of the LDPC base graph, the submatrix D1 is an $(x_1+1)^{th}$ row to an $X^{th}$ row and the $1^{st}$ column to the $y_2^{th}$ column of the LDPC base graph, and the submatrix E1 is the $(x_1+1)^{th}$ row to the $X^{th}$ row and the $(y_2+1)^{th}$ column to the $Y^{th}$ column of the LDPC base graph, where $1 \leq x_1 \leq X$; $1 \leq y_1 \leq y_2 \leq Y$; and $x_1$, $X$, $y_1$, $y_2$, and $Y$ are integers. Elements on a diagonal of the submatrix E1 are non-zero elements, a non-zero element is included above the diagonal of the submatrix E1, and/or a non-zero element is included below the diagonal of the submatrix E1, and the submatrix C1 includes a non-zero element.

The $1^{st}$ row to the $x_1^{th}$ row and the $1^{st}$ column to the $y_1^{th}$ column of the LDPC base graph herein may refer to all locations whose row numbers are greater than or equal to 1 and less than or equal to $x_1$ and whose column numbers are greater than or equal to 1 and less than or equal to $y_1$ in the LDPC base graph. The $1^{st}$ row to the $x_1^{th}$ row and the $(y_1+1)^{th}$ column to the $y_2^{th}$ column of the LDPC base graph, the $1^{st}$ row to the $x_1^{th}$ row and the $(y_2+1)^{th}$ column to the $Y^{th}$ column of the LDPC base graph, the $(x_1+1)^{th}$ row to the $X^{th}$ row and the $1^{st}$ column to the $y_2^{th}$ column of the LDPC base graph, and the $(x_1+1)^{th}$ row to the $X^{th}$ row and the $(y_2+1)^{th}$ column to the $Y^{th}$ column of the LDPC base graph are similar. Details are not described again. Similar content is not explained below again.

Because parts, other than an extended node, of two rows corresponding to a column whose column weight is 2 in the LDPC base graph are orthogonal to each other, the receiving end may perform row parallel decoding on the LDPC coding bit sequence based on the LDPC base graph. The following describes an LDPC decoding process.

In a possible implementation, that the receiving end performs channel decoding on the LDPC coding bit sequence based on the LDPC base graph includes: decoding, in a first decoding manner, a row that is in the LDPC coding bit sequence and that corresponds to the $i_1^{th}$ row and a row that is in the LDPC coding bit sequence and that corresponds to the $i_2^{th}$ row; and decoding, in a second decoding manner, a row that is in the LDPC coding bit sequence and that corresponds to an $i_1^{th}$ row of the second submatrix and a row that is in the LDPC coding bit sequence and that corresponds to an $i_2^{th}$ row of the second submatrix. The first decoding manner is row parallel decoding, and the second decoding manner is different from the first decoding manner.

In other words, for an $i_1^{th}$ row and an $i_2^{th}$ row of the LDPC base graph, the first decoding manner (namely, row parallel decoding) is used for a location other than an extended node in the two rows, and decoding in the second decoding manner is performed for a location corresponding to the extended node in the two rows.

There are many implementations of the second decoding manner. This is not limited in this application.

In a possible implementation, the $i_1^{th}$ row and the $i_2^{th}$ row of the LDPC base graph are used as an example. It is assumed that the $i_1^{th}$ row corresponds to a first check node, and the $i_2^{th}$ row corresponds to a second extended node. The following decoding operations may be performed on a first extended node (where a correspondence may be described in the feature 2) corresponding to the $i_1^{th}$ row and the $i_2^{th}$ row:

obtaining first information stored on the first extended node and second information stored on the first check node, where the first information is information sent by the first extended node to the first check node in a previous decoding iteration process, and the second information is information sent by the first check node to the first extended node in the previous decoding iteration process;
obtaining third information stored on a second check node, where the third information is information sent by the second check node to the first extended node in the previous decoding iteration process;
determining fourth information based on the first information, the second information, and the third information, and storing the fourth information on the second check node, where the fourth information is information sent by the second check node to the first extended node in a current decoding iteration process;
determining fifth information based on the fourth information and the first information, and storing the fifth information on the first extended node, where the fifth information is information sent by the first extended node to the first check node in the current decoding iteration process; and
determining sixth information based on the fourth information, and storing the sixth information on the first check node, where the sixth information is information sent by the first check node to the first extended node in the current decoding iteration process.

In the foregoing decoding process, in addition to being used to update storage of the second check node, the information sent by the second check node to the first extended node in the current decoding iteration process may be directly used, without being stored, to calculate the information sent by the first extended node to the first check node in the current decoding iteration process and the information sent by the first check node to the first extended node in the current decoding iteration process. In this way, pipeline decoding is performed, and times of reading and updating the first extended node, the first check node, and the second check node can be reduced.

In this application, there are many manners of obtaining the LDPC base graph based on the storage matrix and the indication sequence. This is not limited. For example, the following manner 1, manner 2, and manner 3 may be included.

**Manner 1:** The transmitting end stores a high-code-rate matrix (that is, the storage matrix is the high-code-rate matrix), an indication sequence, and a division table, and splits the high-code-rate matrix based on the indication sequence and the division table to generate a low-code-rate LDPC base graph.

In the manner 1, the indication sequence may also be referred to as a split (split) sequence or an extended interleaver, and is uniformly referred to as a split sequence below. The split sequence indicates a row to be split. For example, if an 8th element of the split sequence indicates a row number 3, it indicates that an 8th row of the LDPC base graph is used to perform elimination on a row whose row number is 3 in the LDPC base graph. The 8th row of the LDPC base graph is obtained based on the division table. In other words, the row whose row number is 3 in the LDPC base graph is split into the 8th row of the LDPC base graph and a row whose row number is 3 in an eliminated LDPC base graph (assuming that the row number is unchanged). In other words, the indication information indicates a split relationship between the rows of the LDPC base graph.

For ease of understanding, splitting in this application is first described.

It is assumed that a check equation in the high-code-rate matrix is $c_1$: $x_1 + x_2 + x_3 + x_4 = 0$, and a check equation newly added during low-code-rate extension or IR-HARQ is $c_2$: $x_1 + x_3 + x_5 = 0$, where $x_5$ is an extended node (or a newly added variable node). $c_2$: $x_1 + x_3 + x_5 = 0$ is used to perform elimination on $c_1$: $x_1 + x_2 + x_3 + x_4 = 0$ to perform low-code-rate extension. $2x_1 + x_2 + 2x_3 + x_4 + x_5 = 0$ obtained by performing elimination is equivalent to $c'_1$: $x_2 + x_4 + x_5 = 0$. Therefore, $c_1$ may be replaced with $c'_1$: $x_2 + x_4 + x_5 = 0$. $c'_1$ is obtained by performing elimination on $c_1$ by using $c_2$ may be understood as that $c_1$ is split into $c'_1$ and $c_2$.

It can be learned that, other than the extended node $x_5$, variable nodes included in $c'_1$ and $c_2$ are completely orthogonal to each other, and a design of a row parallel decoding scheme is supported.

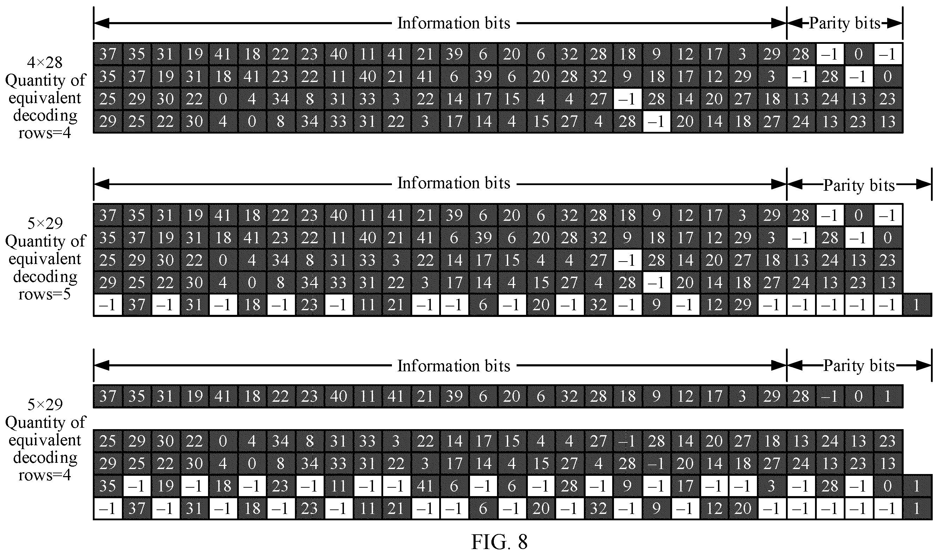

FIG. 8 is a diagram of one time of splitting of a high-code-rate matrix. In FIG. 8, the high-code-rate matrix is a $4\times28$ kernel matrix, and an example in which a 2nd row of the high-code-rate matrix is split is used as an example. As shown in FIG. 8, to ensure performance and a convergence speed, the $4\times28$ kernel matrix has high edge density, almost all elements in the matrix are non-zero elements, and a quantity of equivalent decoding rows is 4. Low-code-rate extension is performed, and one row and one column, namely, a 5th row and a 29th column, are added to the $4\times28$ kernel matrix, to obtain a $5\times29$ decoding matrix. A last element in the newly added row is a non-zero element (for example, 1 in FIG. 8), and a row weight is approximately equal to $0.5\times$ a quantity of columns of the kernel matrix, that is, approximately equal to 14. In this case, a quantity of equivalent decoding rows is 5. Then, the 5th row is used to perform elimination on a 2nd row to obtain a $5\times29$ equivalent decoding matrix. The original 2nd row is split into a 4th row and a 5th row of the equivalent decoding matrix shown in FIG. 8. In the 4th row and the 5th row of the equivalent decoding matrix, parts other than newly added parity bits are orthogonal to each other. Therefore, a quantity of equivalent decoding rows is 4.

In addition, the newly added 5th row may be referred to as an elimination row or an elimination check node of the original 2nd row.

It should be noted that, in FIG. 8, row locations are transformed in the $5\times29$ equivalent decoding matrix, and row numbers may be correspondingly changed or may remain unchanged. Certainly, after splitting, row location transformation may not be performed for the equivalent decoding matrix. This is not limited in this application.

It can be learned from FIG. 8 that, when low-code-rate extension is performed in the foregoing splitting manner, in a process in which a code rate becomes lower, a quantity of edges in a Tanner graph is not increased, in other words, a total quantity of edges, except an extended node, of base graphs with all code rates is fixed. Calculation complexity of an LDPC code mainly depends on the quantity of edges and orthogonality in the Tanner graph. Therefore, obtaining a low-code-rate matrix in the foregoing splitting manner helps maintain the calculation complexity of the LDPC code.

FIG. 8 shows only one time of splitting of the high-code-rate matrix. Actually, splitting may need to be performed for a plurality of times from the high-code-rate matrix to a low-code-rate matrix with a target code rate, in other words, a splitting process of low-code-rate extension is progressively completed.

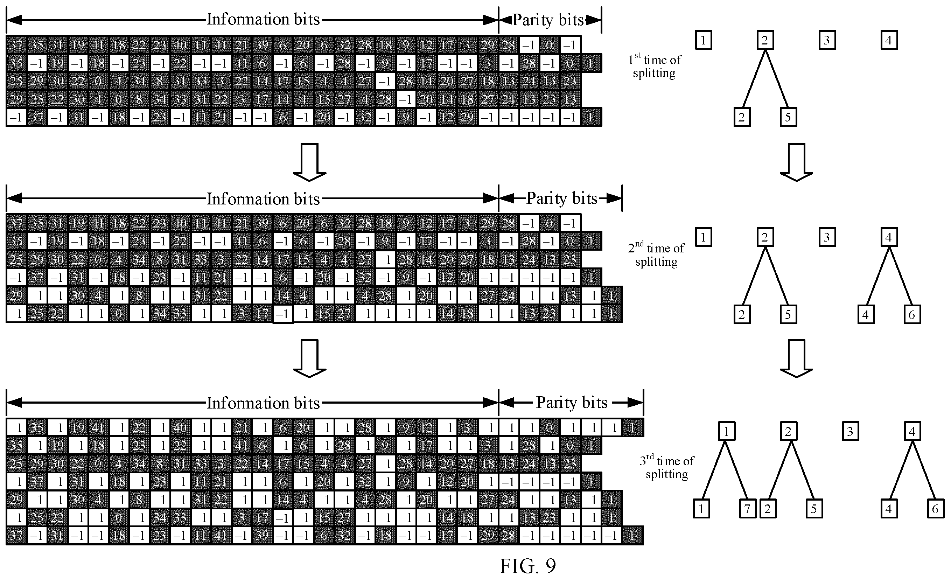

FIG. 9 is a diagram of a progressive splitting manner. FIG. 9 shows a 1st time of splitting to a 3rd time of splitting in a splitting process of low-code-rate extension. After the 1st time of splitting, a 2nd row of a $4\times28$ high-code-rate matrix is split into a 2nd row and a 5th row, to obtain a $5\times29$ equivalent decoding matrix. After the 2nd time of splitting, a 4th row of the high-code-rate matrix is split into a 4th row and a 6th row, to obtain a $6\times30$ equivalent decoding matrix. After the 3rd time of splitting, a 1st row of the high-code-rate matrix is split into a 1st row and a 7th row, to obtain a $6\times30$ equivalent decoding matrix. A part that is not identified with a value and that is in the matrix in FIG. 9 may be understood as a zero element. For example, an element in a 1st row and a 29th column of the $5\times29$ equivalent decoding matrix is a zero element.

The splitting process of the low-code-rate extension may be completed layer by layer, and one complete round of splitting may be considered as a process in which each existing check node is split once. For example, it is assumed that a current matrix is an initial matrix of a $4\times28$ high-code-rate matrix, and each row needs to be split. In this case, one complete round of splitting means that each of a 1st row to a 4th row is split once. For another example, it is assumed that a current matrix is an $8 \times 32$ equivalent decoding matrix, and each row needs to be split. In this case, one complete round of splitting means that each of a 1st row to an 8th row is split once. After one complete round of splitting, a depth of a forest is increased by 1. A matrix obtained through an $i$th time of splitting in a $t$th round corresponds to a forest whose depth is $t+1$ and that has $i \times 2$ check nodes whose depths are $t+1$. With reference to FIG. 9, a 1st time of splitting, a 2nd time of splitting, and a 3rd time of splitting in a 1st round corresponds to forests whose depths are 2 and that respectively has two, four, and six check nodes whose depths are 2.

It should be noted that one round of splitting may be one complete round of splitting, or may be partial splitting in one complete round of splitting. For example, to achieve a target code rate, for a last round of splitting, only some check nodes may need to be split. For another example, if row weights of some check nodes in a high-code-rate matrix are not large, the check nodes may not be split.

Because the splitting process of the low-code-rate extension is performed layer by layer, a depth of a sub-tree corresponding to each root node may be consistent.

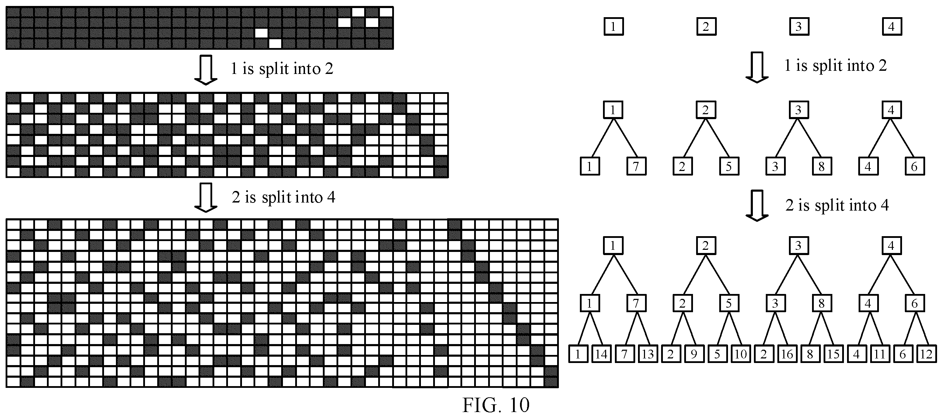

FIG. 10 is a diagram of two complete rounds of splitting of a high-code-rate matrix. In the matrix shown in FIG. 10, a zero element and a non-zero element are merely distinguished by using a shadowed block and a non-shadowed block, and shifting values of all elements are not marked. Two rounds of splitting are schematically shown, where a shadowed block represents a non-zero element, and a non-shadowed block represents a zero element. A splitting order in a 1st round of splitting is a 2nd row, a 4th row, a 1st row, and a 3rd row. A splitting order in a 2nd round of splitting is a 2nd row, a 5th row, a 4th row, a 6th row, a 7th row, a 1st row, an 8th row, and a 3rd row.

Optionally, in a splitting process, check node density (namely, row weights) may be kept as regular as possible. In this way, quantities of QC blocks for parallel decoding in all regions of an LDPC base graph are similar, corresponding hardware resources may be similar, latencies of row parallel decoding may be consistent, and a density requirement of density evolution is satisfied.

A specific splitting process is described below with reference to a split sequence and a division table.

It is assumed that in a high-code-rate matrix, a quantity of rows is M, a quantity of columns is N, a quantity of non-extended rows is $m_1$, and a quantity of non-extended columns is $n_2$. When the high-code-rate matrix includes neither an extended row nor an extended column, $M=m_1$ and $N=n_2$.

In this application, the split sequence indicates a row to be split, and the division table is used to construct a row added during each time of splitting.

(1) Split sequence

The split sequence may include a plurality of row numbers, and a sorting order of the row numbers in the split sequence is a splitting order]

In a possible implementation, the split sequence includes at least one segment, and each of the at least one segment corresponds to one round of splitting.

Optionally, a row number included in the at least one segment may be a random value.

Optionally, the row number included in the at least one segment is related to a row weight of each row of a storage matrix.

Optionally, row numbers included in a segment corresponding to a $t$th round of splitting in at least one round of splitting corresponding to the at least one segment are in a form of permutation of $\{1, ..., 2^{t-1}m_1\}$ or a form of permutation of a subset of $\{1, ..., 2^{t-1}m_1\}$, where $m_1$ is a quantity of non-extended rows of a high-code-rate matrix, and t is a positive integer. Because the row numbers included in the segment corresponding to the $t$th round of splitting are in the form of permutation of $\{1, ..., 2^{t-1}m_1\}$ or the form of permutation of the subset of $\{1, ..., 2^{t-1}m_1\}$, a plurality of times of splitting included in each round may be performed in parallel. This helps improve splitting efficiency.

Optionally, a $t$th segment of the split sequence corresponds to the $t$th round of splitting.

Optionally, a $(t+1)$th segment of the split sequence corresponds to the $t$th round of splitting, and a 1st segment corresponds to a 0th round of splitting or an initial matrix (namely, the storage matrix).

An example in which the $(t+1)$th segment of the split sequence corresponds to the $t$th round of splitting is used below for description.

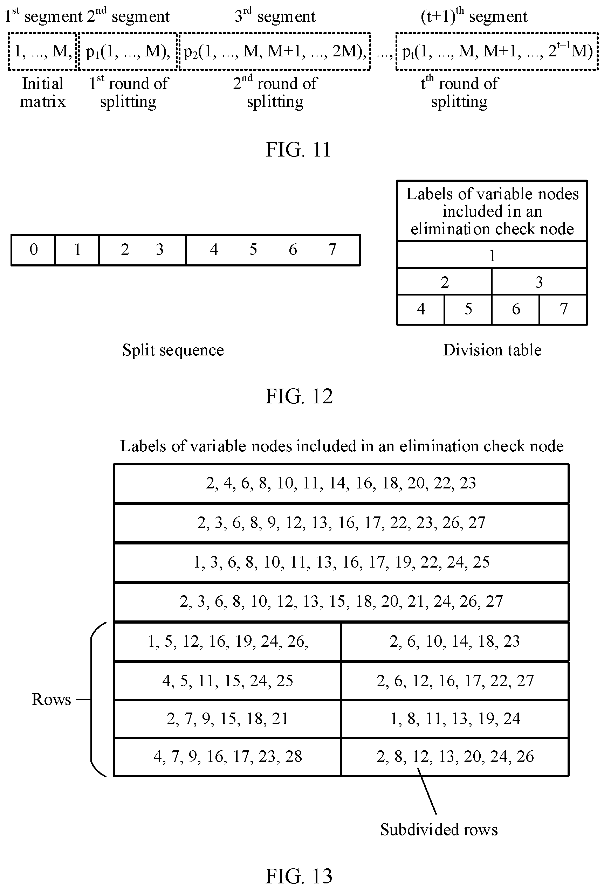

FIG. 11 is a diagram of a split sequence.

It is assumed that an initial matrix is $BG_0 = (H_0)_{M \times N}$, a matrix obtained through a $t$th round of splitting is $BG_t$, $BG_t$ is defined as a matrix generated after all rows of $BG_{t-1}$ are split, and $BG_t = G[C_t \cup V_t]$. If the initial matrix includes neither an extended row nor an extended column, $M=m_1$ and $N=n_2$.

In a phase of splitting, if a row $i$ is generated by splitting an initial row $j$ (in other words, $i$ is an elimination row of $j$), $j = f(i)$. If there is a node $i = i_0, i_1, i_2, ..., i_l = j$ that makes $i_k = f(i_{k-1})$, where $k = 1, ..., l$, be true, $i \sim j$. If a set $g_t(j) = \{i \in C_t | i \sim j\}$ is defined in $BGt$, $g_1(j) = j$, $g_{t+1}(j) = g_t(j) \cup \{i \in C_{t+1} | \exists p \in g_t(j), i = p + M(2^t - 1)\}$. A split sequence used by $BG_{t-1}$ to construct $BG_t$ is $[g_{t-1}(1), ..., g_{t-1}(M)]$, a split sequence 1 used by $BG_1$ to construct $BG_t$ is $[g_1(1) ... g_1(M)][g_2(1) ... g_2(M)] ... [g_{t-1}(1) ... g_{t-1}(M)]$, and a split sequence 2 used by $BG_1$ to construct $BG_t$ is $[h_1(1, ..., M)][h_2(1, ..., M)] ... [h_{t-1}(1, ..., M)]$, where $[h_t(1, ..., M)] = [g_t(1)\{1\}g_t(2)$

$\{1\} ... g_t(M)\{1\}, ..., g_t(1)\{2^{t-1}\}g_t(2)\{2^{t-1}\} ... g_t(M)\{2^{t-1}\}]$.

The split sequences 1 and 2 are basic split sequences, and an actual split sequence may be a form of permutation of the sequence 1 and the sequence 2.

A basic meaning of the split sequence is as follows:

(a) A length of the split sequence is a quantity of rows included in the split sequence, and is a total quantity of rows of a matrix generated by splitting.

(b) Segmentation of the split sequence: The split sequence is segmented based on a quantity of splitting rounds, where a $(t+1)^{th}$ segment corresponds to a $t^{th}$ round of splitting, in other words, a $t^{th}$ segment corresponds to a $(t-1)^{th}$ round of splitting, and a length of the segment corresponding to the $t^{th}$ round of splitting is $2^{t-1}M$.

(c) Meanings of digits in the split sequence: For locations of 1, ..., and M, a digit corresponds to a row number of an initial matrix, and a digit at a location after M corresponds to a row number of a currently split row.

(d) Order of the digits in the split sequence: An order of row numbers at locations after M in the split sequence corresponds to a splitting order.

(e) A quantity of specific digits in the split sequence: For a location after M, a quantity of times that a digit appears is a quantity of times that a row is split, and corresponds to a quantity of included extended nodes.

The split sequence is described below with reference to an example.

With reference to FIG. 10, the split sequence may be {1, 2, 3, 4, 2, 4, 1, 3, 2, 5, 4, 6, 7, 1, 8, 3}, including three segments {1, 2, 3, 4}, {2, 4, 1, 3} and {2, 5, 4, 6, 7, 1, 8, 3}, where {1, 2, 3, 4} corresponds to a $0^{th}$ round of split or an initial matrix, {2, 4, 1, 3} corresponds to a $1^{st}$ round of split, and {2, 5, 4, 6, 7, 1, 8, 3} corresponds to a $2^{nd}$ round of split.

The split sequence has the following features:

(a) In a process of a $t^{th}$ round of splitting, elements $2^{t-1}M + 1$ to $2^t M$ of a corresponding sequence may be a permutation $p_t(1, ..., 2^{t-1}M)$, in other words, labels (namely, row numbers) of all current check equations exist only once in a sequence segment corresponding to this round of splitting.

In this case, the permutation $p_t(1, ..., 2^{t-1}M)$ may be $p(1, ..., M) \times ... \times p(2^{t-2}M + 1, ..., 2^{t-1}M)$ or $p(\{i \in C_t | i \sim 1\}) \times ... \times p(\{i \in C_t | i \sim M\})$, where the identifier "$\times$" indicates splicing.

(b) A calculation formula of an element at an $i^{th}$ location of the split sequence is $\theta(i) = p_{t_1+1}(i - M2^{t_1+1} + M)$, where $t_1$ is a largest non-negative integer that satisfies $i \geq M(2^{t_1+1} - 1)$.

(2) Division table

The division table may also be referred to as a division sequence, and the division table corresponds to a split sequence. Other than a segment formed by initial M locations, each segment of the split sequence corresponds to a block or a row of the division table.

FIG. 12 is a diagram of a correspondence between a division table and a split sequence. It should be noted that a form of the division table in FIG. 12 is merely an example. As shown in FIG. 12, the split sequence includes four segments, a $1^{st}$ segment corresponds to an initial matrix, and a $2^{nd}$ segment to a $4^{th}$ segment respectively correspond a $1^{st}$ round of splitting to a $3^{rd}$ round of splitting. The division table includes three rows, and each row may be considered as a block. Locations of same digits in the split sequence and the division table correspond to each other. For example, a location of 1 in the split sequence corresponds to a location of 1 in the division table.

With reference to FIG. 12, basic meanings of the division table are as follows:

(a) Row of the division table: Rows of the division table correspond to a quantity of splitting rounds, and each row corresponds to one round of splitting.

(b) Column of the division table: A quantity of columns corresponding to a $t^{th}$ round of splitting is $2^{t-1}$, namely, a quantity of digits in each row.

(c) Digit in the division table: Each digit corresponds to $M$ rows and one column. To avoid confusion, M rows corresponding to each digit are referred to as subdivided rows, and each subdivided row corresponds to one time of splitting and corresponds to one extended row of an obtained LDPC base graph.

(d): $(t, i, j)$: A $j^{th}$ column of an $i^{th}$ subdivided row of a $t^{th}$ row of the division table is represented as $(t, i, j)$, a set stored at the location is a label (namely, a column number) of a variable node included or not included in $i + (j - 1)M$ elimination check equations, and an elimination parent node (namely, an eliminated check equation) corresponding to the $i^{th}$ subdivided row of the $t^{th}$ row is $p_t(i + (j - 1)M)$.

The division table is described below with reference to an example.

FIG. 13 is an example of a division table. As shown in FIG. 13, the division table includes two rows, where the two rows respectively correspond to two rounds of splitting, each row further includes four subdivided rows, and each of the four subdivided rows correspond to one time of splitting. Labels of variable nodes stored at a location (2, 3, 2) are 1, 8, 11, 13, 19, and 24. Assuming that the labels of the variable nodes are labels of variable nodes included in a check equation, an elimination check equation obtained at a 7$^{th}$ time of splitting in a 2$^{nd}$ round of splitting is $x_1 + x_8 + x_{11} + x_{13} + x_{19} + x_{24} + x_{39} = 0$.

Features of the division table:

(a) A label of a variable node included in an elimination check equation or a label of a remaining variable node after a parent node is eliminated is stored in (t, i, j) in the division table.

(b) A row weight in a process of a $t^{th}$ round of splitting is equal to or approximately equal to 1/2 of a row weight in a process of a $t$ - 1$^{th}$ round of splitting. In this way, each subdivided row of a $t^{th}$ row of the division table has an approximately same sum of total quantity of elements of all columns, and the table is arranged in a compact manner.

(c) A set of labels of variable nodes stored at the location (t, i, j) is properly included in a set of labels of variable nodes included in a parent node of the i$^{th}$ subdivided row of the t$^{th}$ row.

(d) In addition to the label of the variable node, some additional information may further be stored at the location (t, i, j). For example, a fixed difference from a shifting value (shifting value) of the parent node of the i$^{th}$ subdivided row of the t$^{th}$ row may further be stored at the location (t, i, j). Particularly, when a fixed difference of all the shifting values is 0, storage may be omitted. For another example, a label of its parent node may further be stored at the location (t, i, j), so that a split sequence may be omitted.

A splitting process based on a split sequence and a division table is described below with reference to a specific example.

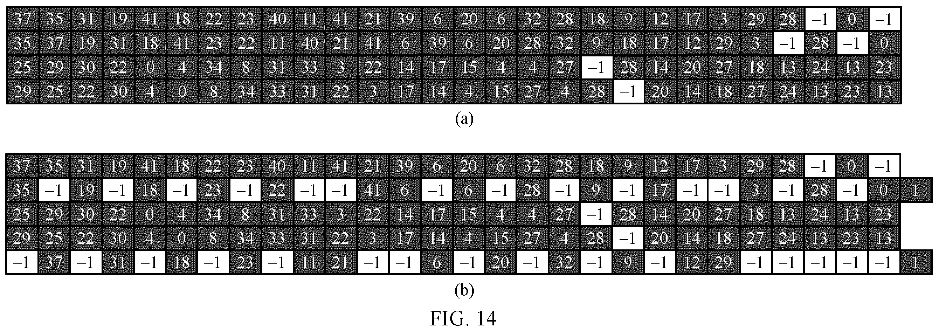

FIG. 14 is a diagram of one time of splitting.

It is assumed that for a stored high-code-rate matrix $H_0$, a quantity of columns is $N = 28$ and a quantity of rows is $M = 4$, that is, a code rate is 0.857. This is specifically shown in (a) in FIG. 14. It is assumed that the split sequence is

$$\theta = \begin{cases} 1234 \\ 2413 \\ 25467183 \end{cases}$$

, where a 1$^{st}$ row corresponds to the initial matrix $H_0$, a 2$^{nd}$ row corresponds to a 1$^{st}$ round of splitting, and a 3$^{rd}$ row corresponds to a 2$^{nd}$ round of splitting. It is assumed that the division table is the division table shown in FIG. 13. Rows with a column quantity of 1 form the 1$^{st}$ round of splitting, and rows with a column quantity of 2 form the 2$^{nd}$ round of splitting.

First $M = 4$ locations (the 1$^{st}$ row) of the split sequence correspond to the initial matrix $(H_0)_{4 \times 28}$. A 2$^{nd}$ row of the split sequence is a permutation of 1234 (all row numbers of the current matrix $(H_0)_{4 \times 28}$). In this way, each row number appears only once in one round of splitting. A first digit in the 2$^{nd}$ row is 2, and a label of an eliminated check equation corresponding to a 1$^{st}$ time of splitting in a 1$^{st}$ round is 2, and is denoted as $c_2$. Variable nodes included in an elimination check equation that is used to perform elimination on $c_2$ are determined based on a 1$^{st}$ subdivided row of a 1$^{st}$ row of the division table, namely, variable nodes corresponding to a label set of a 1$^{st}$ row split in a 1$^{st}$ round of splitting of the division table, that is, a check equation $c_5$ (including one extended node $x_{29}$) is as follows:

$$x_2 + x_4 + x_6 + x_8 + x_{10} + x_{11} + x_{14} + x_{16} + x_{18} + x_{20} + x_{22} + x_{23} + x_{29} = 0$$

An exclusive OR addition is performed on $c_5$ and $c_2$ to obtain a new check equation $c'_2 : x_1 + x_3 + x_5 + x_7 + x_9 + x_{12} + x_{13} + x_{15} + x_{17} + x_{19} + x_{21} + x_{24} + x_{25} + x_{26} + x_{27} + x_{28} + x_{29} = 0$, where $c_2$ is replaced with $c'_2$. For $c'_2$ and $c_5$, locations other than the extended node $x_{29}$ are completely orthogonal, and a split check equation matrix $(H_1)_{5 \times 29}$ is shown in (b) in FIG. 14.

A label of the newly added check equation $c_5$ is the same as a currently used location in the split sequence.

Subsequently, a 2$^{nd}$ element, a 3$^{rd}$ element, and a 4$^{th}$ element in the 2$^{nd}$ row of the split sequence are sequentially used to perform splitting to generate matrices $(H_2)_{6 \times 30}$, $(H_3)_{7 \times 31}$, and $(H_4)_{8 \times 32}$, to complete a process of the 1$^{st}$ round of splitting; and then a 3$^{rd}$ row of the split sequence is processed to perform a process of a 2$^{nd}$ round of splitting.

The split sequence and the division table are described above. A rate matching process based on a split sequence and a division table is described below.

In a possible implementation, it is assumed that for a high-code-rate matrix, a quantity of rows is M and a quantity of columns is N, and the high-code-rate matrix includes neither an extended row nor an extended column. The rate matching process based on the split sequence and the division table is mainly implemented by using the following steps.

Step 1: Determine, based on a target code rate and a target code length, a quantity X of rows and a quantity Y of columns of an LDPC base graph that needs to be constructed.

Step 2: Determine, based on the quantity Y of columns of the LDPC base graph, that splitting includes complete splitting rounds 1, ... , $t_0$ and first $i$ times of splitting in a $(t_0 + 1)^{th}$ round.

For example, a smallest $Z_c$ that satisfies $KZ_c \geq K_0$ is selected from a $Z_c$ list, where $K$ is a quantity of information columns of the LDPC base graph (namely, a quantity of information columns of a storage matrix), and $K_0$ is a quantity of information bits corresponding to the LDPC base graph (namely, a target quantity of information bits), and shortening (shorten) processing is performed on locations $KZ_c - K_0 + 1$ to $KZ_c$; a quantity R of splitting times is determined, where R is a smallest integer that satisfies $RZ_c \geq N_0 - K_0$; and next, $t_0$ is selected, where $t_0$ is a largest positive integer that satisfies $2^t M \leq R$. In this way, first $t_0$ complete rounds of splitting and $i=R-2^t M$ times of splitting in the $(t_0+1)^{th}$ round need to be performed.

Step 3: Read elements $2^{t-1}M + 1$ to $2^t M$ of the split sequence and the corresponding division table for a $t^{th}$ round of splitting, where $0 \leq t \leq t_0$, to complete a complete splitting process of the first $t_0$ rounds; and read elements $2^t M + 1$ to $i$ of the split sequence and the corresponding division table for the $(t_0 + 1)^{th}$ round of splitting, to complete an incomplete splitting process of the $(t_0 + 1)^{th}$ round.

For example, locations, corresponding to the first $t_0^{th}$ complete rounds of splitting, of the split sequence and the division table, and locations corresponding to first $R-2^t M$ times of splitting of the $(t_0 + 1)^{th}$ round of splitting are sequentially selected, and the high-code-rate matrix is split for R times based on the obtained split sequence and division table.

Because the split sequence has the permutation feature described above, a plurality of times of splitting in each round of splitting may be performed in parallel.

After the foregoing splitting process, the obtained LDPC base graph supports decoding with a row parallelism degree up to $2^{t0+1}$.

It should be noted that the conditions that $Z_c$, R, $t_0$, and the like need to satisfy are all examples, and may be replaced with other conditions that can be implemented.

It should be further noted that the R times of splitting may be divided into a plurality of rounds of splitting based on the foregoing descriptions, and a plurality of times of splitting in each round of splitting are performed in parallel. Certainly, the R times of splitting may alternatively be performed sequentially or serially. In this case, there is no segmentation concept for the split sequence, and there is no block concept for the division table. After the quantity R of splitting times is determined, first M+R row numbers of the split sequence and first R rows of the division table (the row herein refer to the foregoing subdivided row) may be obtained based on R, and then the R times of splitting are performed sequentially.

It should be noted that, for first R-1 times of splitting in the R times of splitting, a row before $Z_c$ lifting may be used as a granularity for splitting, in other words, a QC structure or $Z_c$ may be used as a granularity for splitting. For an $R^{th}$ time of splitting, namely, a last time of splitting, a row before $Z_c$ lifting may be used as a granularity for splitting, or a row (that is, 1) after $Z_c$ lifting may be used as the granularity for splitting. For example, when a part of parity bits corresponding to a last column of the LDPC base graph are punctured, the row after $Z_c$ lifting may be used as the granularity for the $R^{th}$ time of splitting. The $R^{th}$ time of splitting using the row after $Z_c$ lifting as a granularity is described below.

When fine-grained rate matching is performed, a basic splitting granularity may be changed from a row before $Z_c$ lifting to a row after $Z_c$ lifting, in other words, from $Z_c$ to 1, to implement fine-grained rate matching.

It is assumed that a size of an LDPC base graph is X rows and Y columns, and a used lifting value is $Z_c$.

If a part of parity bits corresponding to a last column of the LDPC base graph are not punctured, rate matching may be performed by using $Z_c$ as a basic unit. If a part of parity bits corresponding to the last column of the LDPC base graph need to be punctured during rate matching, splitting is performed at a granularity of 1 instead of $Z_c$ during construction of a last row of a check equation. For example, with reference to the foregoing descriptions, it is assumed that $RZ_c - N_0 + K_0$ may correspond to a punctured bit of an extended node with a largest label, and $(R-1)Z_c-N_0$ is split at the granularity of 1, where $N_0$ is a target code length.

For example, assuming that after the rate matching, a $1^{st}$ row to a $z^{th}$ row of a check equation $c$ with a largest label of the LDPC base graph need to be used, when $f(c)$ is split by using $c$, elimination is performed, at a fine granularity of 1, sequentially on a $1^{st}$ row to a $z^{th}$ row of $f(c)$ by using the $1^{st}$ row to the $z^{th}$ row of $c$, and elimination is not performed on a $(z + 1)^{th}$ row to a $Zc^{th}$ row of $f(c)$. Assuming that check equations of an eliminated check matrix are $c_1'$ and $f(c_1')$,

$$c'|_1^{Zc} = c|_1^{Zc}, \ f(c_1')|_{z+1}^{Zc} = f(c_1)|_{z+1}^{Zc}, \text{ and } \ f(c_1')|_1^z = f(c_1)|_1^z \oplus c|_1^z.$$

A check matrix is constructed through fine-grained splitting, a complete row orthogonality feature (other than an extended node) still exists in a use part of $c_1'$ and a $f(c_1')$ decoding process, and a parallelism degree remains unchanged.

The division table is described below with reference to an example.

It is assumed that $Z_c=3$, a parent node or an eliminated check equation is $c_1$, and an elimination check equation is $c_2$. It is assumed that only a $1^{st}$ check equation of $c_2$ is used for current rate matching, in other words, $2^{nd}$ and $3^{rd}$ locations of parity bits corresponding to $c_2$ are punctured. In this case, elimination is performed on a $1^{st}$ check equation of $c_1$ by using the $1^{st}$ check equation of $c_2$, and elimination is not performed on a $2^{nd}$ check equation and a $3^{rd}$ check equation of $c_1$.

The foregoing fine-grained splitting helps maintain edge density, to help improve encoding and decoding performance.

In addition, it should be noted that, if a row location is adjusted and/or a column location is adjusted in a process of obtaining the LDPC base graph in step 602 based on the manner 1, extended rows and/or extended columns satisfy: $X-x_1$ extended rows and/or $Y-y_2$ extended columns are sorted in a splitting order, and sorted extended rows and extended columns have the foregoing feature 3.

**Manner 2:** The transmitting end stores a lowest-code-rate matrix (that is, the storage matrix is the lowest-code-rate matrix) and an indication sequence, and splits the storage matrix based on the indication sequence to generate a check matrix for corresponding decoding, namely, the LDPC base graph in step 602.

Different from the manner 1, in the manner 2, a division table is not separately stored, but an elimination check equation required for splitting is stored in the storage matrix. In other words, in the manner 2, elimination is performed on a row with a large row weight in the storage matrix by using a row with a small row weight in the storage matrix.

In the manner 2, the indication sequence may be a split sequence.

For descriptions of splitting and the split sequence, refer to the manner 1. Details are not described herein again.

The storage matrix in the manner 2 is described below.

It is assumed that the storage matrix is an $M \times N$ matrix, a quantity of non-extended rows is $m_1$, and a quantity of non-extended columns is $n_2$.

The storage matrix includes a submatrix A2, a submatrix B2, a submatrix C2, a submatrix D2, and a submatrix E2, where the submatrix A2 is a $1^{st}$ row to an $m_1^{th}$ row and a $1^{st}$ column to an $n_1^{th}$ column of the storage matrix, the submatrix B2 is the $1^{st}$ row to the $m_1^{th}$ row and an $(n_1+1)^{th}$ column to an $n_2^{th}$ column of the storage matrix, the submatrix C2 is the $1^{st}$ row to the $m_1^{th}$ row and an $(n_2+1)^{th}$ column to an $N^{th}$ column of the storage matrix, the submatrix D2 is an $(m_1+1)^{th}$ row to an $M^{th}$ row and the $1^{st}$ column to the $n_2^{th}$ column of the storage matrix, and the submatrix E2 is the $(m_1+1)^{th}$ row to the $M^{th}$ row and the $(n_2+1)^{th}$ column to the $N^{th}$ column of the storage matrix, where $1 \leq m_1 \leq M$; $1 \leq n_1 \leq n_2 \leq N$; and $m_1$, M, $n_1$, $n_2$, and N are integers. The submatrix A2 and the submatrix B2 form a core part of the storage matrix.

The storage matrix has at least some of the following features:

(1) An $a_1^{th}$ row of the submatrix D2 is properly included in a $b_1^{th}$ row of a third submatrix and/or an $a_2^{th}$ row of the submatrix D2, the third submatrix includes the submatrix A2 and the submatrix B2, and the $a_1^{th}$ row is any row of the submatrix D2.

In other words, a variable node (other than an extended node) included in a row other than the core part of the storage matrix is properly included in a variable node included in a parent node of the row other than the core part of the storage matrix.

A correspondence between the $a_1^{th}$ row and the $b_1^{th}$ row and a correspondence between the $a_1^{th}$ row and the $a_2^{th}$ row may be determined based on the split sequence.

(2) A difference between a shifting value of each non-zero element in the $a_1^{th}$ row and a shifting value of a non-zero element at a corresponding location in the $b_1^{th}$ row remains the same, and/or a difference between a shifting value of each non-zero element in the $a_1^{th}$ row and a shifting value of a non-zero element at a corresponding location in the $b_1^{th}$ row remains the same.

In other words, a difference between a shifting value of the row other than the core part of the storage matrix and a shifting value of a location corresponding to the parent node of the row other than the core part of the storage matrix is a fixed constant. Optionally, the constant may be 0.

(3) A plurality of rows that are of the submatrix D2 and that correspond to a $b_2^{th}$ row of the third submatrix are different from each other, and the $b_2^{th}$ row is any row of the third submatrix.

"A plurality of rows that are of the submatrix D2 and that correspond to a $b_2^{th}$ row of the third submatrix" may be all child nodes of a parent node, namely, the $b_2^{th}$ row of the third submatrix.

For example, a $1^{st}$ row of the third submatrix is used as an example. In a $1^{st}$ round of splitting, the $1^{st}$ row is split into a $1^{st}$ row and a $7^{th}$ row (in other words, the $7^{th}$ row is used to perform elimination on the $1^{st}$ row). In a $2^{nd}$ round of splitting, the $1^{st}$ row is split into a $1^{st}$ row and a $14^{th}$ row (in other words, the $14^{th}$ row is used to perform elimination on the $1^{st}$ row), and the $7^{th}$ row is split into a $7^{th}$ row and a $13^{th}$ row (in other words, the $13^{th}$ row is used to perform elimination on the $7^{th}$ row). In this way, the $7^{th}$ row, the $13^{th}$ row, and the $14^{th}$ row all correspond to the $1^{st}$ row (a common parent node).

(4) A degree of the extended node of the storage matrix is 1.

(5) Rows of the storage matrix correspond one-to-one to elements in the split sequence, in other words, a quantity of rows of the storage matrix is equal to a length of the split sequence.

(6) The core part of the storage matrix, namely, A2 and B2, corresponds to a $1^{st}$ segment of the split sequence, and has no extended node.

(7) The storage matrix corresponds to rows split in a $1^{st}$ round, a $2^{nd}$ round, ..., and a $t^{th}$ round, where row weights are decreased. In each round, a row weight is decreased by 1/2 or approximately equal to 1/2 of a row weight in a previous round.

(8) The storage matrix may be directly used as an encoding matrix.

A Tanner graph corresponding to the storage matrix having the foregoing features contains multiple four and six circles, and is completely different from a Tanner graph corresponding to an existing check matrix.

In a possible implementation, a manner of storing a shifting value of each non-zero element of the storage matrix may be as follows: The storage matrix is used to store a connection relationship between a variable node and a check node, the shifting value of the non-zero element of the storage matrix is obtained based on a shifting value table, and the shifting value table is used to store shifting values of locations of non-extended rows of the storage matrix. In this case, an $i_3$th row number in at least one row number included in the split sequence indicates that a shifting value of an $i_3$th row of the LDPC base graph is determined based on a shifting value of a row identified by the $i_3$th row number in the at least one row number, and the row identified by the $i_3$th row number in the at least one row number is a row that needs to be split, where $i_3$ is a positive integer. For example, if an 8th element in the split sequence indicates a row number 3, it indicates that an 8th row of the LDPC base graph is used to perform elimination on a row whose row number is 3 in the LDPC base graph, and a shifting value of the 8th row is determined based on a shifting value of the row whose row number is 3 in the LDPC base graph.

In another possible implementation, a shifting value of each non-zero element of the storage matrix may be directly stored in the storage matrix.

The manner 2 is described below with reference to a specific example.

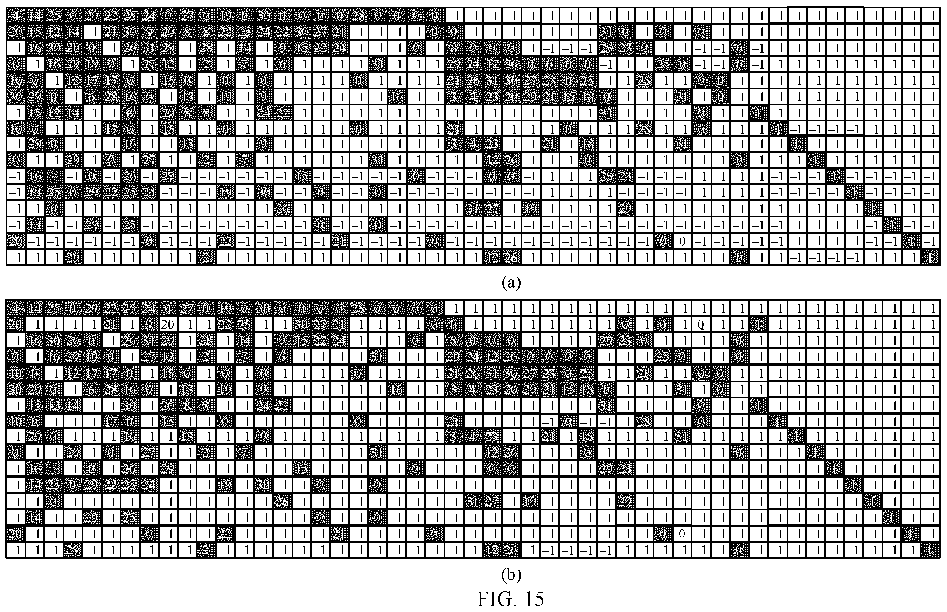

FIG. 15 is another diagram of one time of splitting.

It is assumed that for a stored low-code-rate matrix $H_0$, a quantity of columns is $N = 49$ and a quantity of rows is $M =$ 16. $H_0$ is shown in (a) in FIG. 15. It is assumed that for a split sequence $\theta = \begin{cases} 1,2,3,4,5,6 \\ 2,5,6,4,3,1 \\ 8,12,2,10 \end{cases}$, first six locations (namely, a 1st row) of the split sequence correspond to an initial matrix (namely, the low-code-rate matrix $H_0$), locations 7 to 12 (namely, a 2nd row) correspond to a 1st round of splitting, locations 13 to 16 (namely, a 3rd row) correspond to a 2nd round of splitting, and digits in the 2nd row and the 3rd row are a permutation of row numbers that are currently to be split. In this way, each row number appears only once in one round of splitting.

A 1st digit in the 2nd row of the split sequence is 2, and a corresponding check matrix generated through a 1st time of splitting in the 1st round needs to be generated by performing elimination on a 2nd check equation (namely, a 2nd row of the storage matrix) by using a 7th check equation (namely, a 7th row of the storage matrix).

First, seven rows and 40 columns of the storage matrix are intercepted, and the check equations $c_2$ and $c_7$ are shown as follows:

$c_2 : x_1 + x_2 + x_3 + x_4 + x_6 + x_7 + x_8 + x_9 + x_{10} + x_{11} + x_{12} + x_{13} + x_{14} + x_{15} + x_{16} + x_{17} + x_{18} + x_{23} + x_{24} + x_{32} + x_{33} + x_{35} + x_{37} = 0;$

and

$$c_7: x_2 + x_3 + x_4 + x_7 + x_9 + x_{10} + x_{11} + x_{14} + x_{15} + x_{32} + x_{37} + x_{40} = 0.$$

An exclusive OR addition is performed on $c_2$ and $c_7$ to obtain a new check equation $c'_2 : x_1 + x_6 + x_8 + x_{12} + x_{13} + x_{16} + x_{17} + x_{18} + x_{23} + x_{24} + x_{33} + x_{35} + x_{40} = 0$, where $c_2$ is replaced with $c'_2$, and it is noted that an extended node $x_{40}$ appears in $c'_2$. A split check equation matrix $(H_1)_{7 \times 40}$ is shown in (b) in FIG. 15.

A 2nd element, a 3rd element, a 4th element, a 5th element, and a 6th element in the 1st row of the split sequence are sequentially used to perform splitting to generate matrices $(H_2)_{8 \times 41} \dots (H_6)_{12 \times 45}$, to complete a process of the 1st complete round of merging; and then the 3rd row of the split sequence is processed to perform a process of the 2nd complete round of splitting.

In manner 2, a rate matching process based on the split sequence is similar to that in the manner 1. A difference is that in the manner 2, information used to construct an elimination check equation is not obtained from a division table, but a row of the storage matrix is used as the elimination check equation.

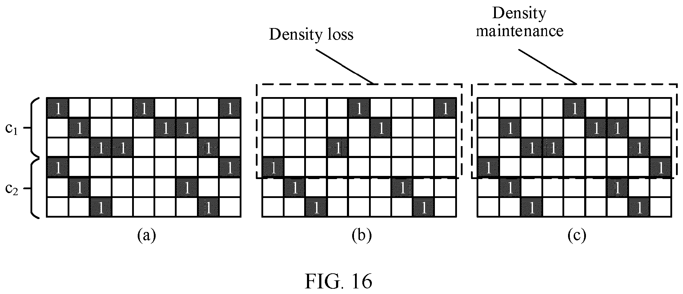

An $R$th time of splitting at a granularity of a row after $Z_c$ lifting is also similar to that in the manner 1, and is described below with reference to FIG. 16.

FIG. 16 is a diagram of fine-grained rate matching.

It is assumed that $Z_c = 3$, check equations included in a storage matrix are $c_1$ and $c_2$, $c_1$ is an eliminated check equation, and an elimination check equation is $c_2$, that is, $c_1$ is a parent node of $c_1$. It is assumed that only a 1st check equation of $c_2$ is used for current rate matching, in other words, 2nd and 3rd locations of parity bits corresponding to $c_2$ are punctured. In this case, elimination is performed on a 1st check equation of $c_1$ by using the 1st check equation of $c_2$, and elimination is not performed on a 2nd check equation and a 3rd check equation of $c_1$.

(a) in FIG. 16 shows $c_1$ and $c_2$ in the storage matrix, (b) in FIG. 16 is a diagram in which elimination is performed by using a row before $Z_c$ lifting as a granularity, and (c) in FIG. 16 is a diagram in which elimination is performed by using a row after $Z_c$ lifting as a granularity. It can be learned from (b) and (c) in FIG. 16 that, when a part of parity bits corresponding to a last column of an LDPC base graph need to be punctured, a loss occurs in edge density when splitting is performed at a granularity of $Z_c$; and when splitting is performed at a granularity of 1, maintenance of the edge density is facilitated, to help improve encoding and decoding performance.

In addition, it should be noted that, if a row location is adjusted and/or a column location is adjusted in a process of obtaining the LDPC base graph in step 602 based on the manner 2, extended rows and/or extended columns satisfy: $X\text{-}x_1$ extended rows and/or $Y\text{-}y_2$ extended columns are sorted in a splitting order, and sorted extended rows and extended columns have the foregoing feature 3.

**Manner 3:** The transmitting end stores a lowest-code-rate matrix (that is, the storage matrix is the lowest-code-rate matrix) and an indication sequence, and merges the storage matrix based on the indication sequence to generate a check matrix for corresponding decoding, namely, the LDPC base graph in step 602.

In the manner 3, the indication sequence may also be referred to as a merge (merge) sequence. For ease of understanding, the indication sequence is referred to as a merge sequence below. The merge sequence indicates rows to be merged in the storage matrix. In other words, the indication information indicates a merge relationship between the rows of the storage matrix.

The storage matrix and the merge sequence in the manner 3 are described below.

(1) Storage matrix

The storage matrix in the manner 3 may be a low-code-rate matrix obtained by splitting a highest-code-rate matrix for T times in advance based on the manner 1. Certainly, the storage matrix may alternatively be determined in advance by using a method different from the manner 1, but a finally obtained matrix has a same feature as the low-code-rate matrix in the manner 1.

In a possible implementation, the storage matrix has at least some of the following features.

Feature A: The storage matrix includes a fourth submatrix and a fifth submatrix, the fourth submatrix includes the non-extended columns of the storage matrix, the fifth submatrix includes extended columns of the storage matrix, and a column weight of each of P columns of the fifth submatrix is 2; and one of two non-zero elements included in a $p^{th}$ column in the P columns corresponds to a $j_1^{th}$ row of the first submatrix, the other one of the two non-zero elements included in the $p^{th}$ column in the P columns corresponds to a $j_2^{th}$ row of the first submatrix, the $j_1^{th}$ row and the $j_2^{th}$ row are orthogonal to each other, and the $p^{th}$ column is any one of the P columns, where P, p, $j_1$, and $j_2$ are all positive integers.

In other words, degrees of some or all extended nodes in the storage matrix are 2, and parts, other than extended parts, of two rows corresponding to each of the extended nodes are orthogonal to each other.

Feature B: The storage matrix is an $S\times G$ matrix, and an $(s_1+1)^{th}$ row to an $S^{th}$ row of the storage matrix are extended rows, and a $(g_2+1)^{th}$ column to a $G^{th}$ column of the storage matrix are extended columns; and the storage matrix includes a submatrix A3, a submatrix B3, a submatrix C3, a submatrix D3, and a submatrix E3, where the submatrix A3 is a $1^{st}$ row to an $s_1^{th}$ row and a $1^{st}$ column to a $g_1^{th}$ column of the storage matrix, the submatrix B3 is the $1^{st}$ row to the $s_1^{th}$ row and a $(g_1+1)^{th}$ column to a $g_2^{th}$ column of the storage matrix, the submatrix C3 is the $1^{st}$ row to the $s_1^{th}$ row and the $(g_2+1)^{th}$ column to the $G^{th}$ column of the storage matrix, the submatrix D3 is the $(s_1+1)^{th}$ row to the $S^{th}$ row and the $1^{st}$ column to the $g_2^{th}$ column of the storage matrix, and the submatrix E3 is the $(s_1+1)^{th}$ row to the $S^{th}$ row and the $(g_2+1)^{th}$ column to the $G^{th}$ column of the storage matrix, where $1\leq s_1\leq S$; $1\leq g_1\leq g_2\leq G$; and $s_1$, S, $g_1$, $g_2$, and G are integers, where elements on a diagonal of the submatrix E3 are non-zero elements, a non-zero element is included above the diagonal of the submatrix E3, and/or a non-zero element is included below the diagonal of the submatrix E3, and the submatrix C3 includes a non-zero element.

In addition, it should be noted that, if a row location is adjusted and/or a column location is adjusted in a process of obtaining the storage matrix, extended rows and/or extended columns of the storage matrix satisfy: $S\text{-}s_1$ extended rows and/or $G\text{-}g_2$ extended columns are sorted in a splitting order, and sorted extended rows and extended columns have the foregoing feature B.

(2) Merge sequence

The merge sequence may include a plurality of pieces of sub-information, and an arrangement order of the plurality of pieces of sub-information is a merging order. Each of the plurality of pieces of sub-information indicates two rows to be merged in the storage matrix.

Optionally, the foregoing sub-information may be a label of an extended node, and rows to be merged are rows corresponding to the extended node. For a specific correspondence manner, refer to the foregoing feature A. The label of the extended node may be a label numbered when only extended nodes are numbered. For example, the storage matrix includes 10 extended nodes, and numbers of the extended nodes may be sequentially 1 to 10. The label of the extended node may alternatively be a label numbered when all variable nodes are numbered. For example, if the storage matrix includes 28 variable nodes, including four extended nodes, labels of the extended nodes may be sequentially 25 to 28.

Optionally, the sub-information may be labels of rows to be merged. For example, when a 5th row and a 6th row of the storage matrix need to be merged, the sub-information may include a label of the 5th row and a label of the 6th row.

An example in which the sub-information is the label of the extended node is used below for description. The label of the extended node may be a label numbered when only extended nodes are numbered.

In a possible implementation, the plurality of pieces of sub-information in the merge sequence form at least one segment, and each of the at least one segment corresponds to one round of merging.

Optionally, a label of an extended column (namely, a label of an extended node), of the storage matrix, corresponding to the sub-information included in the at least one segment may be a random value.

Optionally, the label of the extended column (namely, the label of the extended node), of the storage matrix, corresponding to the sub-information included in the at least one segment is related to a row weight of each row of the storage matrix.

Optionally, labels of extended columns (namely, labels of extended nodes), of the storage matrix, corresponding to sub-information included in a $t^{th}$ segment in the at least one segment are in a form of permutation of $\{(2^{T1-t}-1)s_1+1, ..., (2^{T1-t+1}-1)s_1\}$ or a form of permutation of a subset of $\{(2^{T1-t}-1)s_1+1, ..., (2^{T1-t+1}-1)s_1\}$, where T1 is an upper bound of a quantity of merging rounds, $s_1$ is a quantity of non-extended rows of the storage matrix, and T1 and t are positive integers. The label of the extended node is a label numbered when only the extended nodes are numbered.

Optionally, a $t^{th}$ segment of the merge sequence corresponds to a $t^{th}$ round of merging.

Because the labels of the extended nodes corresponding to the sub-information included in the segment corresponding to the $t^{th}$ round of merging are in the form of permutation of $\{(2^{T1-t}-1)s_1+1, ..., (2^{T1-t+1}-1)s_1\}$ or the form of permutation of the subset of $\{(2^{T1-t}-1)s_1+1, ..., (2^{T1-t+1}-1)s_1\}$, a plurality of times of merging included in each round may be performed in parallel. This helps improve merging efficiency.

Assuming that each extended column of the storage matrix has the foregoing feature A, and sub-information is a label of an extended node, a basic meaning of the merge sequence is as follows:

(a) Length of the merge sequence: It is a total quantity of extended nodes of the storage matrix.

(b) Segmentation of the merge sequence: The merge sequence is segmented based on a quantity of merging rounds, and a $t^{th}$ segment corresponds to a $t^{th}$ round of merging.

(c) Meanings of digits in the merge sequence: An $i^{th}$ location in the merge sequence corresponds to an extended node corresponding to check equations that are of the storage matrix and that are to be merged at an $i^{th}$ time.

(d) An order of the digits in the merge sequence: It is an order of obtaining a high-code-rate matrix by merging the storage matrix.

In a possible implementation, the merge sequence may be provided by using a calculation formula. Specifically, an $i^{th}$ location element in the $t^{th}$ round is $\gamma(i) = p_{t2+1}(i - (2^{T1-t2+1} - 1)s_1)$, where $t_2$ is a largest positive integer that satisfies $i > (2^{T1-t2+1} - 1)s_1$. s1 is a quantity of rows of a core part of the storage matrix, and T1 is an upper bound of a quantity of merging times.

A merging process based on a merge sequence is described below with reference to a specific example.

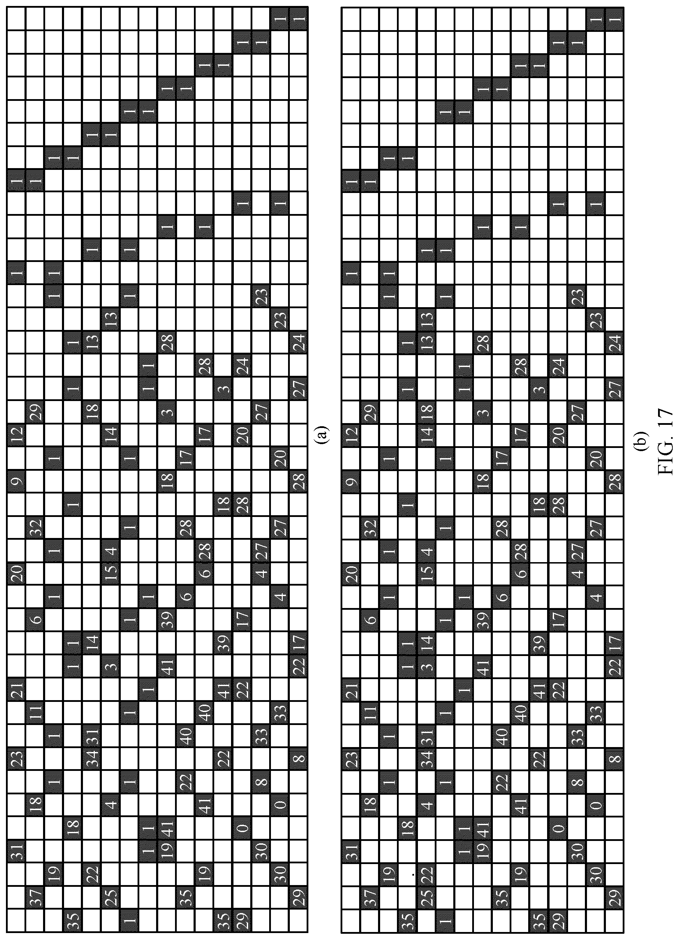

FIG. 17 is a diagram of one time of merging.

It is assumed that for a stored low-code-rate matrix $H_0$, a quantity of columns is $G = 40$ and a quantity of rows is $S = 16$, that is, a code rate is 0.4, as shown in (a) in FIG. 17. It is assumed that a merge sequence is

$$\gamma = \begin{cases} 7,12,5,11,10,8,9,6 \\ \quad 3,1,4,2 \end{cases}$$

, where a 1st row corresponds to a 1st round of merging, and digits in the 1st row is a permutation of 5 to 12 (labels of extended nodes corresponding to check equations that are of the current storage matrix and that are to be merged). In this way, each label appears only once in one round of merging. A 1st digit in the 1st row is 7, and check equations corresponding to a 1st time of merging in the 1st round are check equations corresponding to a 7th extended node, namely, the following check equations $c_5$ and $c_6$ (an included common extended node is the 7th extended node $x_{35}$):

$$c_5\colon\ x_3 + x_8 + x_9 + x_{13} + x_{23} + x_{26} + x_{30} + x_{35} = 0;$$

and

$$c_6\colon\ x_2 + x_6 + x_{12} + x_{16} + x_{17} + x_{22} + x_{27} + x_{35} = 0.$$

An exclusive OR addition is performed on $c_5$ and $c_6$ to obtain a new check equation $c'_5\colon x_2 + x_3 + x_6 + x_8 + x_9 + x_{12} + x_{13} + x_{16} + x_{17} + x_{22} + x_{23} + x_{26} + x_{27} + x_{30} = 0$, where $c_5$ and $c_6$ are replaced with $c'_5$, and it is noted that an extended node $x_{35}$

is eliminated. A merged check equation matrix $(H_1)_{15 \times 39}$ is shown in (b) in FIG. 17.

Subsequently, a 2nd element, a 3rd element, a 4th element, a 5th element, a 6th element, a 7th element, and an 8th element in the 1st row of the merge sequence are sequentially used to perform merging to generate matrices $(H_2)_{14 \times 38}$, ...$(H_8)_{8 \times 32}$, to complete a process of the 1st complete round of merging; and then a 2nd row of the merge sequence is processed to perform a process of a 2nd round of merging.

In addition, it should be noted that, the low-code-rate matrix shown in (a) in FIG. 17 is a matrix obtained through row location adjustment.

The merge sequence and the storage matrix are described above. A rate matching process based on a merge sequence is described below. It is assumed that for a storage matrix, a quantity of rows is S and a quantity of columns is G, where $S=2^{T1}s_1$, and $G=g_2+(2^{T1}-1)s_1$, where $s_1$ is a quantity of rows of a core part of the storage matrix, $g_2$ is a quantity of columns of the core part of the storage matrix, and T1 is an upper bound of a quantity of merging times.

In a possible implementation, the rate matching process based on the merge sequence is mainly implemented by using the following steps.

Step 1: Determine, based on a target code rate and a target code length, a quantity X of rows and a quantity Y of columns of an LDPC base graph that needs to be constructed.

Step 2: Determine, based on the quantity Y of columns of the LDPC base graph, that merging includes complete merging rounds 1, ... , $t_3$ - 1 and first $i$ times of merging in a $t_3$th round.

For example, a smallest $Z_c$ that satisfies $KZ_c \geq K_0$ is selected from a $Z_c$ list, where $K$ is a quantity of information columns of the LDPC base graph (namely, a quantity of information columns of a storage matrix), and $K_0$ is a quantity of information bits corresponding to the LDPC base graph (namely, a target quantity of information bits), and shortening (shorten) processing is performed on locations $KZ_c$ - $K_0$ + 1 to $KZ_c$; a quantity W of merging times is determined, where W is a largest integer that satisfies $R_0 \leq \dfrac{K}{g_1+(2^{T1}-1)s_1-W}$, where $R_0$ is the target code rate; and next, $t_3$ is selected, where $t_3$

is a largest positive integer that satisfies $2^{T1-t_3}s_1(2^t - 1) \leq W$. In this way, first $t_3$-1 complete rounds of merging and $i$=W-($2^{t_3}$ - 1) $s_1$ + ($2^{T1-t_3}$ - 1)$s_1$ times of merging in the $t_3$th round need to be performed.

Step 3: Sequentially select W elements in the merge sequence, to complete the first $t_3$-1 complete rounds of merging and the $i$=W-($2^{t_3}$ - 1)$s_1$ + ($2^{T1-t_3}$ - 1)$s_1$ times of merging in the $t_3$th round.

Because the merge sequence has the permutation feature described above, a plurality of times of merging in each round of merging may be performed in parallel.

It should be noted that the conditions that $Z_c$, W, $t_3$, and the like need to satisfy are all examples, and may be replaced with other conditions that can be implemented.

It should be further noted that the W times of merging may be divided into a plurality of rounds of merging based on the foregoing descriptions, and a plurality of times of merging in each round of merging are performed in parallel. Certainly, the W times of merging may alternatively be performed sequentially or serially. In this case, there is no segmentation concept for the merge sequence. After the quantity W of merging times is determined, first W pieces of sub-information of the merge sequence may be obtained based on W, and then the W times of merging are performed sequentially.

Similar to splitting, for first W-1 times of merging in the W times of splitting, a row before $Z_c$ lifting may be used as a granularity for merging, in other words, a QC structure or $Z_c$ may be used as a granularity for merging. For a Wth time of merging, namely, a last time of merging, a row before $Z_c$ lifting may be used as a granularity for merging, or a row (that is, 1) after $Z_c$ lifting may be used as the granularity for merging. For example, when a part of parity bits corresponding to a last column of the LDPC base graph are punctured, the row after $Z_c$ lifting may be used as the granularity for the Wth time of merging. For another example, with reference to the foregoing descriptions, it is assumed that $WZc$ - $N_0$ may correspond to a punctured bit of an extended node with a largest label, and merging is performed at a granularity of 1 for $(W-1)Z_c$-$N_0$, where $N_0$ is the target code length.

**Manner 4:** The transmitting end stores a lowest-code-rate matrix (that is, the storage matrix is the lowest-code-rate matrix), a shifting value table, and an indication sequence, and reads the storage matrix and the shifting value table based on the indication sequence to obtain an LDPC base graph for usage.

The storage matrix is used to store a connection relationship between a variable node and a check node, a shifting value of a non-zero element of the storage matrix is obtained based on the shifting value table, and the shifting value table is used to store shifting values of locations of non-extended rows of the storage matrix. The indication sequence includes at least one row number, and an $i_3$th row number in the at least one row number indicates that a shifting value of an $i_3$th row of the LDPC base graph is determined based on a shifting value of a row identified by the $i_3$th row number in the at least one row number, where $i_3$ is a positive integer.

For example, the expected LDPC base graph is a matrix with seven rows and 29 columns, the storage matrix stores connection relationships between variable nodes and check nodes, the shifting value table stores a shifting value of each location of six rows and 28 columns of a core part, and a 7th row number of the indication sequence is 2. For a 7th row of the LDPC base graph, the transmitting end may determine a shifting value of the 7th row based on a connection relationship of a 7th row of the storage matrix and a shifting value corresponding to a 2nd row of the storage matrix in the shifting value table.

In other words, the LDPC base graph used for encoding is obtained by reading the storage matrix and the shifting value table based on the indication sequence.

For descriptions of the storage matrix, refer to the manner 2. For descriptions of the indication sequence, refer to the manner 1. Details are not described herein again.

In the manner 4, a rate matching process is similar to that in the manner 1. Details are not described again.

This application further provides another LDPC code-based communication method. In this method, degrees of some or all extended nodes of a storage matrix are 2, and parts, other than extended parts, of two rows corresponding to each of the extended nodes are orthogonal to each other. Therefore, the extended nodes may be punctured to implement a merging effect, so as to increase a code rate from low to high.

The LDPC code-based communication method is described below.

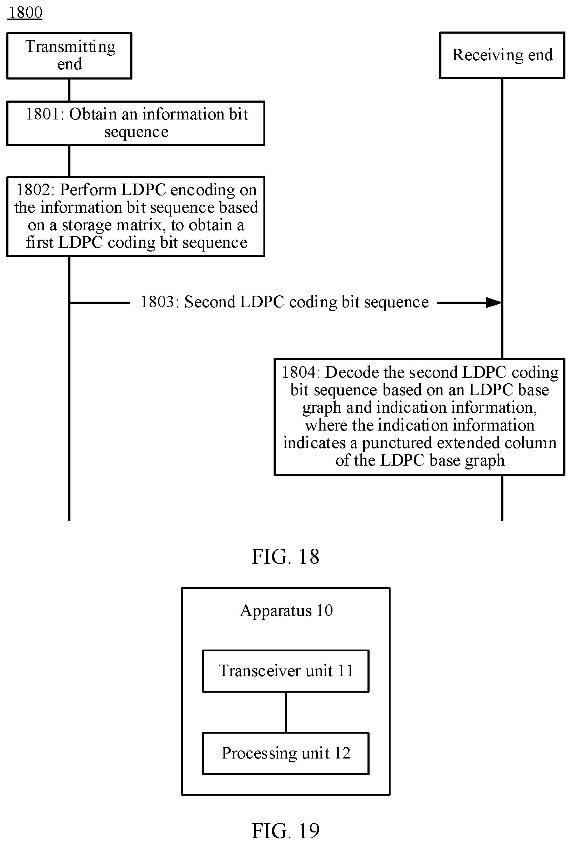

FIG. 18 is a schematic flowchart of an LDPC code-based communication method 1800 according to this application.

The method 1800 may be performed by a transmitting end and a receiving end, or may be performed by modules or units in the transmitting end and the receiving end, which are collectively referred to as the transmitting end and the receiving end below for ease of description. The method 1800 may include at least a part of the following content.

Step 1801: The transmitting end obtains an information bit sequence.

To be specific, if the transmitting end needs to communicate with the receiving end, in other words, the transmitting end needs to send a signal to the receiving end, the transmitting end needs to first obtain an information bit sequence corresponding to the signal that needs to be sent to the receiving end.

Optionally, that the transmitting end obtains the to-be-sent information sequence may mean that the transmitting end performs source encoding on a source symbol to generate the information bit sequence. That the transmitting end obtains the to-be-sent information sequence may alternatively mean that the transmitting end receives the information bit sequence from another communication apparatus.

Step 1802: The transmitting end performs LDPC encoding on the information bit sequence based on an LDPC base graph, to obtain an LDPC coding bit sequence.

The LDPC base graph is a matrix stored at the transmitting end, namely, a storage matrix. The storage matrix may be a low-code-rate matrix obtained by splitting a highest-code-rate matrix for T times in advance based on the manner 1. Certainly, the storage matrix may alternatively be determined in advance by using a method different from the manner 1, but a finally obtained matrix has a same feature as the low-code-rate matrix in the manner 1.

In a possible implementation, the storage matrix has at least some of the following features.

Feature A: The storage matrix includes a fourth submatrix and a fifth submatrix, the fourth submatrix includes the non-extended columns of the storage matrix, the fifth submatrix includes extended columns of the storage matrix, and a column weight of each of P columns of the fifth submatrix is 2; and one of two non-zero elements included in a $p^{th}$ column in the P columns corresponds to a $j_1^{th}$ row of the first submatrix, the other one of the two non-zero elements included in the $p^{th}$ column in the P columns corresponds to a $j_2^{th}$ row of the first submatrix, the $j_1^{th}$ row and the $j_2^{th}$ row are orthogonal to each other, and the $p^{th}$ column is any one of the P columns, where P, p, $j_1$, and $j_2$ are all positive integers.

In other words, degrees of some or all extended nodes in the storage matrix are 2, and parts, other than extended parts, of two rows corresponding to each of the extended nodes are orthogonal to each other.

Feature B: The storage matrix is an $S \times G$ matrix, and an $(s_1+1)^{th}$ row to an $S^{th}$ row of the storage matrix are extended rows, and a $(g_2+1)^{th}$ column to a $G^{th}$ column of the storage matrix are extended columns; and the storage matrix includes a submatrix A3, a submatrix B3, a submatrix C3, a submatrix D3, and a submatrix E3, where the submatrix A3 is a $1^{st}$ row to an $s_1^{th}$ row and a $1^{st}$ column to a $g_1^{th}$ column of the storage matrix, the submatrix B3 is the $1^{st}$ row to the $s_1^{th}$ row and a $(g_1+1)^{th}$ column to a $g_2^{th}$ column of the storage matrix, the submatrix C3 is the $1^{st}$ row to the $s_1^{th}$ row and the $(g_2+1)^{th}$ column to the $G^{th}$ column of the storage matrix, the submatrix D3 is the $(s_1+1)^{th}$ row to the $S^{th}$ row and the $1^{st}$ column to the $g_2^{th}$ column of the storage matrix, and the submatrix E3 is the $(s_1+1)^{th}$ row to the $S^{th}$ row and the $(g_2+1)^{th}$ column to the $G^{th}$ column of the storage matrix, where $1 \leq s_1 \leq S$; $1 \leq g_1 \leq g_2 \leq G$; and $s_1$, S, $g_1$, $g_2$, and G are integers, where elements on a diagonal of the submatrix E3 are non-zero elements, a non-zero element is included above the diagonal of the submatrix E3, and/or a non-zero element is included below the diagonal of the submatrix E3, and the submatrix C3 includes a non-zero element.

In addition, it should be noted that, if a row location is adjusted and/or a column location is adjusted in a process of obtaining the storage matrix, extended rows and/or extended columns of the storage matrix satisfy: $S - s_1$ extended rows and/or $G - g_2$ extended columns are sorted in a splitting order, and sorted extended rows and extended columns have the foregoing feature B.

Step 1803: The transmitting end sends a second LDPC coding bit sequence to the receiving end based on indication information, in other words, the receiving end receives the second LDPC coding bit sequence from the transmitting end.

A specific form of the indication information is not limited in this application. In a possible implementation, a form used for the indication information may include at least one of an indication sequence, a mapping table, or a mapping pair. For details, refer to descriptions in FIG. 6. Details are not described herein again. Similarly, for ease of description, the technical solutions of this application are described below by using an indication sequence as an example. The indication sequence may be replaced with an equivalent form such as a mapping table or a mapping pair.

The indication sequence may also be referred to as a puncture (puncture) sequence. For ease of understanding, the indication sequence is referred to as a puncture sequence below. The puncture sequence indicates a to-be-punctured extended column of the storage matrix. It should be noted that the to-be-punctured extended column of the storage matrix herein belongs to the P columns in the foregoing feature A.

The second LDPC coding bit sequence sent by the transmitting end includes coding bits in a first LDPC coding bit sequence other than coding bits corresponding to the punctured extended column of the storage matrix. In other words, the second LDPC coding bits do not include the coding bits corresponding to the punctured extended column of the storage matrix in the first LDPC coding bit sequence.

When some or all extended columns of the storage matrix are punctured, the storage matrix does not change. However, because a column whose degree is 2 is punctured, an exclusive OR result of two check equations (namely, two rows of the storage matrix) corresponding to the column is 0, in other words, it is equivalent to that the two rows are merged. In this way, the merging effect shown in the foregoing manner 3 may be implemented through puncturing.

The puncture sequence is described below.

The puncture sequence is similar to the foregoing merge sequence, and may include a plurality of pieces of sub-information, and an arrangement order of the plurality of pieces of sub-information is a puncturing order. Each of the plurality of pieces of sub-information indicates a to-be-punctured extended column of the storage matrix.

Optionally, the sub-information may be a label of the extended node. The label of the extended node may be a label numbered when only extended nodes are numbered. For example, the storage matrix includes 10 extended nodes, and numbers of the extended nodes may be sequentially 1 to 10. The label of the extended node may alternatively be a label numbered when all variable nodes are numbered. For example, if the storage matrix includes 28 variable nodes, including four extended nodes, labels of the extended nodes may be sequentially 25 to 28.

An example in which the label of the extended node is a label numbered when only the extended nodes are numbered is used below for description.

In a possible implementation, the plurality of pieces of sub-information in the puncture sequence form at least one segment, and each of the at least one segment corresponds to one round of puncturing.

Optionally, a label of an extended column (namely, a label of an extended node), of the storage matrix, corresponding to the sub-information included in the at least one segment may be a random value.

Optionally, the label of the extended column (namely, the label of the extended node), of the storage matrix, corresponding to the sub-information included in the at least one segment is related to a row weight of each row of the storage matrix.

Optionally, labels of extended columns (namely, labels of extended nodes), of the storage matrix, corresponding to sub-information included in a $t^{th}$ segment in the at least one segment are in a form of permutation of $\{(2^{T2-t}-1)s_1+1, ..., (2^{T2-t+1}-1)s_1\}$ or a form of permutation of a subset of $\{(2^{T2-t}-1)s_1+1, ..., (2^{T2-t+1}-1)s_1\}$, where T2 is an upper bound of a quantity of puncturing rounds, $s_1$ is a quantity of non-extended rows of the storage matrix, and T2 and t are positive integers.

Optionally, a $t^{th}$ segment of the puncture sequence corresponds to a $t^{th}$ round of puncturing.

Because the labels of the extended nodes corresponding to the sub-information included in the segment corresponding to the $t^{th}$ round of puncturing are in the form of permutation of $\{(2^{T2-t}-1)s_1+1, ..., (2^{T2-t+1}-1)s_1\}$ or the form of permutation of the subset of $\{(2^{T2-t}-1)s_1+1, ..., (2^{T-t+1}-1)s_1\}$, a plurality of times of puncturing included in each round may be performed in parallel. This helps improve puncturing efficiency.

Assuming that each extended column of the storage matrix has the foregoing feature A, a basic meaning of the puncture sequence is as follows:

(a) Length of the puncture sequence: It is a total quantity of extended nodes of the storage matrix.
(b) Segmentation of the puncture sequence: The puncture sequence is segmented based on a quantity of puncturing rounds, and a $t^{th}$ segment corresponds to a $t^{th}$ round of puncturing.
(c) Meanings of digits in the puncture sequence: An $i^{th}$ location in the puncture sequence corresponds to a label of an extended node that is of the storage matrix and that is to be punctured at an $i^{th}$ time.
(d) An order of the digits in the puncture sequence: It is an order of obtaining a high-code-rate matrix by puncturing the storage matrix.

In a possible implementation, the puncture sequence may be provided by using a calculation formula. Specifically, an $i^{th}$ location element in the $t^{th}$ round is $\gamma(i) = p_{t_4+1}(i - (2^{T2-t_4+1} - 1)s_1)$, where $t_4$ is a largest positive integer that satisfies $i > (2^{T2-t_4+1}-1)s_1$, $s_1$ is a quantity of rows of a core part of the storage matrix, and T2 is an upper bound of a quantity of puncturing times.

A rate matching process based on a puncture sequence is described below.

It is assumed that for a storage matrix, a quantity of rows is S and a quantity of columns is G, where $S=2^{T2}s_1$, and $G=g_2+(2^{T2}-1)s_1$, where $s_1$ is a quantity of rows of a core part of the storage matrix, $g_2$ is a quantity of columns of the core part of the storage matrix, and T2 is an upper bound of a quantity of puncturing times.

In a possible implementation, the rate matching process based on the puncture sequence is mainly implemented by using the following steps.

Step 1: Determine, based on a target code rate and a target code length, that puncturing includes a quantity 1, ... , $t_5$ - 1 of complete puncturing rounds and first i times of puncturing in a $t_5^{th}$ round.

For example, a smallest $Z_c$ that satisfies $KZ_c \geq K_0$ is selected from a $Z_c$ list, where $K$ is a quantity of information columns of an LDPC base graph (namely, a quantity of information columns of a storage matrix), and $K_0$ is a target quantity of information bits, and shortening (shorten) processing is performed on locations $KZ_c - K_0 + 1$ to $KZ_c$; a quantity J of puncturing times is determined, where J is a largest integer that satisfies $R_0 \leq \dfrac{K}{g_2+(2^{T2}-1)s_2-J}$, where $R_0$ is the target code rate; and next, $t_5$ is selected, where $t_5$ is a largest positive integer that satisfies $2^{T2-t5}s_1(2^t - 1) \leq J$. In this way, first $t_5$-1 complete rounds of puncturing and $i=J-(2^{t5} - 1)s_1 + (2^{T2-t5} - 1)s_1$ times of puncturing in the $t_5^{th}$ round need to be performed.

Step 3: Sequentially select J elements in the puncture sequence, to complete the first $t_5$ -1 complete rounds of puncturing and the $i =J -(2^{t5} - 1)s_1 + (2^{T2-t5} - 1)s_1$ times of puncturing of the $t_5^{th}$ round.

Because the puncture sequence has the permutation feature described above, a plurality of times of puncturing in each round of puncturing may be performed in parallel.

It should be noted that the conditions that $Z_c$, J, $t_5$, and the like need to satisfy are all examples, and may be replaced with other conditions that can be implemented.

It should be further noted that the J times of puncturing may be divided into a plurality of rounds of puncturing based on the foregoing descriptions, and a plurality of times of puncturing in each round of puncturing are performed in parallel. Certainly, the J times of puncturing may alternatively be performed sequentially or serially. In this case, there is no segmentation concept for the puncture sequence. After the quantity J of puncturing times is determined, first J pieces of sub-information of the puncture sequence may be obtained based on J, and then the J times of puncturing are performed sequentially. The J times of puncturing may alternatively be performed once, and there is also no segmentation concept for the puncture sequence. After the quantity J of puncturing times is determined, the first J pieces of sub-information of the puncture sequence may be obtained based on J, and then J extended nodes are punctured once.

Similar to splitting, for first J-1 times of puncturing in the J times of puncturing, a row before $Z_c$ lifting may be used as a granularity for puncturing, in other words, a QC structure or $Z_c$ may be used as a granularity for puncturing. For a $J^{th}$ time of puncturing, namely, a last time of puncturing, a row before $Z_c$ lifting may be used as a granularity for puncturing, or a row (that is, 1) after $Z_c$ lifting may be used as the granularity for puncturing. When puncturing is performed by using the row after $Z_c$ lifting as the granularity, a part of parity bits corresponding to a last punctured column may be punctured.

Step 1804: The receiving end decodes the second LDPC coding bits based on the puncture sequence and the LDPC base graph.

Specifically, the receiving end may pad, based on the puncture sequence, a zero to a corresponding location of an LLR sequence corresponding to the second LDPC coding bits, and decode the LLR sequence obtained by padding the zero. The corresponding location of the LLR sequence is a location indicated by the puncture sequence.

The puncture sequence, the LDPC base graph, and the rate matching process based on the puncture sequence used by the receiving end are the same as those used by the transmitting end. For details, refer to the descriptions of the transmitting end. Details are not described herein again.

A puncture sequence, a storage matrix, and usage manners of the puncture sequence and the storage matrix are described below with reference to a specific example.

It is assumed that for a stored low-code-rate matrix $H_0$, a quantity of columns is $G = 40$ and a quantity of rows is $S = 16$, that is, a code rate is 0.4, as shown in (a) in FIG. 17. It is assumed that a puncture sequence is $\beta = \left\{ \begin{matrix} 7,12,5,11,10,8,9,6 \\ 3,1,4,2 \end{matrix} \right.$, where a 1st row corresponds to a 1st round of puncturing, and digits in the 1st row is a permutation of 5 to 12 (labels of extended nodes that are of the current storage matrix and that are to be punctured). In this way, each label appears only once in one round of puncturing. A 1st digit in the 1st row is 7, and a corresponding extended node that is punctured at a 1st time in the 1st round is a $7^{th}$ extended node $x_{35}$.

It is noted that after the $7^{th}$ extended node $x_{35}$ is punctured, the storage matrix does not change. However, because a degree of $x_{35}$ is 2, and check equations $c_5$ and $c_6$ corresponding to $x_{35}$ are equivalent to $c_5 \oplus c_6 = 0$, in other words, it is equivalent to that $c_5$ and $c_6$ are merged. Subsequently, a 2nd element, a 3rd element, a 4th element, a 5th element, a 6th element, a 7th element, and an 8th element in the 1st row of the puncture sequence are sequentially used to puncture the storage matrix, to complete a process of the 1st complete round of splitting; and then a 2nd row of the puncture sequence is processed to perform a process of the 2nd round of puncturing.

It should be noted that the foregoing embodiments of this application may be independently implemented, or may be implemented together in a proper manner. This is not limited in this application.

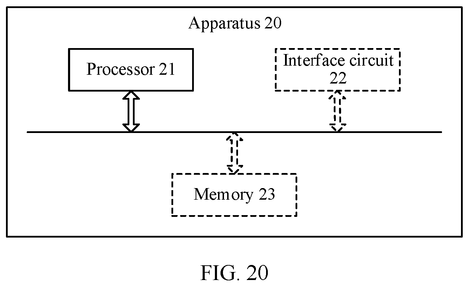

The method provided in this application is described in detail above the with reference to FIG. 6 to FIG. 18. Apparatus embodiments of this application are described in detail below with reference to FIG. 19 and FIG. 20.

It may be understood that, to implement functions in the foregoing embodiments, the apparatus in FIG. 19 or FIG. 20 includes a corresponding hardware structure and/or software module for performing each function. A person skilled in the art should be easily aware that, with reference to the units and method steps in the examples described in embodiments disclosed in this application, this application can be implemented in a form of hardware or a combination of hardware and computer software.

FIG. 19 and FIG. 20 are diagrams of structures of possible apparatuses according to embodiments of this application. These apparatuses may be configured to implement functions of the transmitting end or the receiving end in the foregoing method embodiments. Therefore, beneficial effects of the foregoing method embodiments can also be implemented.

As shown in FIG. 19, an apparatus 10 includes a transceiver unit 11 and a processing unit 12.

In some implementations:

When the apparatus 10 is configured to implement a function of the transmitting end in the foregoing method embodiments, the transceiver unit 11 is configured to obtain an information bit sequence; the processing unit 12 is configured to perform LDPC encoding on the information bit sequence based on an LDPC base graph, to obtain an LDPC coding bit sequence, where the LDPC base graph is obtained based on a storage matrix and indication information, the indication information indicates a correspondence between rows of the storage matrix or a correspondence between rows of the LDPC base graph, and a sum of column weights of non-extended columns of the LDPC base graph is equal to a sum of column weights of non-extended columns of the storage matrix; and the transceiver unit 11 is further configured to send the LDPC coding bit sequence.

When the apparatus 10 is configured to implement a function of the receiving end in the foregoing method embodiments, the transceiver unit 11 is configured to: receive an LDPC coding bit sequence from a transmitting end; and decode the LDPC coding bit sequence based on an LDPC base graph, where the LDPC base graph is obtained based on a storage matrix and indication information, the indication information indicates a correspondence between rows of the storage matrix or a correspondence between rows of the LDPC base graph, and a sum of column weights of non-extended columns of the LDPC base graph is equal to a sum of column weights of non-extended columns of the storage matrix.

Optionally, a code rate corresponding to the LDPC base graph is different from a code rate corresponding to the storage matrix.

Optionally, the LDPC base graph includes a first submatrix and a second submatrix, the first submatrix includes the non-extended columns of the LDPC base graph, the second submatrix includes extended columns of the LDPC base graph; a column weight of each of Q columns of the second submatrix is 2; and one of two non-zero elements included in a $q^{th}$ column in the Q columns corresponds to an $i_1^{th}$ row of the first submatrix, the other one of the two non-zero elements included in the $q^{th}$ column in the Q columns corresponds to an $i_2^{th}$ row of the first submatrix, the $i_1^{th}$ row and the $i_2^{th}$ row are orthogonal to each other, and the $q^{th}$ column is any one of the Q columns, where Q, q, $i_1$, and $i_2$ are all positive integers.

Optionally, the LDPC base graph is an $X \times Y$ matrix, and a $(y_2+1)^{th}$ column to a $Y^{th}$ column of the LDPC base graph are extended columns; and the LDPC base graph includes a submatrix A1, a submatrix B1, a submatrix C1, a submatrix D1, and a submatrix E1, where the submatrix A1 is a 1st row to an $x_1^{th}$ row and a 1st column to a $y_1^{th}$ column of the LDPC base graph, the submatrix B1 is the 1st row to the $x_1^{th}$ row and a $(y_1+1)^{th}$ column to a $y_2^{th}$ column of the LDPC base graph, the submatrix C1 is the 1st row to the $x_1^{th}$ row and the $(y_2+1)^{th}$ column to the $Y^{th}$ column of the LDPC base graph, the submatrix D1 is an $(x_1+1)^{th}$ row to an $X^{th}$ row and the 1st column to the $y_2^{th}$ column of the LDPC base graph, and the submatrix E1 is the $(x_1+1)^{th}$ row to the $X^{th}$ row and the $(y_2+1)^{th}$ column to the $Y^{th}$ column of the LDPC base graph, where $1 \leq x_1 \leq X$; $1 \leq y_1 \leq y_2 \leq Y$; and $x_1$, X, $y_1$, $y_2$, and Y are integers. Elements on a diagonal of the submatrix E1 are non-zero elements, a non-zero element is included above the diagonal of the submatrix E1, and/or a non-zero element is included below the diagonal of the submatrix E1, and the submatrix C1 includes a non-zero element.

Optionally, a form used for the indication information includes at least one of an indication sequence, a mapping table, or a mapping pair.

Optionally, the indication information indicates the correspondence between the rows of the LDPC base graph, the storage matrix is used to store a connection relationship between a variable node and a check node, a shifting value of a non-zero element of the storage matrix is obtained based on a shifting value table, and the shifting value table is used to store shifting values of locations of non-extended rows of the storage matrix.

Optionally, the indication information is in the form of the indication sequence, the LDPC base graph is obtained by reading the storage matrix and the shifting value table based on the indication sequence, the indication sequence includes at least one row number, and an $i_3^{th}$ row number in the at least one row number indicates that a shifting value of an

$i_3^{th}$ row of the LDPC base graph is determined based on a shifting value of a row identified by the $i_3^{th}$ row number in the at least one row number, where $i_3$ is a positive integer.

Optionally, the indication information is in the form of the indication sequence, the LDPC base graph is obtained by splitting the storage matrix based on the indication sequence, the indication sequence includes at least one row number, an $(m_1+r)^{th}$ row number in the at least one row number indicates that an $(m_1+r)^{th}$ row of the LDPC base graph is used to perform elimination processing on a row identified by the $(m_1+r)^{th}$ row number in the at least one row number, and a sorting order of the at least one row number is a splitting order, where $m_1$ is a quantity of non-extended rows of the storage matrix, and r is a positive integer.

Optionally, the at least one row number includes at least one segment, each of the at least one segment corresponds to one round of splitting, and row numbers in a segment corresponding to a $t^{th}$ round of splitting in at least one round of splitting corresponding to the at least one segment are in a form of permutation of $\{1, ..., 2^{t-1}m_1\}$ or a form of permutation of a subset of $\{1, ..., 2^{t-1}m_1\}$, where t is a positive integer.

Optionally, the storage matrix is an $M \times N$ matrix, and an $(m_1+1)^{th}$ row to an $M^{th}$ row of the storage matrix are extended rows; and the storage matrix includes a submatrix A2, a submatrix B2, a submatrix C2, a submatrix D2, and a submatrix E2, where the submatrix A2 is a $1^{st}$ row to an $m_1^{th}$ row and a $1^{st}$ column to an $n_1^{th}$ column of the storage matrix, the submatrix B2 is the $1^{st}$ row to the $m_1^{th}$ row and an $(n_1+1)^{th}$ column to an $n_2^{th}$ column of the storage matrix, the submatrix C2 is the $1^{st}$ row to the $m_1^{th}$ row and an $(n_2+1)^{th}$ column to an $N^{th}$ column of the storage matrix, the submatrix D2 is the $(m_1+1)^{th}$ row to the $M^{th}$ row and the $1^{st}$ column to the $n_2^{th}$ column of the storage matrix, and the submatrix E2 is the $(m_1+1)^{th}$ row to the $M^{th}$ row and the $(n_2+1)^{th}$ column to the $N^{th}$ column of the storage matrix, where $1 \leq m_1 \leq M$; $1 \leq n_1 \leq n_2 \leq N$; and $m_1$, M, $n_1$, $n_2$, and N are integers. An $a_1^{th}$ row of the submatrix D2 is properly included in a $b_1^{th}$ row of a third submatrix and/or an $a_2^{th}$ row of the submatrix D2, the third submatrix includes the submatrix A2 and the submatrix B2, and the $a_1^{th}$ row is any row of the submatrix D2.

Optionally, a difference between a shifting value of each non-zero element in the $a_1^{th}$ row and a shifting value of a non-zero element at a corresponding location in the $b_1^{th}$ row remains the same, and/or a difference between a shifting value of each non-zero element in the $a_1^{th}$ row and a shifting value of a non-zero element at a corresponding location in the $b_1^{th}$ row remains the same.

Optionally, a plurality of rows that are of the submatrix D2 and that correspond to a $b_2^{th}$ row of the third submatrix are different from each other, and the $b_2^{th}$ row is any row of the third submatrix.

Optionally, a correspondence between the $a_1^{th}$ row and the $b_1^{th}$ row and a correspondence between the $a_1^{th}$ row and the $a_2^{th}$ row are determined based on the indication information.

Optionally, the processing unit 12 is further configured to: determine a quantity R of splitting times based on a code length corresponding to the LDPC base graph, a quantity of information bits corresponding to the LDPC base graph, and a quantity of information columns of the LDPC base graph; and split the storage matrix for R times to obtain the LDPC base graph, where an $r^{th}$ time of splitting in the R times of splitting includes the following operations: obtaining the $(m_1+r)^{th}$ row number of the indication sequence; and performing, by using an $(m_1+r)^{th}$ row of the storage matrix, elimination processing on a row that is in the storage matrix and that corresponds to the $(m_1+r)^{th}$ row number, where $m_1$ is a quantity of the non-extended rows of the storage matrix, the $r^{th}$ time of splitting is any one of the R times of splitting, and r is a positive integer.

Optionally, the storage matrix does not include an extended column.

Optionally, the LDPC base graph is obtained based on the storage matrix, the indication sequence, and a division table, and one row of the division table is used to construct one extended row of the LDPC base graph.

Optionally, the processing unit 12 is further configured to: determine a quantity R of splitting times based on a code length corresponding to the LDPC base graph, a quantity of information bits corresponding to the LDPC base graph, and a quantity of information columns of the LDPC base graph; and split the storage matrix for R times to obtain the LDPC base graph, where an $r^{th}$ time of splitting in the R times of splitting includes the following operations: obtaining the $r^{th}$ row of the division table, and constructing an $r^{th}$ extended row of the storage matrix based on the $r^{th}$ row; obtaining an $(M+r)^{th}$ row number of the indication sequence; and performing elimination processing on a $k^{th}$ row by using the $r^{th}$ extended row, where the $k^{th}$ row is a row that is in the storage matrix or first r-1 extended rows of the storage matrix and that corresponds to the $(M+r)^{th}$ row number, M is a quantity of rows of the storage matrix, the $r^{th}$ time of splitting is any one of the R times of splitting, and r is a positive integer.

Optionally, R is a smallest integer that satisfies $RZ_c \geq N_0 - K_0$, where $Z_c$ is a lifting value, $Z_c$ is a smallest $Z_c$ that satisfies $KZ_c \geq K_0$ in a $Z_c$ list, $N_0$ is the code length corresponding to the LDPC base graph, $K_0$ is the quantity of information bits corresponding to the LDPC base graph, and K is the quantity of information columns of the LDPC base graph.

Optionally, if a part of parity bits corresponding to a last column of the LDPC base graph are punctured, a row after $Z_c$ lifting is used as a granularity for a last time of splitting in the R times of splitting, where $Z_c$ is a lifting value, $Z_c$ is a smallest $Z_c$ that satisfies $KZ_c \geq K_0$ in a $Z_c$ list, $K_0$ is a quantity of information bits corresponding to the LDPC base graph, and K is the quantity of information columns of the LDPC base graph.

Optionally, the indication information is in the form of the indication sequence, the LDPC base graph is obtained by merging the storage matrix based on the indication sequence, the indication sequence includes a plurality of pieces of sub-information, each of the plurality of pieces of sub-information indicates two rows to be merged in the storage matrix, and an arrangement order of the sub-information is a merging order.

Optionally, the plurality of pieces of sub-information include at least one segment, each of the at least one segment corresponds to one round of merging, and labels of extended columns, of the storage matrix, corresponding to sub-information included in a $t^{th}$ segment in the at least one segment are in a form of permutation of $\{(2^{T-t}-1)s_1+1, ..., (2^{T-t+1}-1)s_1\}$ or a form of permutation of a subset of $\{(2^{T-t}-1)s_1+1, ..., (2^{T-t+1}-1)s_1\}$, where T is an upper bound of a quantity of merging rounds, $s_1$ is a quantity of non-extended rows of the storage matrix, and T and t are positive integers.

Optionally, the storage matrix includes a fourth submatrix and a fifth submatrix, the fourth submatrix includes the non-extended columns of the storage matrix, the fifth submatrix includes extended columns of the storage matrix; a column weight of each of P columns of the fifth submatrix is 2; and one of two non-zero elements included in a $p^{th}$ column in the P columns corresponds to a $j_1^{th}$ row of the first submatrix, the other one of the two non-zero elements included in the $p^{th}$ column in the P columns corresponds to a $j_2^{th}$ row of the first submatrix, the $j_1^{th}$ row and the $j_2^{th}$ row are orthogonal to each other, and the $p^{th}$ column is any one of the P columns, where P, p, $j_1$, and $j_2$ are all positive integers.

Optionally, the storage matrix is an $S \times G$ matrix, and an $(s_2+1)^{th}$ row to an $S^{th}$ row of the storage matrix are extended rows, and a $(g_2+1)^{th}$ column to a $G^{th}$ column of the storage matrix are extended columns; and the storage matrix includes a submatrix A3, a submatrix B3, a submatrix C3, a submatrix D3, and a submatrix E3, where the submatrix A3 is a $1^{st}$ row to an $s_1^{th}$ row and a $1^{st}$ column to a $g_1^{th}$ column of the storage matrix, the submatrix B3 is the $1^{st}$ row to the $s_1^{th}$ row and a $(g_1+1)^{th}$ column to a $g_2^{th}$ column of the storage matrix, the submatrix C3 is the $1^{st}$ row to the $s_1^{th}$ row and the $(g_2+1)^{th}$ column to the $G^{th}$ column of the storage matrix, the submatrix D3 is the $(s_1+1)^{th}$ row to the $S^{th}$ row and the $1^{st}$ column to the $g_2^{th}$ column of the storage matrix, and the submatrix E3 is the $(s_1+1)^{th}$ row to the $S^{th}$ row and the $(g_2+1)^{th}$ column to the $G^{th}$ column of the storage matrix, where $1 \le s_1 \le S$; $1 \le g_1 \le g_2 \le G$; and $s_1$, S, $g_1$, $g_2$, and G are integers. Elements on a diagonal of the submatrix E3 are non-zero elements, a non-zero element is included above the diagonal of the submatrix E3, and/or a non-zero element is included below the diagonal of the submatrix E3, and the submatrix C3 includes a non-zero element.

Optionally, the processing unit 12 is further configured to: determine a quantity W of merging times based on the code rate corresponding to the LDPC base graph, a quantity of information columns of the LDPC base graph, a quantity of non-extended rows of the storage matrix, a quantity of non-extended columns of the storage matrix, and the upper bound T of the quantity of merging rounds; and merge the storage matrix for W times to obtain the LDPC base graph, where a $W^{th}$ time of merging in the W times of splitting includes the following operations: obtaining a $W^{th}$ piece of sub-information of the indication sequence; and merging two rows indicated by the $W^{th}$ piece of sub-information, where the $W^{th}$ time of merging is any one of the W times of merging, and w is a positive integer.

Optionally, W is a smallest integer that satisfies $R_0 \le \dfrac{K}{g_1 + (2^{T1}-1)s_1 - W}$, where $R_0$ is the code rate corresponding to the LDPC base graph; K is the quantity of information columns of the LDPC base graph; $s_1$ is the quantity of non-extended rows of the storage matrix; $g_1$ is the quantity of non-extended columns of the storage matrix; and T1 is the upper bound of the quantity of merging rounds.

Optionally, if a part of parity bits corresponding to a last column of the LDPC base graph are punctured, a row after $Z_c$ lifting is used as a granularity for a last time of merging in the W times of merging, where $Z_c$ is a lifting value, $Z_c$ is a smallest $Z_c$ that satisfies $KZ_c \ge K_0$ in a $Z_c$ list, $K_0$ is a quantity of information bits corresponding to the LDPC base graph, and K is the quantity of information columns of the LDPC base graph.

In some other implementations:

When the apparatus 10 is configured to implement a function of the transmitting end in the foregoing method embodiments, the transceiver unit 11 is configured to obtain an information bit sequence; the processing unit 12 is configured to perform LDPC encoding on the information bit sequence based on a storage matrix to obtain a first LDPC coding bit sequence, where the storage matrix includes a fourth submatrix and a fifth submatrix, the fourth submatrix includes non-extended columns of the storage matrix, the fifth submatrix includes extended columns of the storage matrix; a column weight of each of P columns of the fifth submatrix is 2; and one of two non-zero elements included in a $p^{th}$ column in the P columns corresponds to a $j_1^{th}$ row of a first submatrix, the other one of the two non-zero elements included in the $p^{th}$ column in the P columns corresponds to a $j_2^{th}$ row of the first submatrix, the $j_1^{th}$ row and the $j_2^{th}$ row are orthogonal to each other, and the $p^{th}$ column is any one of the P columns, where P, p, $j_1$, and $j_2$ are all positive integers; and the transceiver unit 11 is further configured to send a second LDPC coding bit sequence based on indication information, where the indication information indicates a punctured column of the fifth submatrix, and the second LDPC coding bit sequence includes coding bits that are in the first LDPC coding bit sequence and that are different from coding bits corresponding to the punctured column of the fifth submatrix.

When the apparatus 10 is configured to implement the function of the transmitting end in the foregoing method embodiments, the transceiver unit 11 is configured to receive an LDPC coding bit sequence from a transmitting end; and the processing unit 12 is configured to decode the LDPC coding bit sequence based on a storage matrix and indication information, where the storage matrix includes a fourth submatrix and a fifth submatrix, the fourth submatrix includes non-extended columns of the storage matrix, the fifth submatrix includes extended columns of the storage matrix; a column weight of each of P columns of the fifth submatrix is 2; one of two non-zero elements included in a $p^{th}$ column in the P columns corresponds to a $j_1^{th}$ row of a first submatrix, the other one of the two non-zero elements included in the $p^{th}$ column in the P columns corresponds to a $j_2^{th}$ row of the first submatrix, the $j_1^{th}$ row and the $j_2^{th}$ row are orthogonal to each other, and the $p^{th}$ column is any one of the P columns, where P, p, $j_1$, and $j_2$ are all positive integers; and the indication information indicates a punctured column of the fifth submatrix, and the second LDPC coding bit sequence includes coding bits that are in a first LDPC coding bit sequence and that are different from coding bits corresponding to the punctured column of the fifth submatrix.

Optionally, the storage matrix is an S×G matrix, and an $(s_1+1)^{th}$ row to an $S^{th}$ row of the storage matrix are extended rows, and a $(g_2+1)^{th}$ column to a $G^{th}$ column of the storage matrix are extended columns; and the storage matrix includes a submatrix A3, a submatrix B3, a submatrix C3, a submatrix D3, and a submatrix E3, where the submatrix A3 is a $1^{st}$ row to an $s_1^{th}$ row and a $1^{st}$ column to a $g_1^{th}$ column of the storage matrix, the submatrix B3 is the $1^{st}$ row to the $s_1^{th}$ row and a $(g_1+1)^{th}$ column to a $g_2^{th}$ column of the storage matrix, the submatrix C3 is the $1^{st}$ row to the $s_1^{th}$ row and the $(g_2+1)^{th}$ column to the $G^{th}$ column of the storage matrix, the submatrix D3 is the $(s_1+1)^{th}$ row to the $S^{th}$ row and the $1^{st}$ column to the $g_2^{th}$ column of the storage matrix, and the submatrix E3 is the $(s_1+1)^{th}$ row to the $S^{th}$ row and the $(g_2+1)^{th}$ column to the $G^{th}$ column of the storage matrix, where $1 \leq s_1 \leq S$; $1 \leq g_1 \leq g_2 \leq G$; and $s_1$, S, $g_1$, $g_2$, and G are integers. Elements on a diagonal of the submatrix E3 are non-zero elements, a non-zero element is included above the diagonal of the submatrix E3, and/or a non-zero element is included below the diagonal of the submatrix E3, and the submatrix C3 includes a non-zero element.

Optionally, a form used for the indication information includes at least one of an indication sequence, a mapping table, or a mapping pair.

Optionally, the indication information is in the form of the indication sequence, the indication sequence includes a plurality of pieces of sub-information, each of the plurality of pieces of sub-information indicates one of the extended columns of the storage matrix, and an arrangement order of the plurality of pieces of sub-information is a puncturing order.

Optionally, the plurality of pieces of sub-information include at least one segment, each of the at least one segment corresponds to one round of puncturing, and labels of extended columns indicated by sub-information included in a $t^{th}$ segment in the at least one segment are in a form of permutation of $\{(2^{T-t}-1)s_1+1, ..., 2^{T-t+1}-1)s_1\}$ or a form of permutation of a subset of $\{(2^{T-t}-1)s_1+1, ..., 2^{T-t+1}-1)s_1\}$, where T is an upper bound of a quantity of merging rounds, $s_1$ is a quantity of non-extended rows of the storage matrix, and T and t are positive integers.

Optionally, a quantity J of pieces of sub-information included in the indication sequence is a smallest integer that satisfies $R_0 \leq \dfrac{K}{g_2+(2^{T2}-1)s_1-J}$, where $R_0$ is a target code rate, K is a target quantity of information columns, $s_1$ is the quantity of non-extended rows of the storage matrix, $g_2$ is a quantity of non-extended columns of the storage matrix, and T2 is the upper bound of the quantity of merging rounds.

For more detailed descriptions of the transceiver unit 11 and the processing unit 12, refer to related descriptions in the foregoing method embodiments. Details are not described herein again.

As shown in FIG. 20, an apparatus 20 includes a processor 21. The processor 21 is coupled to a memory 23, and the memory 23 is configured to store instructions. When the apparatus 20 is configured to implement the foregoing method, the processor 21 is configured to execute the instructions in the memory 23, to implement a function of the foregoing processing unit 12.

Optionally, the apparatus 20 further includes the memory 23.

Optionally, the apparatus 20 further includes an interface circuit 22. The processor 21 and the interface circuit 22 are coupled to each other. It may be understood that the interface circuit 22 may be a transceiver or an input/output interface. When the apparatus 20 is configured to implement the foregoing method, the processor 21 is configured to execute the instructions to implement the function of the foregoing processing unit 12, and the interface circuit 22 is configured to implement a function of the foregoing transceiver unit 11.

For example, when the apparatus 20 is a chip used at a transmitting end or a receiving end, the chip implements a function of the transmitting end or the receiving end in the foregoing method embodiments. The chip receives information from another module (for example, a radio frequency module or an antenna) in the transmitting end or the receiving end, where the information is sent by the another apparatus to the transmitting end or the receiving end; or the chip sends information to another module (for example, a radio frequency module or an antenna) in the transmitting end or the receiving end, where the information is sent by the transmitting end or the receiving end to the another apparatus.

This application further provides a communication apparatus, including a processor. The processor is coupled to a memory. The memory is configured to store a computer program or instructions and/or data. The processor is configured to: execute the computer program or the instructions stored in the memory, or read the data stored in the memory, to perform the method in the foregoing method embodiments. Optionally, there are one or more processors. Optionally, the communication apparatus includes the memory. Optionally, there are one or more memories. Optionally, the memory and the processor are integrated together or disposed separately.

This application further provides a computer-readable storage medium. The computer-readable storage medium stores computer instructions used for implementing the method performed by the transmitting end or the receiving end in the foregoing method embodiments.

This application further provides a computer program product, including instructions. When the instructions are executed by a computer, the method performed by the transmitting end or the receiving end in the foregoing method embodiments is implemented.

This application further provides a communication system. The communication system includes at least one of the transmitting end or the receiving end in the foregoing embodiments.

For explanations and beneficial effects of related content in any one of the apparatuses provided above, refer to the corresponding method embodiment provided above. Details are not described herein again.

It may be understood that the processor in embodiments of this application may be a central processing unit (central processing unit, CPU), or may be another general-purpose processor, a digital signal processor (digital signal processor, DSP), an application-specific integrated circuit (application-specific integrated circuit, ASIC), a field programmable gate array (field programmable gate array, FPGA) or another programmable logic device, a transistor logic device, a hardware component, or any combination thereof. The general-purpose processor may be a microprocessor or any conventional processor or the like.

The method steps in embodiments of this application may be implemented by hardware, or may be implemented by the processor by executing software instructions. The software instructions may include a corresponding software module. The software module may be stored in a random access memory, a flash memory, a read-only memory, a programmable read-only memory, an erasable programmable read-only memory, an electrically erasable programmable read-only memory, a register, a hard disk, a removable hard disk, a compact disc read-only memory (compact disc read- only memory, CD-ROM), or any other form of storage medium well-known in the art. For example, a storage medium is coupled to a processor, so that the processor can read information from the storage medium and write information into the storage medium. Certainly, the storage medium may be a component of the processor. The processor and the storage medium may be disposed in an ASIC. In addition, the ASIC may be located at a transmitting end or a receiving end. Certainly, the processor and the storage medium may exist in a transmitting end or a receiving end as discrete components.

All or some of the foregoing embodiments may be implemented by using software, hardware, firmware, or any combination thereof. When software is used to implement the embodiments, all or a part of the embodiments may be implemented in a form of a computer program product. The computer program product includes one or more computer programs or instructions. When the computer programs or instructions are loaded and executed on a computer, all or some of the procedures or functions in embodiments of this application are performed. The computer may be a general-purpose computer, a special-purpose computer, a computer network, a network device, user equipment, or another programmable apparatus. The computer program or instructions may be stored in a computer-readable storage medium, or may be transmitted from a computer-readable storage medium to another computer-readable storage medium. For example, the computer program or instructions may be transmitted from a website, computer, server, or data center to another website, computer, server, or data center in a wired or wireless manner. The computer-readable storage medium may be any usable medium that can be accessed by the computer, or a data storage device, for example, a server or a data center, integrating one or more usable media. The usable medium may be a magnetic medium, for example, a floppy disk, a hard disk, or a magnetic tape; or may be an optical medium, for example, a digital video disc; or may be a semiconductor medium, for example, a solid-state drive.

In embodiments of this application, unless otherwise stated or there is a logic conflict, terms and/or descriptions in different embodiments are consistent and may be mutually referenced, and technical features in different embodiments may be combined based on an internal logical relationship thereof, to form a new embodiment.

It may be understood that various numbers in embodiments of this application are merely used for differentiation for ease of description, and are not used to limit the scope of embodiments of this application. Sequence numbers of the foregoing processes do not mean an execution sequence, and the execution sequence of the processes should be determined based on functions and internal logic of the processes.

Unless otherwise stated, meanings of all technical and scientific terms used in embodiments of this application are the same as those usually understood by a person skilled in the technical field of this application. The terms used in this application are merely intended to describe objectives of the specific embodiments, and are not intended to limit the scope of this application. It should be understood that the foregoing is an example for description, and the foregoing examples are merely intended to help a person skilled in the art understand embodiments of this application, but are not intended to limit embodiments of this application to examples of specific values or specific scenarios. It is clear that a person skilled in the art can make various equivalent modifications or variations based on the examples described above, and such modifications and variations also fall within the scope of embodiments of this application.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

**Claims**

1. A low-density parity check LDPC code-based communication method, comprising:

   obtaining an information bit sequence;
   performing LDPC encoding on the information bit sequence based on an LDPC base graph, to obtain an LDPC coding bit sequence, wherein the LDPC base graph is obtained based on a storage matrix and indication information, the indication information indicates a correspondence between rows of the storage matrix or a correspondence between rows of the LDPC base graph, and a sum of column weights of non-extended columns of the LDPC base graph is equal to a sum of column weights of non-extended columns of the storage matrix; and
   sending the LDPC coding bit sequence.

2. A low-density parity check LDPC code-based communication method, comprising:

   receiving an LDPC coding bit sequence from a transmitting end; and
   decoding the LDPC coding bit sequence based on an LDPC base graph, wherein the LDPC base graph is obtained based on a storage matrix and indication information, the indication information indicates a correspondence between rows of the storage matrix or a correspondence between rows of the LDPC base graph, and a sum of column weights of non-extended columns of the LDPC base graph is equal to a sum of column weights of non-extended columns of the storage matrix.

3. The method according to claim 1 or 2, wherein
   a code rate corresponding to the LDPC base graph is different from a code rate corresponding to the storage matrix.

4. The method according to any one of claims 1 to 3, wherein
   the LDPC base graph comprises a first submatrix and a second submatrix, the first submatrix comprises the non-extended columns of the LDPC base graph, the second submatrix comprises extended columns of the LDPC base graph; a column weight of each of Q columns of the second submatrix is 2; and one of two non-zero elements comprised in a $q^{th}$ column in the Q columns corresponds to an $i_1^{th}$ row of the first submatrix, the other one of the two non-zero elements comprised in the $q^{th}$ column in the Q columns corresponds to an $i_2^{th}$ row of the first submatrix, the $i_1^{th}$ row and the $i_2^{th}$ row are orthogonal to each other, and the $q^{th}$ column is any one of the Q columns, wherein Q, q, $i_1$, and $i_2$ are all positive integers.

5. The method according to any one of claims 1 to 4, wherein

   the LDPC base graph is an $X \times Y$ matrix, and a $(y_2+1)^{th}$ column to a $Y^{th}$ column of the LDPC base graph are extended columns; and the LDPC base graph comprises a submatrix A1, a submatrix B1, a submatrix C1, a submatrix D1, and a submatrix E1, wherein the submatrix A1 is a $1^{st}$ row to an $x_1^{th}$ row and a $1^{st}$ column to a $y_1^{th}$ column of the LDPC base graph, the submatrix B1 is the $1^{st}$ row to the $x_1^{th}$ row and a $(y_1+1)^{th}$ column to a $y_2^{th}$ column of the LDPC base graph, the submatrix C1 is the $1^{st}$ row to the $x_1^{th}$ row and the $(y_2+1)^{th}$ column to the $Y^{th}$ column of the LDPC base graph, the submatrix D1 is an $(x_1+1)^{th}$ row to an $X^{th}$ row and the $1^{st}$ column to the $y_2^{th}$ column of the LDPC base graph, and the submatrix E1 is the $(x_1+1)^{th}$ row to the $X^{th}$ row and the $(y_2+1)^{th}$ column to the $Y^{th}$ column of the LDPC base graph, wherein $1 \leq x_1 \leq X$; $1 \leq y_1 \leq y_2 \leq Y$; and $x_1$, X, $y_1$, $y_2$, and Y are integers, wherein elements on a diagonal of the submatrix E1 are non-zero elements, a non-zero element is comprised above the diagonal of the submatrix E1, and/or a non-zero element is comprised below the diagonal of the submatrix E1, and the submatrix C1 comprises a non-zero element.

6. The method according to any one of claims 1 to 5, wherein
   a form used for the indication information comprises at least one of an indication sequence, a mapping table, or a mapping pair.

7. The method according to any one of claims 1 to 6, wherein

the storage matrix is an $M \times N$ matrix, and an $(m_1+1)^{th}$ row to an $M^{th}$ row of the storage matrix are extended rows; and the storage matrix comprises a submatrix A2, a submatrix B2, a submatrix C2, a submatrix D2, and a submatrix E2, wherein the submatrix A2 is a $1^{st}$ row to an $m_1^{th}$ row and a $1^{st}$ column to an $n_1^{th}$ column of the storage matrix, the submatrix B2 is the $1^{st}$ row to the $m_1^{th}$ row and an $(n_1+1)^{th}$ column to an $n_2^{th}$ column of the storage matrix, the submatrix C2 is the $1^{st}$ row to the $m_1^{th}$ row and an $(n_2+1)^{th}$ column to an $N^{th}$ column of the storage matrix, the submatrix D2 is the $(m_1+1)^{th}$ row to the $M^{th}$ row and the $1^{st}$ column to the $n_2^{th}$ column of the storage matrix, and the submatrix E2 is the $(m_1+1)^{th}$ row to the $M^{th}$ row and the $(n_2+1)^{th}$ column to the $N^{th}$ column of the storage matrix, wherein $1 \leq m_1 \leq M$; $1 \leq n_1 \leq n_2 \leq N$; and $m_1$, M, $n_1$, $n_2$, and N are integers, wherein an $a_1^{th}$ row of the submatrix D2 is properly comprised in a $b_1^{th}$ row of a third submatrix and/or an $a_2^{th}$ row of the submatrix D2, the third submatrix comprises the submatrix A2 and the submatrix B2, and the $a_1^{th}$ row is any row of the submatrix D2.

8. The method according to claim 7, wherein
a difference between a shifting value of each non-zero element in the $a_1^{th}$ row and a shifting value of a non-zero element at a corresponding location in the $b_1^{th}$ row remains the same, and/or a difference between a shifting value of each non-zero element in the $a_1^{th}$ row and a shifting value of a non-zero element at a corresponding location in the $b_1^{th}$ row remains the same.

9. The method according to claim 7 or 8, wherein
a plurality of rows that are of the submatrix D2 and that correspond to a $b_2^{th}$ row of the third submatrix are different from each other, and the $b_2^{th}$ row is any row of the third submatrix.

10. The method according to any one of claims 7 to 9, wherein
a correspondence between the $a_1^{th}$ row and the $b_1^{th}$ row and a correspondence between the $a_1^{th}$ row and the $a_2^{th}$ row are determined based on the indication information.

11. The method according to any one of claims 1 to 10, wherein
the indication information indicates the correspondence between the rows of the LDPC base graph, the storage matrix is used to store a connection relationship between a variable node and a check node, a shifting value of a non-zero element of the storage matrix is obtained based on a shifting value table, and the shifting value table is used to store shifting values of locations of non-extended rows of the storage matrix.

12. The method according to claim 11, wherein
the indication information is in the form of the indication sequence, the LDPC base graph is obtained by reading the storage matrix and the shifting value table based on the indication sequence, the indication sequence comprises at least one row number, and an $i_3^{th}$ row number in the at least one row number indicates that a shifting value of an $i_3^{th}$ row of the LDPC base graph is determined based on a shifting value of a row identified by the $i_3^{th}$ row number in the at least one row number, wherein $i_3$ is a positive integer.

13. The method according to any one of claims 1 to 11, wherein
the indication information is in the form of the indication sequence, the LDPC base graph is obtained by splitting the storage matrix based on the indication sequence, the indication sequence comprises at least one row number, an $(m_1+r)^{th}$ row number in the at least one row number indicates that an $(m_1+r)^{th}$ row of the LDPC base graph is used to perform elimination processing on a row identified by the $(m_1+r)^{th}$ row number in the at least one row number, and a sorting order of the at least one row number is a splitting order, wherein $m_1$ is a quantity of non-extended rows of the storage matrix, and r is a positive integer.

14. The method according to claim 13, wherein
the at least one row number comprises at least one segment, each of the at least one segment corresponds to one round of splitting, and row numbers in a segment corresponding to a $t^{th}$ round of splitting in at least one round of splitting corresponding to the at least one segment are in a form of permutation of $\{1, ..., 2^{t-1}m_1\}$ or a form of permutation of a subset of $\{1, ..., 2^{t-1}_{m1}\}$, wherein t is a positive integer.

15. The method according to claim 13 or 14, wherein the method further comprises:

determining a quantity R of splitting times based on a code length corresponding to the LDPC base graph, a quantity of information bits corresponding to the LDPC base graph, and a quantity of information columns of the LDPC base graph; and

splitting the storage matrix for R times to obtain the LDPC base graph, wherein

an $r^{th}$ time of splitting in the R times of splitting comprises the following operations: obtaining the $(m_1+r)^{th}$ row number of the indication sequence; and performing, by using an $(m_1+r)^{th}$ row of the storage matrix, elimination processing on a row that is in the storage matrix and that is identified by the $(m_1+r)^{th}$ row number, wherein the $r^{th}$ time of splitting is any one of the R times of splitting.

16. The method according to claim 13 or 14, wherein
the storage matrix does not comprise an extended column, the $(m_1+r)^{th}$ row of the LDPC base graph is obtained based on an $r^{th}$ row of a division table, and one row of the division table is used to construct one extended row of the LDPC base graph.

17. The method according to claim 16, wherein the method further comprises:

determining a quantity R of splitting times based on a code length corresponding to the LDPC base graph, a quantity of information bits corresponding to the LDPC base graph, and a quantity of information columns of the LDPC base graph; and
splitting the storage matrix for R times to obtain the LDPC base graph, wherein
an $r^{th}$ time of splitting in the R times of splitting comprises the following operations: obtaining the $r^{th}$ row of the division table, and constructing an $r^{th}$ extended row of the storage matrix based on the $r^{th}$ row; obtaining an $(M+r)^{th}$ row number of the indication sequence; and performing elimination processing on a $k^{th}$ row by using the $r^{th}$ extended row, wherein the $k^{th}$ row is a row that is in the storage matrix or first r-1 extended rows of the storage matrix and that corresponds to the $(M+r)^{th}$ row number, M is a quantity of rows of the storage matrix, and the $r^{th}$ time of splitting is any one of the R times of splitting.

18. The method according to claim 15 or 17, wherein

R is a smallest integer that satisfies $RZ_c \geq N_0 - K_0$, wherein
$Z_c$ is a lifting value, $Z_c$ is a smallest $Z_c$ that satisfies $KZ_c \geq K_0$ in a $Z_c$ list, $N_0$ is the code length corresponding to the LDPC base graph, $K_0$ is the quantity of information bits corresponding to the LDPC base graph, and K is the quantity of information columns of the LDPC base graph.

19. The method according to claim 15, 17, or 18, wherein

if a part of parity bits corresponding to a last column of the LDPC base graph are punctured, a row after $Z_c$ lifting is used as a granularity for a last time of splitting in the R times of splitting, wherein
$Z_c$ is the lifting value, $Z_c$ is the smallest $Z_c$ that satisfies $KZ_c \geq K_0$ in the $Z_c$ list, $K_0$ is the quantity of information bits corresponding to the LDPC base graph, and K is the quantity of information columns of the LDPC base graph.

20. The method according to any one of claims 1 to 6, wherein
the indication information is in the form of the indication sequence, the LDPC base graph is obtained by merging the storage matrix based on the indication sequence, the indication sequence comprises a plurality of pieces of sub-information, each of the plurality of pieces of sub-information indicates two rows to be merged in the storage matrix, and an arrangement order of the plurality of pieces of sub-information is a merging order.

21. The method according to claim 20, wherein
the plurality of pieces of sub-information comprise at least one segment, each of the at least one segment corresponds to one round of merging, and labels of extended columns, of the storage matrix, corresponding to sub-information comprised in a $t^{th}$ segment in the at least one segment are in a form of permutation of $\{(2^{T1-t}-1)s_1+1, ..., (2^{T1-t+1}-1)s_1\}$ or a form of permutation of a subset of $\{(2^{T1-t}-1)s_1+1, ..., (2^{T1-t+1}-1)s_1\}$, wherein T1 is an upper bound of a quantity of merging rounds, $s_1$ is a quantity of non-extended rows of the storage matrix, and T1 and t are positive integers.

22. The method according to claim 21, wherein
the storage matrix comprises a fourth submatrix and a fifth submatrix, the fourth submatrix comprises the non-extended columns of the storage matrix, the fifth submatrix comprises extended columns of the storage matrix; a column weight of each of P columns of the fifth submatrix is 2; and one of two non-zero elements comprised in a $p^{th}$ column in the P columns corresponds to a $j_1^{th}$ row of the first submatrix, the other one of the two non-zero elements comprised in the $p^{th}$ column in the P columns corresponds to a $j_2^{th}$ row of the first submatrix, the $j_1^{th}$ row and the $j_2^{th}$ row are orthogonal to each other, and the $p^{th}$ column is any one of the P columns, wherein P, p, $j_1$, and $j_2$ are all positive

integers.

**23.** The method according to claim 20 or 21, wherein

the storage matrix is an $S \times G$ matrix, and an $(s_1+1)^{th}$ row to an $S^{th}$ row of the storage matrix are extended rows, and a $(g_2+1)^{th}$ column to a $G^{th}$ column of the storage matrix are extended columns; and the storage matrix comprises a submatrix A3, a submatrix B3, a submatrix C3, a submatrix D3, and a submatrix E3, wherein the submatrix A3 is a $1^{st}$ row to an $s_1^{th}$ row and a $1^{st}$ column to a $g_1^{th}$ column of the storage matrix, the submatrix B3 is the $1^{st}$ row to the $s_1^{th}$ row and a $(g_1+1)^{th}$ column to a $g_2^{th}$ column of the storage matrix, the submatrix C3 is the $1^{st}$ row to the $s_1^{th}$ row and the $(g_2+1)^{th}$ column to the $G^{th}$ column of the storage matrix, the submatrix D3 is the $(s_1+1)^{th}$ row to the $S^{th}$ row and the $1^{st}$ column to the $g_2^{th}$ column of the storage matrix, and the submatrix E3 is the $(s_1+1)^{th}$ row to the $S^{th}$ row and the $(g_2+1)^{th}$ column to the $G^{th}$ column of the storage matrix, wherein $1 \leq s_1 \leq S$; $1 \leq g_1 \leq g_2 \leq G$; and $s_1$, $S$, $g_1$, $g_2$, and $G$ are integers, wherein
elements on a diagonal of the submatrix E3 are non-zero elements, a non-zero element is comprised above the diagonal of the submatrix E3, and/or a non-zero element is comprised below the diagonal of the submatrix E3, and the submatrix C3 comprises a non-zero element.

**24.** The method according to any one of claims 20 to 23, wherein the method further comprises:

determining a quantity W of merging times based on the code rate corresponding to the LDPC base graph, a quantity of information columns of the LDPC base graph, a quantity of non-extended rows of the storage matrix, a quantity of non-extended columns of the storage matrix, and the upper bound T1 of the quantity of merging rounds; and
merging the storage matrix for W times to obtain the LDPC base graph, wherein
a $w^{th}$ time of merging in the W times of splitting comprises the following operations: obtaining a $w^{th}$ piece of sub-information of the indication sequence; and merging two rows indicated by the $w^{th}$ piece of sub-information, wherein the $w^{th}$ time of merging is any one of the W times of merging, and w is a positive integer.

**25.** The method according to claim 24, wherein

W is a smallest integer that satisfies $R_0 \leq \dfrac{K}{g_1 + (2^{T1}-1)s_1 - W}$ , wherein

$R_0$ is the code rate corresponding to the LDPC base graph; K is the quantity of information columns of the LDPC base graph; $s_1$ is the quantity of non-extended rows of the storage matrix; $g_1$ is the quantity of non-extended columns of the storage matrix; and T1 is the upper bound of the quantity of merging rounds.

**26.** The method according to claim 24 or 25, wherein

if a part of parity bits corresponding to a last column of the LDPC base graph are punctured, a row after $Z_c$ lifting is used as a granularity for a last time of merging in the W times of merging, wherein
$Z_c$ is a lifting value, $Z_c$ is a smallest $Z_c$ that satisfies $KZ_c \geq K_0$ in a $Z_c$ list, $K_0$ is a quantity of information bits corresponding to the LDPC base graph, and K is the quantity of information columns of the LDPC base graph.

**27.** A low-density parity check LDPC code-based communication method, comprising:

obtaining an information bit sequence;
performing LDPC encoding on the information bit sequence based on a storage matrix to obtain a first LDPC coding bit sequence, wherein the storage matrix comprises a fourth submatrix and a fifth submatrix, the fourth submatrix comprises non-extended columns of the storage matrix, the fifth submatrix comprises extended columns of the storage matrix; a column weight of each of P columns of the fifth submatrix is 2; and one of two non-zero elements comprised in a $p^{th}$ column in the P columns corresponds to a $j_1^{th}$ row of a first submatrix, the other one of the two non-zero elements comprised in the $p^{th}$ column in the P columns corresponds to a $j_2^{th}$ row of the first submatrix, the $j_1^{th}$ row and the $j_2^{th}$ row are orthogonal to each other, and the $p^{th}$ column is any one of the P columns, wherein P, p, $j_1$, and $j_2$ are all positive integers; and
sending a second LDPC coding bit sequence based on indication information, wherein the indication information indicates a punctured column of the fifth submatrix, and the second LDPC coding bit sequence comprises coding bits that are in the first LDPC coding bit sequence and that are different from coding bits corresponding to the punctured column of the fifth submatrix.

28. A low-density parity check LDPC code-based communication method, comprising:

receiving an LDPC coding bit sequence from a transmitting end; and
decoding the LDPC coding bit sequence based on a storage matrix and indication information, wherein the storage matrix comprises a fourth submatrix and a fifth submatrix, the fourth submatrix comprises non-extended columns of the storage matrix, the fifth submatrix comprises extended columns of the storage matrix; a column weight of each of P columns of the fifth submatrix is 2; one of two non-zero elements comprised in a $p^{th}$ column in the P columns corresponds to a $j_1^{th}$ row of a first submatrix, the other one of the two non-zero elements comprised in the $p^{th}$ column in the P columns corresponds to a $j_2^{th}$ row of the first submatrix, the $j_1^{th}$ row and the $j_2^{th}$ row are orthogonal to each other, and the $p^{th}$ column is any one of the P columns, wherein P, p, $j_1$, and $j_2$ are all positive integers; and the indication information indicates a punctured column of the fifth submatrix, and the second LDPC coding bit sequence comprises coding bits that are in a first LDPC coding bit sequence and that are different from coding bits corresponding to the punctured column of the fifth submatrix.

29. The method according to claim 27 or 28, wherein

the storage matrix is an $S \times G$ matrix, and an $(s_1+1)^{th}$ row to an $S^{th}$ row of the storage matrix are extended rows, and a $(g_2+1)^{th}$ column to a $G^{th}$ column of the storage matrix are extended columns; and the storage matrix comprises a submatrix A3, a submatrix B3, a submatrix C3, a submatrix D3, and a submatrix E3, wherein the submatrix A3 is a $1^{st}$ row to an $s_1^{th}$ row and a $1^{st}$ column to a $g_1^{th}$ column of the storage matrix, the submatrix B3 is the $1^{st}$ row to the $s_1^{th}$ row and a $(g_1+1)^{th}$ column to a $g_2^{th}$ column of the storage matrix, the submatrix C3 is the $1^{st}$ row to the $s_1^{th}$ row and the $(g_2+1)^{th}$ column to the $G^{th}$ column of the storage matrix, the submatrix D3 is the $(s_1+1)^{th}$ row to the $S^{th}$ row and the $1^{st}$ column to the $g_2^{th}$ column of the storage matrix, and the submatrix E3 is the $(s_1+1)^{th}$ row to the $S^{th}$ row and the $(g_2+1)^{th}$ column to the $G^{th}$ column of the storage matrix, wherein $1 \leq s_1 \leq S$; $1 \leq g_1 \leq g_2 \leq G$; and $s_1$, S, $g_1$, $g_2$, and G are integers, wherein
elements on a diagonal of the submatrix E3 are non-zero elements, a non-zero element is comprised above the diagonal of the submatrix E3, and/or a non-zero element is comprised below the diagonal of the submatrix E3, and the submatrix C3 comprises a non-zero element.

30. The method according to any one of claims 27 to 29, wherein
a form used for the indication information comprises at least one of an indication sequence, a mapping table, or a mapping pair.

31. The method according to claim 30, wherein
the indication information is in the form of the indication sequence, the indication sequence comprises a plurality of pieces of sub-information, each of the plurality of pieces of sub-information indicates one of the extended columns of the storage matrix, and an arrangement order of the plurality of pieces of sub-information is a puncturing order.

32. The method according to claim 31, wherein
the plurality of pieces of sub-information comprise at least one segment, each of the at least one segment corresponds to one round of puncturing, and labels of extended columns indicated by sub-information comprised in a $t^{th}$ segment in the at least one segment are in a form of permutation of $\{(2^{T2-t}-1)s_1+1, ..., 2^{T2-t+1}-1)s_1\}$ or a form of permutation of a subset of $\{(2^{T2-t}-1)s_1+1, ..., 2^{T2-t+1}-1)s_1\}$, wherein T2 is an upper bound of a quantity of merging rounds, $s_1$ is a quantity of non-extended rows of the storage matrix, and T2 and t are positive integers.

33. The method according to claim 31 or 32, wherein

a quantity J of pieces of sub-information comprised in the indication sequence is a smallest integer that satisfies

$$R_0 \leq \frac{K}{g_2 + (2^{T2}-1)s_1 - J}$$, wherein

$R_0$ is a target code rate, K is a target quantity of information columns, $s_1$ is the quantity of non-extended rows of the storage matrix, $g_2$ is a quantity of non-extended columns of the storage matrix, and T2 is the upper bound of the quantity of merging rounds.

34. A communication apparatus, comprising a module or unit configured to perform the method according to any one of claims 1 and 3 to 26, the method according to any one of claims 2 to 26, the method according to any one of claims 27 and 29 to 33, or the method according to any one of claims 28 to 33.

35. A communication apparatus, comprising:

a processor, configured to execute a computer program stored in a memory, to enable the apparatus to perform the method according to any one of claims 1 and 3 to 26, perform the method according to any one of claims 2 to 26, perform the method according to any one of claims 27 and 29 to 33, or perform the method according to any one of claims 28 to 33.

36. The apparatus according to claim 35, wherein the apparatus further comprises a memory.

37. The apparatus according to claim 35 or 36, wherein the apparatus is a chip.

38. A computer-readable storage medium, wherein the computer-readable storage medium stores a computer program; and when the computer program is run on a computer, the computer is enabled to perform the method according to any one of claims 1 and 3 to 26, perform the method according to any one of claims 2 to 26, perform the method according to any one of claims 27 and 29 to 33, or perform the method according to any one of claims 28 to 33.

39. A computer program product, wherein the computer program product comprises instructions used for performing the method according to any one of claims 1 and 3 to 26, the method according to any one of claims 2 to 26, the method according to any one of claims 27 and 29 to 33, or the method according to any one of claims 28 to 33.

40. A communication system, comprising:

a transmitting end configured to perform the method according to any one of claims 1 and 3 to 26, and a receiving end configured to perform the method according to any one of claims 2 to 26; or
a transmitting end configured to perform the method according to any one of claims 27 and 29 to 33, and a receiving end configured to perform the method according to any one of claims 28 to 33.

$$H=\begin{matrix} V_1 & V_2 & V_3 & V_4 & V_5 & V_6 & V_7 & V_8 \\ \begin{bmatrix} 1 & 0 & 1 & 0 & 1 & 0 & 1 & 0 \\ 1 & 0 & 0 & 1 & 0 & 1 & 0 & 1 \\ 0 & 1 & 1 & 0 & 0 & 1 & 1 & 0 \\ 0 & 0 & 0 & 1 & 1 & 0 & 0 & 1 \end{bmatrix} & & & & & & & \end{matrix} \begin{matrix} C_1 \\ C_2 \\ C_3 \\ C_4 \end{matrix}$$

FIG. 1

FIG. 2

| A | B | C |
|---|---|---|
| D | | E |

FIG. 3

Network device

Terminal 1

Terminal 2

FIG. 4

| Source | → | Source encoding | → | Channel encoding | → | Modulation |

| Sink | ← | Source recovery | ← | Channel decoding | ← | Demodulation |

FIG. 5

<u>600</u>

```
┌──────────────┐                                    ┌──────────────┐
│ Transmitting │                                    │Receiving end │
│     end      │                                    │              │
└──────────────┘                                    └──────────────┘
        │                                                   │
┌───────┴────────────────┐                                  │
│ 601: Obtain an information bit │                           │
│        sequence         │                                  │
└────────────────────────┘                                  │
        │                                                   │
┌───────┴────────────────────────┐                          │
│ 602: Perform LDPC encoding on   │                          │
│ the information bit sequence based │                       │
│ on an LDPC base graph, to obtain │                         │
│ an LDPC coding bit sequence      │                         │
└─────────────────────────────────┘                         │
        │                                                   │
        │──── 603: LDPC coding bit sequence ───────────────▶│
        │                                                   │
        │                               ┌───────────────────┴──────────────┐
        │                               │ 604. Decode the LDPC coding bit   │
        │                               │ sequence based on the LDPC base graph, │
        │                               │ where the LDPC base graph is obtained │
        │                               │ based on a storage matrix and indication │
        │                               │           information             │
        │                               └──────────────────────────────────┘
        │                                                   │
```

FIG. 6

EP 4 614 910 A1

Non-extended columns — Extended columns

Non-extended rows

Extended rows

FIG. 7

4×28
Quantity of equivalent decoding rows=4

5×29
Quantity of equivalent decoding rows=5

5×29
Quantity of equivalent decoding rows=4

Parity bits

Information bits

**FIG. 8**

FIG. 9

FIG. 10

1st segment 2nd segment        3rd segment        $(t+1)^{th}$ segment

| $1, ..., M,$ | $p_1(1, ..., M),$ | $p_2(1, ..., M, M+1, ..., 2M),$ | ..., | $p_t(1, ..., M, M+1, ..., 2^{t-1}M)$ |
|---|---|---|---|---|
| Initial matrix | 1st round of splitting | 2nd round of splitting | | $t^{th}$ round of splitting |

FIG. 11

| 0 | 1 | 2 | 3 | 4 | 5 | 6 | 7 |
|---|---|---|---|---|---|---|---|

Split sequence

| Labels of variable nodes included in an elimination check node | | | |
|---|---|---|---|
| 1 | | | |
| 2 | | 3 | |
| 4 | 5 | 6 | 7 |

Division table

FIG. 12

Labels of variable nodes included in an elimination check node

| 2, 4, 6, 8, 10, 11, 14, 16, 18, 20, 22, 23 | |
|---|---|
| 2, 3, 6, 8, 9, 12, 13, 16, 17, 22, 23, 26, 27 | |
| 1, 3, 6, 8, 10, 11, 13, 16, 17, 19, 22, 24, 25 | |
| 2, 3, 6, 8, 10, 12, 13, 15, 18, 20, 21, 24, 26, 27 | |
| 1, 5, 12, 16, 19, 24, 26, | 2, 6, 10, 14, 18, 23 |
| 4, 5, 11, 15, 24, 25 | 2, 6, 12, 16, 17, 22, 27 |
| 2, 7, 9, 15, 18, 21 | 1, 8, 11, 13, 19, 24 |
| 4, 7, 9, 16, 17, 23, 28 | 2, 8, 12, 13, 20, 24, 26 |

Rows

Subdivided rows

FIG. 13

(a)

(b)

FIG. 14

(a)

(b)

FIG. 15

FIG. 16

FIG. 17

1800

```
┌─────────────────┐                                    ┌─────────────────┐
│  Transmitting   │                                    │  Receiving end  │
│      end        │                                    │                 │
└─────────────────┘                                    └─────────────────┘
```

1801: Obtain an information bit sequence

1802: Perform LDPC encoding on the information bit sequence based on a storage matrix, to obtain a first LDPC coding bit sequence

1803: Second LDPC coding bit sequence ⟶

1804: Decode the second LDPC coding bit sequence based on an LDPC base graph and indication information, where the indication information indicates a punctured extended column of the LDPC base graph

FIG. 18

```
┌───────────────────────────────┐
│         Apparatus 10          │
│                               │
│   ┌───────────────────────┐   │
│   │  Transceiver unit 11  │   │
│   └───────────────────────┘   │
│                               │
│   ┌───────────────────────┐   │
│   │   Processing unit 12  │   │
│   └───────────────────────┘   │
│                               │
└───────────────────────────────┘
```

FIG. 19

FIG. 20

## INTERNATIONAL SEARCH REPORT

| International application No. |
| --- |
| **PCT/CN2022/132833** |

### A. CLASSIFICATION OF SUBJECT MATTER

H04L27/00(2006.01)i

According to International Patent Classification (IPC) or to both national classification and IPC

### B. FIELDS SEARCHED

Minimum documentation searched (classification system followed by classification symbols)

IPC:H04L,H04W

Documentation searched other than minimum documentation to the extent that such documents are included in the fields searched

Electronic data base consulted during the international search (name of data base and, where practicable, search terms used)

3GPP, CNTXT, ENTXT, ENTXTC, IEEE: 编码, 译码, 分裂, 合并, 基, 矩阵, 基础矩阵, 基本矩阵, 基矩阵, 码率, 拓展, 扩展, 行, 列重, 非零, 指示, 映射, 序列, base, basi?, LDPC, matrix, rate, encod+, cod+, IR-HARQ, tanner, row, indicat+, map, sequence, punch+

### C. DOCUMENTS CONSIDERED TO BE RELEVANT

| Category* | Citation of document, with indication, where appropriate, of the relevant passages | Relevant to claim No. |
| --- | --- | --- |
| A | CN 113078911 A (HUAWEI TECHNOLOGIES CO., LTD.) 06 July 2021 (2021-07-06) description, paragraphs [0064]-[0270] | 1-40 |
| A | CN 108270448 A (ZTE CORP.) 10 July 2018 (2018-07-10) entire document | 1-40 |
| A | CN 108270510 A (HUAWEI TECHNOLOGIES CO., LTD.) 10 July 2018 (2018-07-10) entire document | 1-40 |
| A | CN 108988869 A (CHINA ACADEMY OF TELECOMMUNICATION TECHNOLOGY) 11 December 2018 (2018-12-11) entire document | 1-40 |
| A | US 2020244290 A1 (NOKIA TECHNOLOGIES OY) 30 July 2020 (2020-07-30) entire document | 1-40 |
| A | ZTE CORP. et al. "Discussion on LDPC codes for NR" *R1-166414, 3GPP TSG RAN WG1 #86*, 13 August 2016 (2016-08-13), pages 1-10 | 1-40 |

☐ Further documents are listed in the continuation of Box C.   ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **02 August 2023** | **07 August 2023** |

| Name and mailing address of the ISA/CN | Authorized officer |
| --- | --- |
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

International application No.

**PCT/CN2022/132833**

| Patent document cited in search report | | | Publication date (day/month/year) | Patent family member(s) | | | Publication date (day/month/year) |
|---|---|---|---|---|---|---|---|
| CN | 113078911 | A | 06 July 2021 | WO | 2021136540 | A1 | 08 July 2021 |
| | | | | EP | 4072024 | A1 | 12 October 2022 |
| | | | | US | 2022352904 | A1 | 03 November 2022 |
| CN | 108270448 | A | 10 July 2018 | WO | 2018126788 | A1 | 12 July 2018 |
| CN | 108270510 | A | 10 July 2018 | | None | | |
| CN | 108988869 | A | 11 December 2018 | KR | 20200011491 | A | 03 February 2020 |
| | | | | US | 2020186168 | A1 | 11 June 2020 |
| | | | | JP | 2020522934 | A | 30 July 2020 |
| | | | | WO | 2018219064 | A1 | 06 December 2018 |
| | | | | TW | 201904221 | A | 16 January 2019 |
| | | | | EP | 3633858 | A1 | 08 April 2020 |
| US | 2020244290 | A1 | 30 July 2020 | WO | 2018126428 | A1 | 12 July 2018 |
| | | | | TW | 201830874 | A | 16 August 2018 |
| | | | | CN | 110192349 | A | 30 August 2019 |
| | | | | EP | 3566316 | A1 | 13 November 2019 |

Form PCT/ISA/210 (patent family annex) (July 2022)